# FASCICULE DE BREVET EUROPEEN

(11) **EP 2 718 975 B1**
(45) Date de publication et mention de la délivrance du brevet: **01.07.2020**
(21) Numéro de dépôt: 12729086.4
(22) Date de dépôt: 08.06.2012
(51) Int. Cl.: H01L 31/02, H02S 50/00

(54) **DISPOSITIF DE GENERATION D'ENERGIE PHOTOVOLTAIQUE AVEC GESTION INDIVIDUELLE DES CELLULES**
VORRICHTUNG ZUR ERZEUGUNG VON FOTOVOLTAISCHER ENERGIE MIT INDIVIDUELLER ZELLENVERWALTUNG
DEVICE FOR GENERATING PHOTOVOLTAIC ENERGY WITH INDIVIDUAL CELL MANAGEMENT

(30) Priorité: 08.06.2011 FR 1155018
(43) Date de publication de la demande: 16.04.2014
(73) Titulaire: Commissariat à l'Énergie Atomique et aux Énergies Alternatives, 75015 Paris (FR)
(72) Inventeur: DESPESSE, Ghislain, 38120 Saint Egreve (FR)
(74) Mandataire: Novaimo
(86) Numéro de dépôt international: PCT/EP2012/060878
(87) Numéro de publication internationale: WO 2012/168422

(56) Documents cités:
- EP-A1- 2 219 276
- WO-A2-2006/137948
- WO-A2-2010/062662
- DE-A1-102008 008 505
- DE-A1-102008 059 293
- US-A1- 2008 210 286
- US-A1- 2009 183 763
- US-A1- 2010 037 936

## Description

L'invention concerne un dispositif de génération d'énergie photovoltaïque. Elle concerne aussi un procédé de gestion de la génération d'énergie photovoltaïque.

La génération d'énergie photovoltaïque est généralement mise en oeuvre par un dispositif de génération d'énergie comprenant l'association d'une multitude de cellules photovoltaïques élémentaires, possédant une faible tension à leurs bornes, disposées en série afin d'atteindre une tension de sortie souhaitée. Souvent, ce dispositif de génération d'énergie photovoltaïque est connecté sur le réseau de distribution électrique, qui lui demande une tension de quelques centaines de volts. Dans la pratique, on note une disparité des situations et comportements des différentes cellules photovoltaïques élémentaires du dispositif de génération car certaines de ces cellules peuvent être défaillantes, d'autres dans une zone ombragée, etc. Il en résulte qu'un dispositif de génération d'énergie n'est pas optimisé car ses cellules photovoltaïques ne fonctionnent pas à leur point de fonctionnement optimal.

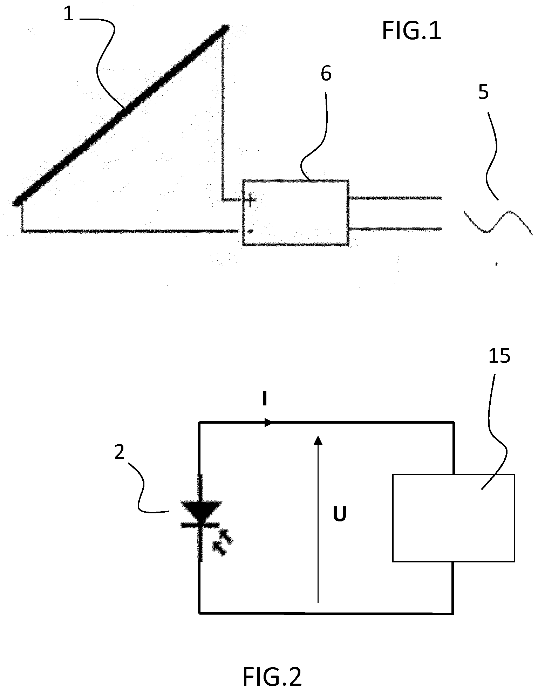

La figure 1 illustre à titre d'exemple un dispositif de génération d'énergie photovoltaïque 1 relié au secteur 5, par un dispositif intermédiaire 6 de type convertisseur DC/AC. Le dispositif 6 a pour fonction de transformer la tension de sortie du générateur photovoltaïque en une tension alternative compatible avec le secteur 5. Naturellement, l'utilisation de ce dispositif intermédiaire 6 présente plusieurs inconvénients, parmi lesquels la génération de pertes au niveau des transistors et autres composants utilisés, ce qui entraîne globalement une consommation énergétique supplémentaire. D'autre part, cela représente aussi un encombrement supplémentaire.

Le document US4175249 décrit un dispositif de génération d'énergie dont la structure comprend une multitude d'interrupteurs, pour permettre de disposer certaines cellules photovoltaïques en série ou en parallèle, pour apporter une souplesse dans la génération électrique. Cette solution reste toutefois non optimisée et difficile à gérer dans la pratique.

Le document US 2008/210286 décrit un autre dispositif de génération d'énergie dont la structure comprend un pluralité d'interrupteurs et d'éléments de stockage d'énergie. Ainsi, il existe un besoin d'une solution améliorée de génération d'énergie photovoltaïque permettant de résoudre les inconvénients des solutions existantes, et l'invention cherche à atteindre tout ou partie des objets suivants :
Un premier objet de l'invention est de proposer une solution optimisée de génération d'énergie photovoltaïque.
Un second objet de l'invention est de proposer une solution de génération d'énergie photovoltaïque qui permet une génération souple, s'adaptant à différentes exigences d'utilisation, comme aux besoins variables d'un moteur par exemple ou d'un réseau électrique quelconque.

A cet effet, l'invention repose sur un dispositif de génération d'énergie photovoltaïque conformément à la revendication 1.

Le dispositif de génération d'énergie photovoltaïque peut comprendre au moins un module comprenant plusieurs cellules disposées en parallèle et plusieurs interrupteurs parallèles connectés en parallèle avec au moins une cellule dudit module.

Ledit au moins un module peut comprendre une borne inférieure apte à une connexion avec un module inférieur et une borne supérieure apte à une connexion avec un module supérieur, et peut comprendre plusieurs branches entre sa borne inférieure et sa borne supérieure comprenant chacune au moins une cellule et un interrupteur de cellule disposés en série et plusieurs autres branches parallèles entre sa borne inférieure et sa borne supérieure comprenant chacune un interrupteur parallèle.

Le dispositif de génération d'énergie photovoltaïque peut comprendre un agencement de briques comprenant deux branches parallèles comprenant respectivement une cellule et au moins un interrupteur de cellule et au moins un interrupteur de cellule et une cellule, et comprenant une branche transversale reliant les deux bornes intermédiaires de respectivement lesdites deux branches parallèles, cette branche transversale comprenant un interrupteur de cellule.

Le dispositif de génération d'énergie photovoltaïque peut comprendre plusieurs modules disposés en série comprenant chacun plusieurs cellules disposées en parallèle et/ou série, chaque cellule étant associée à au moins un interrupteur de cellule et chaque cellule comprenant une cellule photovoltaïque, comprenant une ou plusieurs cellule(s) photovoltaïque(s) élémentaire(s), et un élément de stockage connecté aux bornes de la cellule photovoltaïque.

Le dispositif de génération d'énergie photovoltaïque peut comprendre au moins une carte électronique comprenant :
- des bornes pour une liaison avec des cellules du dispositif de génération d'énergie photovoltaïque, et
- des interrupteurs de cellules, et/ou
- des interrupteurs parallèles, et/ou
- des interrupteurs de module.

Le dispositif de génération d'énergie photovoltaïque peut comprendre au moins une carte électronique intégrée au panneau photovoltaïque ou rattachée à la structure support du panneau photovoltaïque, notamment disposée sous la surface des cellules photovoltaïques, à l'opposé de leur face supérieure recevant un flux de lumière, de sorte que ses bornes de connexion avec les cellules se trouvent positionnées au plus proche des bornes des cellules de façon à réduire au maximum la longueur des connexions et donc les pertes associées.

Il peut comprendre au moins une carte électronique disposée de sorte à minimiser les chemins de puissance et/ou à optimiser la section de conducteur, notamment en renforçant les pistes du circuit imprimé formant ladite carte électronique en leur ajoutant un renfort conducteur électrique par-dessus, comme une baguette ou un fil conducteur.

Le dispositif de génération d'énergie photovoltaïque peut comprendre des trous réalisés au travers d'au moins une carte électronique pour faciliter la circulation d'air et le refroidissement des cellules et des composants électroniques.

Le dispositif de génération d'énergie photovoltaïque peut comprendre au moins un capteur de mesure d'une grandeur caractéristique de l'état d'une cellule, et peut comprendre, au niveau d'un module, un circuit de commande d'au moins un interrupteur de cellule et/ou d'un interrupteur parallèle pour le commander en fonction de la grandeur caractéristique de l'état de la cellule.

Le dispositif de génération d'énergie photovoltaïque peut comprendre plusieurs cellules associées chacune à au moins un interrupteur de cellule et/ou un interrupteur parallèle, commandé(s) par un ou plusieurs circuit(s) de commande alimenté(s) électriquement directement par au moins une cellule d'un module du dispositif de génération d'énergie photovoltaïque.

Le dispositif de génération d'énergie photovoltaïque peut comprendre au moins un circuit de traitement au niveau d'un module ou d'une brique et/ou un calculateur central, qui pilote(nt) des interrupteurs de cellule ou de module ou parallèles par l'intermédiaire d'un circuit de commande.

Le circuit de commande et/ou un circuit de traitement d'au moins un interrupteur peut être alimenté par au moins une cellule du module ou d'un module voisin ou de la brique ou d'une brique voisine de l'interrupteur de cellule qu'il pilote.

L'interrupteur de cellule et/ou de module et/ou parallèle peut être un transistor et/ou l'élément de stockage peut comprendre au moins un condensateur.

Le dispositif de génération d'énergie photovoltaïque peut comprendre trois colonnes comprenant chacune plusieurs modules disposés en série pour fournir une sortie triphasée.

L'invention porte aussi sur un procédé de gestion d'un dispositif de génération d'énergie photovoltaïque tel que décrit précédemment, caractérisé en ce qu'il comprend une étape de détermination de la position de plusieurs interrupteurs de cellule et/ou de plusieurs interrupteurs parallèles de plusieurs cellules disposées en parallèle pour maintenir les cellules dans un état de fonctionnement dans une plage autour d'un point de fonctionnement optimal.

La position d'au moins un interrupteur de cellule et/ou d'au moins un interrupteur parallèle peut maintenir une cellule dans un état de fonctionnement dans une plage de plus ou mois 5% autour d'un point de fonctionnement optimal.

Le procédé de gestion d'un dispositif de génération d'énergie photovoltaïque peut comprendre les étapes suivantes :
- lorsque la tension aux bornes d'une cellule dépasse une tension optimale correspondant au point de fonctionnement optimal, augmentée d'un pourcentage prédéfini, au moins un interrupteur de cellule et/ou parallèle est actionné pour permettre son utilisation pour produire une tension et un courant vers la sortie du dispositif, et/ou
- lorsque la tension aux bornes d'une cellule descend sous cette tension optimale diminuée d'un pourcentage prédéfini, au moins un interrupteur de cellule et/ou parallèle est actionné, de sorte qu'elle ne participe plus à la production de tension et de courant en sortie du dispositif.

Le procédé de gestion d'un dispositif de génération d'énergie photovoltaïque peut comprendre une étape de charge d'un élément de stockage par une cellule photovoltaïque pendant sa déconnexion du reste du dispositif.

Le procédé de gestion d'un dispositif de génération d'énergie photovoltaïque peut comprendre une étape de comparaison de l'état réel d'une cellule avec un état de fonctionnement optimal, mémorisé préalablement dans une mémoire électronique, ou une étape de recherche des conditions optimales de fonctionnement de la cellule.

Le procédé de gestion d'un dispositif de génération d'énergie photovoltaïque peut comprendre la mise en oeuvre des étapes suivantes :
- mesure d'une grandeur représentative de l'état d'une cellule et transmission de la grandeur mesurée à au moins un calculateur ;
- détermination de la position d'un interrupteur de cellule et/ou de module et/ou parallèle en prenant en compte la grandeur mesurée ;
- transmission d'une commande d'ouverture ou fermeture d'un interrupteur de cellule et/ou de module et/ou parallèle en fonction de la détermination précédente.

Le procédé de gestion d'un dispositif de génération d'énergie photovoltaïque peut comprendre une étape consistant à diagnostiquer une défaillance et/ou un état à risque d'une cellule, en reconnaissant les cellules défectueuses, comme en surchauffe suite à une situation de court-circuit, entrée d'humidité, d'arc électrique, de flamme, de défaut d'isolement, à partir de la grandeur mesurée au niveau d'une cellule, afin de déconnecter ou écarter du fonctionnement global du dispositif de génération d'énergie photovoltaïque la cellule concernée, en ouvrant son interrupteur de cellule et/ou en fermant l'interrupteur de module et/ou parallèle concerné.

Le procédé de gestion de dispositif de génération d'énergie photovoltaïque peut mettre en oeuvre les étapes suivantes :
- équilibrage des modules et/ou cellules entre eux, en utilisant en priorité les modules et/ou cellules dont la tension est la plus forte; et/ou
- équilibrage des modules et/ou cellules en modifiant le taux moyen d'utilisation des modules et/ou cellules, mais sans utiliser les mêmes modules et/ou cellules en permanence, de sorte que la tension des modules et/ou cellules s'équilibre.

Le procédé de gestion d'un dispositif de génération d'énergie photovoltaïque peut comprendre une étape d'alimentation électrique d'un circuit de commande d'un interrupteur de cellule et/ou d'un interrupteur parallèle à partir d'au moins une cellule du dispositif de génération d'énergie photovoltaïque.

Le procédé de gestion d'un dispositif de génération d'énergie photovoltaïque peut comprendre une étape d'alimentation électrique de tous les autres composants électroniques internes au dispositif de génération d'énergie photovoltaïque nécessitant une alimentation par au moins une cellule du dispositif de génération d'énergie photovoltaïque.

Le procédé de gestion d'un dispositif de génération d'énergie photovoltaïque peut comprendre une étape de communication par courant porteur entre un circuit de traitement d'un module et celui d'un autre module ou un calculateur central ou une charge.

Le procédé de gestion d'un dispositif de génération d'énergie photovoltaïque peut comprendre une étape de régulation de la tension de sortie du dispositif de génération d'énergie photovoltaïque qui comprend une étape d'ouverture/fermeture d'interrupteurs de cellules et/ou d'un interrupteur parallèle du dispositif de génération d'énergie photovoltaïque pour suivre une consigne de tension de sortie imposée, notamment une consigne variable avec le temps comme de forme sinusoïdale.

Le procédé de gestion d'un dispositif de génération d'énergie photovoltaïque peut comprendre une étape de déconnexion de toutes les cellules du dispositif de génération d'énergie photovoltaïque en cas d'arrêt prolongé du dispositif de génération d'énergie photovoltaïque ou d'incident.

Le procédé de gestion d'un dispositif de génération d'énergie photovoltaïque peut comprendre une étape de diagnostic du fonctionnement de tout ou partie des interrupteurs de cellules et/ou de modules et/ou parallèles.

Le procédé de gestion d'un dispositif de génération d'énergie photovoltaïque peut comprendre une étape d'identification des caractéristiques d'au moins une cellule photovoltaïque et/ou de l'ensoleillement en ouvrant sur une période prédéfinie au moins un interrupteur de cellule pour mesurer la tension à vide de la cellule photovoltaïque ou en fermant au moins un interrupteur de cellule et un interrupteur parallèle ou de module de sorte à disposer la cellule photovoltaïque en court-circuit pour mesurer le courant en court-circuit de ladite cellule photovoltaïque.

L'invention porte aussi sur un dispositif de génération d'énergie photovoltaïque comprenant plusieurs modules, caractérisé en ce qu'un module comprend au moins une cellule et au moins un interrupteur de cellule associé à la cellule, de sorte à pouvoir la déconnecter du reste du dispositif de génération d'énergie photovoltaïque, cette cellule comprenant une cellule photovoltaïque, comprenant une ou plusieurs cellule(s) photovoltaïque(s) élémentaire(s), et un élément de stockage connecté aux bornes de la cellule photovoltaïque.

Chaque module peut comprendre une borne inférieure apte à une connexion avec un module inférieur et une borne supérieure apte à une connexion avec un module supérieur, et peut comprendre un module comprenant au moins une branche entre sa borne inférieure et sa borne supérieure comprenant une cellule et un interrupteur de cellule disposés en série.

Le dispositif de génération d'énergie photovoltaïque peut comprendre un agencement de briques comprenant deux branches verticales parallèles comprenant respectivement une cellule et au moins un interrupteur de cellule, et au moins un interrupteur de cellule et une cellule, et comprenant une branche transversale reliant les deux bornes intermédiaires des deux branches verticales et comprenant un interrupteur de cellule.

Le dispositif de génération d'énergie photovoltaïque peut comprendre au moins un capteur de mesure d'une grandeur caractéristique de l'état d'une cellule, et comprendre, au niveau d'un module, un circuit de commande d'au moins un interrupteur de cellule pour le commander en fonction de la grandeur caractéristique de l'état de la cellule.

Le dispositif de génération d'énergie photovoltaïque peut comprendre un circuit de commande d'au moins un interrupteur de cellule directement alimenté électriquement par au moins une cellule d'un module du dispositif de génération d'énergie photovoltaïque.

Le circuit de commande d'au moins un interrupteur de cellule peut être alimenté par au moins une cellule à proximité de l'interrupteur de cellule qu'il pilote.

Le dispositif de génération d'énergie photovoltaïque peut comprendre plusieurs modules disposés en série comprenant chacun plusieurs cellules disposées en parallèle et/ou série, chaque cellule étant associée à au moins un interrupteur de cellule et chaque cellule comprenant une cellule photovoltaïque, comprenant une ou plusieurs cellule(s) photovoltaïque(s) élémentaire(s), et un élément de stockage connecté aux bornes de la cellule photovoltaïque.

Le dispositif de génération d'énergie photovoltaïque peut comprendre plusieurs cellules associées chacune à au moins un interrupteur de cellule, commandé par un ou plusieurs circuit(s) de commande alimenté(s) électriquement directement par au moins une cellule d'un module du dispositif de génération d'énergie photovoltaïque.

Le dispositif de génération d'énergie photovoltaïque peut comprendre un capteur de mesure du courant au niveau d'une cellule, et/ou un capteur de mesure de la tension aux bornes d'une cellule et/ou aux bornes d'un interrupteur de cellule, et/ou un capteur de mesure de la température d'une cellule et/ou de mesure de spectrométrie d'impédance.

Le dispositif de génération d'énergie photovoltaïque peut comprendre au moins un interrupteur de module connecté en parallèle d'un module ou au moins un module dont chaque cellule est associée à un interrupteur parallèle connecté en parallèle avec la cellule et un interrupteur de cellule disposé en série, et/ou au moins un interrupteur disposé en parallèle de plusieurs modules.

Le dispositif de génération d'énergie photovoltaïque peut comprendre au moins un circuit de traitement au niveau d'un module et/ou un calculateur central, qui pilote(nt) des interrupteurs de cellule ou de module par l'intermédiaire d'un circuit de commande.

Le dispositif de génération d'énergie photovoltaïque peut comprendre un calculateur central et un bus de communication reliant les différents modules comprenant au moins un interrupteur de cellule au calculateur central par l'intermédiaire d'une isolation galvanique.

Le dispositif de génération d'énergie photovoltaïque peut comprendre une carte électronique comprenant :
- des bornes pour une liaison avec des cellules du dispositif de génération d'énergie photovoltaïque, et
- des interrupteurs de cellules pour un ou plusieurs modules, et
- des capteurs de mesure d'une grandeur caractéristique de l'état de cellules et/ou un circuit de commande des interrupteurs de cellules.

Le dispositif de génération d'énergie photovoltaïque peut comprendre au moins un pont en H apte à inverser la tension aux bornes de tout ou partie du dispositif de génération d'énergie photovoltaïque.

Le dispositif de génération d'énergie photovoltaïque peut comprendre plusieurs sous-ensembles de cellules et des interrupteurs disposés entre ces sous-ensembles aptes à disposer deux sous-ensembles en série ou en parallèle.

Le dispositif de génération d'énergie photovoltaïque peut comprendre des interrupteurs pour inverser la tension aux bornes de tout ou partie du dispositif de génération d'énergie photovoltaïque et/ou modifier l'assemblage en série ou en parallèle de sous-ensembles du dispositif de génération d'énergie photovoltaïque, et ces interrupteurs peuvent être commandés par au moins un circuit de commande disposé au niveau d'un module du dispositif de génération d'énergie photovoltaïque.

L'interrupteur de cellule et/ou de module peut être un transistor.

L'élément de stockage peut comprendre au moins un condensateur.

Le dispositif de génération d'énergie photovoltaïque peut comprendre trois colonnes comprenant chacune plusieurs modules disposés en série pour fournir une sortie triphasée.

L'invention porte aussi sur un procédé de gestion d'un dispositif de génération d'énergie photovoltaïque qui comprend une étape de détermination de la position d'au moins un interrupteur de cellule pour maintenir la cellule photovoltaïque dans un état de fonctionnement dans une plage autour d'un point de fonctionnement optimal.

La position d'au moins un interrupteur de cellule peut maintenir la cellule dans un état de fonctionnement dans une plage de plus ou mois 5% autour d'un point de fonctionnement optimal.

Le procédé de gestion d'un dispositif de génération d'énergie photovoltaïque peut comprendre les étapes suivantes :
- lorsque la tension aux bornes d'une cellule dépasse une tension optimale correspondant au point de fonctionnement optimal, augmentée d'un pourcentage prédéfini, au moins un interrupteur de cellule est fermé pour permettre son utilisation pour produire une tension et un courant vers la sortie du dispositif, et/ou
- lorsque la tension aux bornes d'une cellule descend sous cette tension optimale diminuée d'un pourcentage prédéfini, au moins un interrupteur de cellule est ouvert, de sorte qu'elle ne participe plus à la production de tension et de courant en sortie du dispositif.

Le procédé de gestion d'un dispositif de génération d'énergie photovoltaïque peut comprendre une étape de charge d'un élément de stockage par une cellule photovoltaïque pendant sa déconnexion du reste du dispositif.

Le procédé de gestion d'un dispositif de génération d'énergie photovoltaïque peut comprendre une étape de comparaison de l'état réel d'une cellule avec un état de fonctionnement optimal, mémorisé préalablement dans une mémoire électronique, ou une étape de recherche des conditions optimales de fonctionnement de la cellule.

Le procédé de gestion d'un dispositif de génération d'énergie photovoltaïque peut comprendre la mise en oeuvre des étapes suivantes :
- mesure d'une grandeur représentative de l'état d'une cellule et transmission de la grandeur mesurée à au moins un calculateur ;
- détermination de la position d'un interrupteur de cellule et/ou de module en prenant en compte la grandeur mesurée ;
- transmission d'une commande d'ouverture ou fermeture d'un interrupteur de cellule et/ou de module en fonction de la détermination précédente.

Le procédé de gestion d'un dispositif de génération d'énergie photovoltaïque peut comprendre une étape consistant à diagnostiquer une défaillance et/ou un état à risque d'une cellule, en reconnaissant les cellules défectueuses, comme en surchauffe suite à une situation de court-circuit, entrée d'humidité, d'arc électrique, de flamme, de défaut d'isolement, à partir de la grandeur mesurée au niveau d'une cellule, afin de déconnecter ou écarter du fonctionnement global du dispositif de génération d'énergie photovoltaïque la cellule concernée, en ouvrant son interrupteur de cellule et/ou en fermant l'interrupteur de module concerné.

Le procédé de gestion de dispositif de génération d'énergie photovoltaïque peut mettre en œuvre les étapes suivantes :
- équilibrage des modules et/ou cellules entre eux, en utilisant en priorité les modules et/ou cellules dont la tension est la plus forte; et/ou
- équilibrage des modules et/ou cellules en modifiant le taux moyen d'utilisation des modules et/ou cellules, mais sans utiliser les mêmes modules et/ou cellules en permanence, de sorte que la tension des modules et/ou cellules s'équilibre.

Le procédé de gestion d'un dispositif de génération d'énergie photovoltaïque peut comprendre une étape d'alimentation électrique d'un circuit de commande d'un interrupteur de cellule à partir d'au moins une cellule du dispositif de génération d'énergie photovoltaïque.

Le procédé de gestion d'un dispositif de génération d'énergie photovoltaïque peut comprendre une étape d'alimentation électrique de tous les autres composants électroniques internes au dispositif de génération d'énergie photovoltaïque nécessitant une alimentation par au moins une cellule du dispositif de génération d'énergie photovoltaïque.

Le procédé de gestion d'un dispositif de génération d'énergie photovoltaïque selon peut comprendre une étape de communication par courant porteur entre un circuit de traitement d'un module et celui d'un autre module ou un calculateur central ou une charge.

Le procédé de gestion d'un dispositif de génération d'énergie photovoltaïque peut comprendre une étape de régulation de la tension de sortie du dispositif de génération d'énergie photovoltaïque qui comprend une étape d'ouverture/fermeture d'interrupteurs de cellules du dispositif de génération d'énergie photovoltaïque pour suivre une consigne de tension de sortie imposée.

Le procédé de gestion d'un dispositif de génération d'énergie photovoltaïque peut comprendre une étape de déconnexion de toutes les cellules du dispositif de génération d'énergie photovoltaïque en cas d'arrêt prolongé du dispositif de génération d'énergie photovoltaïque ou d'incident.

Le procédé de gestion d'un dispositif de génération d'énergie photovoltaïque peut comprendre une étape de diagnostic du fonctionnement de tout ou partie des interrupteurs de cellules et/ou de modules et/ou parallèles.

Le procédé de gestion d'un dispositif de génération d'énergie photovoltaïque peut comprendre une étape de calcul du nombre de sous-ensembles du dispositif de génération d'énergie photovoltaïque à disposer en parallèle ou en série.

Le procédé de gestion d'un dispositif de génération d'énergie photovoltaïque peut comprendre une étape d'identification des caractéristiques d'au moins une cellule photovoltaïque et/ou de l'ensoleillement en ouvrant sur une période prédéfinie au moins un interrupteur de cellule pour mesurer la tension à vide de la cellule photovoltaïque ou en fermant au moins un interrupteur de cellule et un interrupteur parallèle ou de module de sorte à disposer la cellule photovoltaïque en court-circuit pour mesurer le courant en court-circuit de ladite cellule photovoltaïque.

Ces objets, caractéristiques et avantages de la présente invention seront exposés en détail dans la description suivante de modes de réalisation particuliers faits à titre non-limitatif en relation avec les figures jointes parmi lesquelles :
La figure 1 représente schématiquement l'utilisation d'un dispositif de génération d'énergie photovoltaïque selon un état de la technique.
La figure 2 représente le schéma électrique d'une cellule photovoltaïque élémentaire connectée à une charge.
La figure 3 représente l'évolution de l'intensité et de la puissance fournie par une cellule photovoltaïque en fonction de la tension à ses bornes.
La figure 4 représente l'évolution de l'intensité en fonction de la tension aux bornes d'une cellule photovoltaïque pour différentes températures.
La figure 5 représente l'évolution de l'intensité en fonction de la tension aux bornes d'une cellule photovoltaïque pour différents éclairages.
La figure 6 représente schématiquement un dispositif de génération d'énergie photovoltaïque selon un mode de réalisation de l'invention.
La figure 7 représente une autre illustration schématique du même dispositif de génération d'énergie photovoltaïque selon un mode de réalisation de l'invention.
La figure 8 représente schématiquement un module du dispositif de génération d'énergie photovoltaïque selon le mode de réalisation de l'invention.
La figure 9 illustre plus précisément le schéma électrique choisi pour mettre en œuvre le module illustré sur la figure 8.
La figure 10 illustre le schéma électrique pour mettre en œuvre le module illustré sur la figure 8 selon une variante de réalisation.
La figure 11 représente l'implémentation physique des fonctions électriques de l'invention dans l'architecture d'un dispositif de génération d'énergie photovoltaïque selon un mode de réalisation de l'invention.
La figure 12 illustre plus précisément les composants présents sur chaque carte électronique du mode de réalisation de l'invention.
Les figures 13a et 13c illustrent une variante de réalisation du mode de réalisation de l'invention.
La figure 14 représente de manière plus détaillée l'architecture de la carte électronique selon cette variante de réalisation du mode de réalisation de l'invention.
La figure 15 illustre une seconde variante de réalisation du mode de réalisation de l'invention.
La figure 16 représente de manière plus détaillée l'architecture de la carte électronique associée à un module selon cette seconde variante de réalisation du mode de réalisation de l'invention.
Les figures 17a et 17b illustrent une troisième variante de réalisation du mode de réalisation de l'invention.
La figure 18 illustre une variante de réalisation d'une carte électronique du mode de réalisation de l'invention.
La figure 19 illustre un mode de réalisation d'un bâti intégrant un dispositif de génération d'énergie photovoltaïque selon l'invention.
La figure 20 illustre les étapes d'un procédé de gestion d'une cellule d'un dispositif de génération d'énergie photovoltaïque selon un mode de réalisation de l'invention.
La figure 21 illustre les étapes d'un procédé de gestion d'un module d'un dispositif de génération d'énergie photovoltaïque selon un mode de réalisation de l'invention.
La figure 22 illustre le principe de pilotage d'un transistor parallèle selon un mode de réalisation de l'invention.
La figure 23 illustre un mode de réalisation d'une commande asservie du dispositif de génération d'énergie photovoltaïque selon l'invention.
La figure 24 représente un exemple de tension qui peut être fournie par le dispositif de génération d'énergie photovoltaïque selon l'invention.
La figure 25 représente un mode de réalisation d'un dispositif de génération d'énergie photovoltaïque selon l'invention présentant un pont en H.
La figure 26 représente de manière plus détaillée l'architecture d'un dispositif de génération d'énergie photovoltaïque présentant un pont en H selon un mode de réalisation de l'invention.
La figure 27 illustre schématiquement la mise en œuvre du principe de communication par courant porteur au sein du dispositif de génération d'énergie photovoltaïque selon un mode de réalisation de l'invention.
Les figures 28 à 30 illustrent trois variantes de réalisation d'un dispositif de génération d'énergie photovoltaïque avec plusieurs interrupteurs parallèles distincts selon un mode de réalisation de l'invention.
La figure 31 illustre un mode de réalisation de l'invention, dans lequel le dispositif de génération d'énergie photovoltaïque est séparé en plusieurs parties.
La figure 32 représente de manière plus détaillée l'architecture d'un dispositif de génération d'énergie photovoltaïque séparée en plusieurs parties et présentant un pont en H selon un mode de réalisation de l'invention.
La figure 33 représente l'architecture d'un calculateur mettant en œuvre un procédé de gestion d'un dispositif de génération d'énergie photovoltaïque selon un mode de réalisation de l'invention.
La figure 34 représente de manière plus détaillée une variante d'architecture d'un dispositif de génération d'énergie photovoltaïque séparé en plusieurs parties et présentant un pont en H selon un mode de réalisation de l'invention.
La figure 35 illustre une solution pour le pilotage des transistors séries et parallèle à partir d'une tension relativement faible issue des cellules.
La figure 36 illustre un dispositif de génération d'énergie photovoltaïque comprenant trois colonnes selon un mode de réalisation de l'invention adapté pour délivrer trois tensions indépendantes avec inversion possible de signe.
La figure 37 illustre une variante de réalisation du dispositif de génération d'énergie photovoltaïque de la figure 36 adaptée pour délivrer une tension triphasée.
La figure 38 représente de manière détaillée une architecture d'un dispositif de génération d'énergie photovoltaïque délivrant une tension triphasée selon un mode de réalisation de l'invention.
La figure 39 représente un exemple de fonctionnement du dispositif de génération d'énergie photovoltaïque de la figure 38 délivrant une tension triphasée.
La figure 40 illustre un mode de réalisation de l'invention permettant des mises en série ou parallèle de cellules de modules.
La figure 41 illustre une variante du mode de réalisation précédent.
La figure 42 illustre un autre mode de réalisation de l'invention permettant des mises en série ou parallèle de cellules de modules.
La figure 43 illustre une variante du mode de réalisation précédent.
La figure 44 illustre les éléments de gestion de la variante du mode de réalisation précédent.
Les figures 45 et 46 illustrent un autre mode de réalisation de l'invention permettant des mises en série ou parallèle de cellules de modules.

Pour la suite de la description, nous appellerons cellule photovoltaïque élémentaire 2 la cellule photovoltaïque se présentant comme un ensemble de surface minimale indissociable de production d'énergie photovoltaïque. Nous appellerons cellule photovoltaïque 7 un ensemble d'une ou plusieurs cellule(s) photovoltaïque(s) élémentaire(s). Dans le cas d'une multitude de cellules photovoltaïques élémentaires, elles pourront être associées selon tout schéma électrique, en série et/ou parallèle, dans une telle cellule photovoltaïque. Ensuite, nous appellerons cellule 11 l'association d'une cellule photovoltaïque 7 avec un élément de stockage électrique 8, relié à ses bornes, qui peut être de tout type, par exemple capacitif.

Dans les figures suivantes, les mêmes références seront utilisées pour des éléments identiques ou similaires dans chaque mode de réalisation de l'invention, pour une raison de simplification de la description.

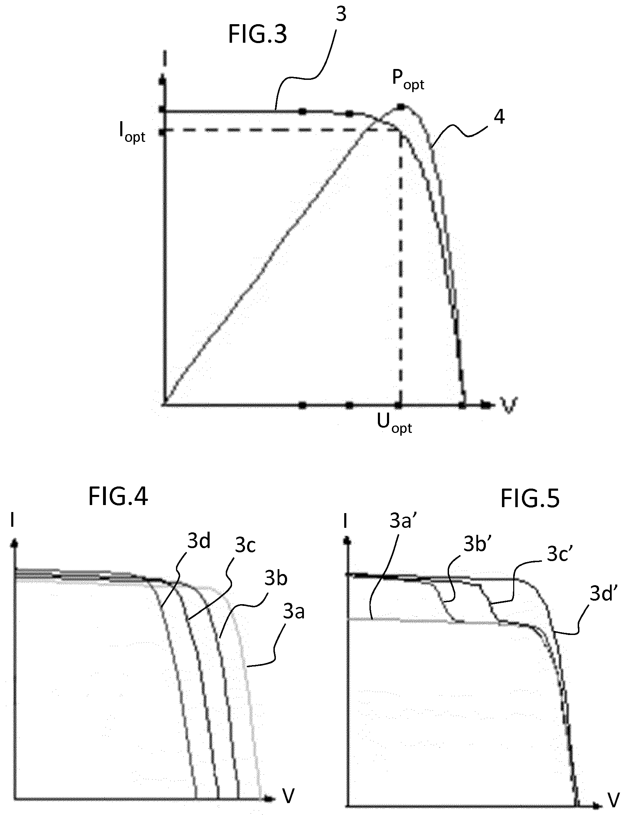

La figure 2 représente schématiquement le circuit électrique équivalent à une cellule photovoltaïque élémentaire 2 reliée à une charge 15. La figure 3 représente la courbe 3 d'évolution de l'intensité I aux bornes de la cellule photovoltaïque élémentaire en fonction de la tension V, ainsi que la courbe 4 d'évolution de la puissance fournie par la cellule photovoltaïque élémentaire, définie par la formule P = V x I en fonction de la tension V. Il en ressort qu'il existe un point de fonctionnement optimal Pₒₚₜ, pour lequel la puissance fournie par la cellule photovoltaïque élémentaire, définie par la formule Pₒₚₜ = Uₒₚₜ x Iₒₚₜ, est maximale. Comme cela a été rappelé en préambule, les dispositifs de génération d'énergie photovoltaïque comprennent de nombreuses cellules photovoltaïques qui ne fonctionnement pas toutes dans ces conditions de fonctionnement optimales. Les modes de réalisation de l'invention qui vont être décrits permettent d'améliorer la performance de la génération d'énergie photovoltaïque notamment en permettant à un maximum de cellules photovoltaïques élémentaires de fonctionner à leur point de fonctionnement optimal ou à proximité.

En complément, la figure 4 illustre quatre courbes 3a, 3b, 3c, 3d d'évolution de l'intensité I aux bornes de la cellule photovoltaïque élémentaire en fonction de la tension V pour respectivement une température de la cellule égale à 0° C, 25 °C, 50 °C et 75 °C. Cette figure montre que ces courbes dépendent de la température, et il en résulte que le point de fonctionnement optimal mentionné ci-dessus dépend aussi de la température.

La figure 5 illustre quatre courbes 3a', 3b', 3c', 3d' d'évolution de l'intensité I aux bornes d'un dispositif de génération d'énergie photovoltaïque en fonction de la tension V pour respectivement quatre éclairements différents. La courbe 3d' représente un éclairement maximal de 1000 W/m², alors que la courbe 3a' représente la courbe pour un éclairement de 800 W/m² pour l'ensemble du dispositif. Les courbes 3b' et 3c' représentent des situations intermédiaires pour lesquelles une partie seulement de la surface du dispositif d'énergie photovoltaïque ne reçoit que 800 W/m² et non 1000 W/m², par exemple lorsqu'une partie du dispositif est ombragé, cette partie étant plus importante dans le cas de la courbe 3b' que dans celui de la courbe 3c'.

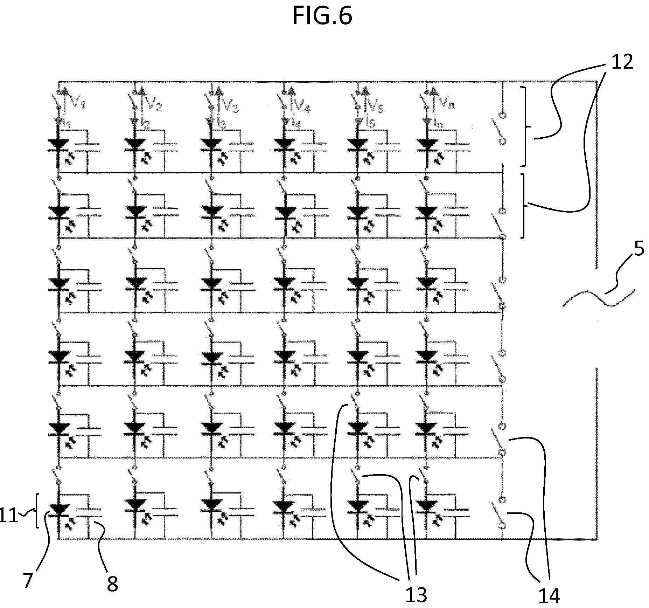

La figure 6 représente schématiquement un mode de réalisation de l'invention dans lequel un dispositif de génération d'énergie photovoltaïque comprend une multitude de cellules 11, formées par une cellule photovoltaïque 7 et un élément de stockage 8, organisées en plusieurs modules 12 ou étage, comprenant chacun plusieurs cellules 11 disposées en parallèle. De plus, chaque cellule 11 est associée à un interrupteur 13 qui lui est propre, disposé en série, qui permet de déconnecter la cellule du reste du dispositif de génération d'énergie photovoltaïque par son ouverture : pour cela, nous l'appellerons « interrupteur de cellule 13 » par la suite. De plus chaque module 12 comprend aussi un interrupteur 14 en parallèle des cellules 11 du module 12, permettant ainsi de court-circuiter l'ensemble du module : pour cela, nous l'appellerons « interrupteur de module 14 » par la suite. L'utilisation d'une telle structure pour un générateur d'énergie photovoltaïque permet de s'affranchir des convertisseurs intermédiaires utilisés dans l'état de la technique, par exemple pour une liaison sur le secteur 5, comme cela apparaît sur cette figure 6. Ce fonctionnement sera explicité par la suite.

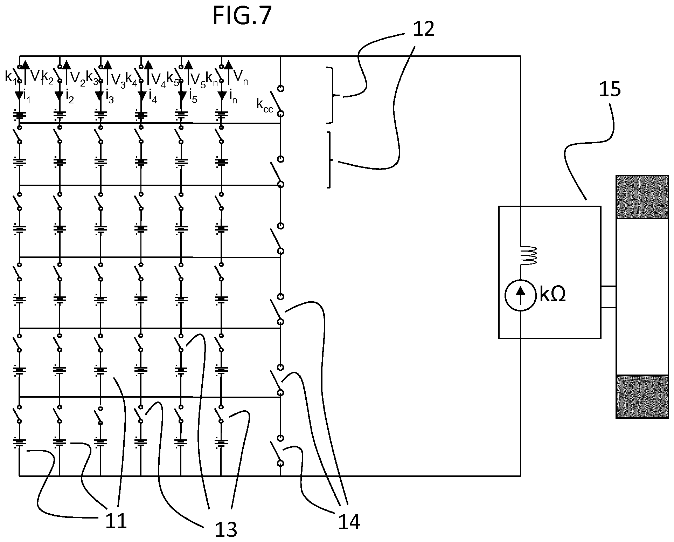

La figure 7 représente aussi schématiquement le même mode de réalisation de l'invention, dans lequel la représentation de la cellule 11 a été simplifiée par rapport à la figure 6. Cette simplification sera conservée sur les figures suivantes pour les alléger. La cellule 11 conserve toutefois bien la même structure que celle décrite ci-dessus. D'autre part, le dispositif de génération d'énergie est ici illustré dans une utilisation différente, pour alimenter une charge 15, comme un moteur. Dans cette variante d'utilisation, il n'y a pas non plus besoin d'un convertisseur intermédiaire entre le dispositif de génération d'énergie et la charge 15.

Selon un aspect avantageux de l'invention, un ou des capteurs de mesure sont intégrés au niveau de tout ou partie des cellules du dispositif de génération d'énergie photovoltaïque, en plus de l'interrupteur représenté, pour permettre, par l'intermédiaire d'un dispositif de commande de ces interrupteurs, d'utiliser ou non certaines cellules en fonction de leur état et des besoins, en fonction des mesures effectuées. Cela permet l'optimisation du dispositif de génération d'énergie photovoltaïque.

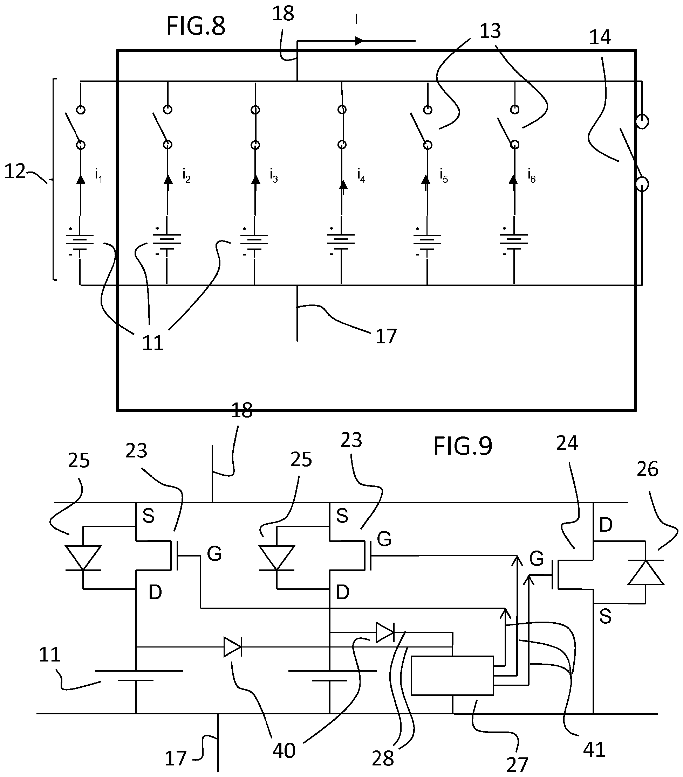

La figure 8 illustre plus en détail un module 12 du dispositif de génération d'énergie photovoltaïque selon le mode de réalisation de l'invention. Il comprend une borne inférieure 17, reliée à un module voisin inférieur, et une borne supérieure 18 pour une liaison série avec le module voisin supérieur. Selon cet exemple, ce module comprend six cellules 11 disposées en parallèle. Naturellement, il pourrait en variante comprendre tout autre nombre de cellules. Plus précisément, le module comprend d'abord six branches parallèles disposées entre ses bornes supérieure 18 et inférieure 17, sur lesquelles sont disposées une cellule 11 et un interrupteur de cellule 13, apte à déconnecter ou non la cellule d'une des deux bornes 17, 18. Il comprend une septième branche sur laquelle est disposé un interrupteur de module 14, en parallèle avec les cellules, apte à shunter les cellules. Sur l'exemple illustré, seules les troisième et quatrième cellules sont utilisées car leurs interrupteurs de cellule 13 respectifs sont fermés, alors que tous les autres interrupteurs de cellule sont ouverts. D'autre part, l'interrupteur de module 14 est ouvert pour mettre le module 12 dans sa configuration normale de fonctionnement.

La figure 9 illustre plus précisément le schéma électrique choisi pour mettre en œuvre le schéma explicité ci-dessus, en référence avec la figure 5. Sur cette figure 9, seuls deux interrupteurs de cellule 13 sont représentés pour simplifier la figure. Les différents interrupteurs 13, 14 sont réalisés à l'aide de transistors de puissance 23, 24, de préférence des transistors de type NMOS, qui apportent un gain en conductivité dans leur état passant par rapport à des transistors PMOS qui pourraient en variante être utilisés. En variante, il est aussi possible d'utiliser d'autres types de transistors tel que des bipolaires, FET, JFET, IGBT, etc. On peut aussi placer plusieurs transistors en parallèle pour mieux assurer le passage du courant. Naturellement, il existe donc au moins autant de transistors de cellule 23 que d'interrupteurs de cellule 13, et un transistor de module 24 pour former l'interrupteur de module 14. Tous ces transistors 23, 24 sont associés à des diodes 25, 26 montées en parallèle, qui sont intégrées dans les transistors si ce sont des transistors de puissance discrets NMOS ou en variante sont des diodes distinctes, pour représenter leur caractéristique de laisser passer le courant en sens inverse. Enfin, un circuit de commande 27, généralement appelé par la dénomination anglo-saxonne « driver », est alimenté électriquement par des liaisons 28 lui permettant de récupérer une différence de tension correspondant sensiblement à la tension de la cellule de plus forte tension, légèrement diminuée par une chute de tension (par exemple proche de 0,6 V) au niveau des diodes 40 disposées sur les liaisons 28.

Ce circuit de commande a pour fonction de générer des signaux de commande 41 vers les différents transistors 23, 24 pour les actionner, remplissant ainsi une fonction de commande des interrupteurs. De manière similaire et non représenté pour une question de clarté des figures, tous les composants électroniques du module peuvent être alimentés selon la même solution, comme un calculateur permettant d'estimer l'état des interrupteurs, un éventuel système de communication, etc.

Le fonctionnement de ce dispositif va maintenant être expliqué. Lors de son utilisation dans un circuit similaire à celui de la figure 7, en configuration habituelle de fonctionnement, au moins un des transistors de cellule 23 est fermé, alors que le transistor de module 24 est ouvert, ce qui permet aux cellules 11 associées aux transistors de cellule 23 fermés de délivrer une tension et un courant qui traverse les transistors fermés et qui va finalement contribuer à l'alimentation de la charge 15. Un courant circule de la borne inférieure 17 vers la borne supérieure 18. En revanche, si tous les transistors de cellule 23 sont ouverts et que le transistor de module 24 est fermé, le courant va passer par ce transistor de module et les cellules du module sont isolées, ne participent pas à la génération du courant d'alimentation. Dans le cas où tous les transistors 23, 24 sont ouverts, le courant du dispositif de génération d'énergie photovoltaïque, va passer par la diode inverse 26 associée au transistor de module 24, et la tension aux bornes 17, 18 du module reste égale à environ -0,6 V (la tension de la borne supérieure 18 est inférieure d'environ 0,6 V à celle de la borne inférieure 17 : cette chute de tension provient de la diode inverse 26 associée au transistor de module 26). Enfin, il est évité de positionner un transistor de cellule 23 fermé alors que le transistor de module 24 est aussi fermé, pour ne pas mettre la cellule 11 en court circuit, pour des raisons de sécurité. Ainsi, pour tout passage des transistors de cellule 23 fermés vers une situation où le transistor de module 24 est fermé, ou inversement, il sera de préférence procédé à une étape intermédiaire d'ouverture de tous les transistors, pendant une courte période de quelques nanosecondes par exemple.

D'autre part, lors de l'ouverture d'un interrupteur de cellule, l'élément de stockage associé à la cellule photovoltaïque va se charger, tout en permettant le maintien de la cellule photovoltaïque vers son point de fonctionnement optimal.

Il est intéressant de noter que la tension d'un module reste faible, même quand tous les transistors sont ouverts, ce qui permet d'utiliser des transistors supportant des tensions relativement faibles et peu coûteux, et dont la résistance à l'état passant est très faible, ce qui induit peu de pertes. Cela sera notamment vérifié si les cellules 11 présentent une tension inférieure à 40 V.

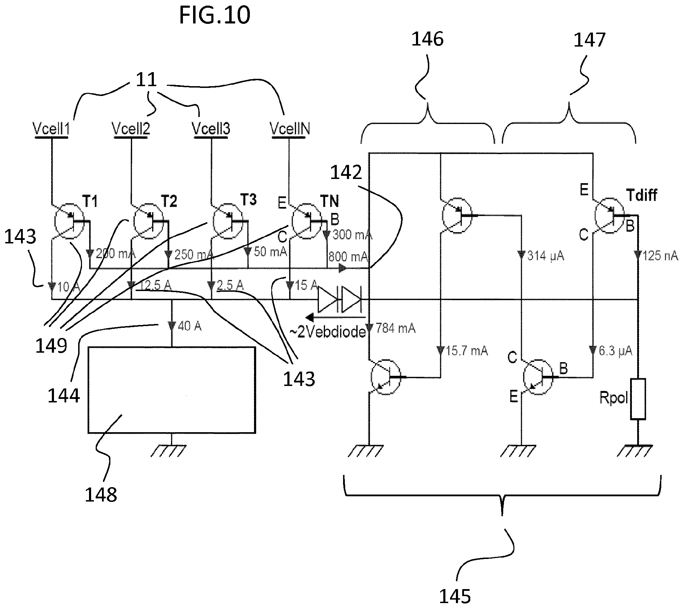

La figure 10 illustre une variante de réalisation du schéma électrique précédent pour implémenter le même principe différemment, permettant notamment d'obtenir une alimentation locale des composants électroniques 148 du circuit à partir de la tension stockée par les cellules du module considéré, voire d'un module voisin. Pour une raison de simplification, les composants électroniques ne sont pas détaillés, mais ils comprennent au moins un circuit de commande et des interrupteurs, comme explicité ci-dessus. Dans cette variante, un transistor 149 PNP bipolaire est associé à chaque cellule 11 du module. Tous ces transistors 149 sont commandés par un même courant d'une borne 142 d'un dispositif de commande 145. Il en résulte en sortie 143 de chaque transistor un courant dont l'intensité dépend de la tension de chaque cellule 11, c'est-à-dire de l'état de chaque cellule 11. Ces courants sont additionnés afin d'alimenter les composants électroniques par un courant 144 résultant. La commande des transistors 149 est telle que le courant 144 final d'alimentation atteint une valeur souhaitée. La solution permet de solliciter les différentes cellules du module en fonction de leur état, de leur tension disponible.

Cette solution évite de plus d'avoir la chute de tension entre la tension disponible au niveau du module et celle réellement exploitable par les composants électroniques, comme dans la réalisation décrite ci-dessus en référence avec la figure 9, du fait de l'utilisation de diodes. Cette chute de tension peut notamment être gênante dans une réalisation pour laquelle les cellules seraient des cellules basse tension, de valeur 1.5 V par exemple.

Le dispositif de commande 145 comprend un dispositif d'amplification comprenant deux étages d'amplification 146 et 147 selon ce mode de réalisation pour permettre de mettre en œuvre la commande du dispositif d'alimentation décrit ci-dessus sans nécessiter une puissance trop importante, qui engendrerait une chute de tension au niveau du module, ce qui est évité dans cette réalisation. Pour cela, un premier courant très faible est prélevé sur le module, au niveau d'un premier transistor Tdiff, puis amplifier par une cascade d'amplification, pour atteindre la valeur de commande souhaitée sur la borne 142. Le courant de commande sur la borne 142 s'ajuste automatiquement en fonction de la demande en courant des composants électroniques 148, ce qui limite celui-ci au strict nécessaire et en temps réel et limite ainsi la consommation moyenne liée à cette commande.

Les valeurs numériques illustrent un exemple d'implémentation permettant d'atteindre un courant d'alimentation de 40 A en prélevant un courant de 125 nA pour sa commande.

Selon le mode de réalisation de l'invention, chaque cellule comprend de plus au moins un capteur de mesure d'une grandeur caractéristique de l'état de la cellule. Ce capteur de mesure peut par exemple mesurer la tension et/ou l'intensité et/ou la température au niveau de la cellule concernée. Chaque capteur de mesure est de plus relié par un dispositif de communication à un dispositif intelligent, local et/ou distant, comme un calculateur de type microcontrôleur, qui reçoit les valeurs mesurées et met en œuvre un procédé de gestion du dispositif de génération d'énergie photovoltaïque, qui sera décrit plus en détail ultérieurement, pour déterminer un mode de fonctionnement optimisé du dispositif de génération d'énergie photovoltaïque, en tenant compte des mesures effectuées. Ce fonctionnement optimisé consiste en fait à déterminer les interrupteurs 13, 14 qui doivent être ouverts et fermés. Cette configuration des différents interrupteurs du dispositif de génération d'énergie photovoltaïque peut être modifiée en temps réel. Cette solution permet ainsi par exemple d'écarter les cellules défectueuses, d'aiguiller le courant au sein même de chaque module, d'équilibrer chacune des cellules du dispositif de génération d'énergie photovoltaïque en temps réel. En remarque, le courant moyen demandé par une charge 15 alimentée par le dispositif de génération d'énergie photovoltaïque est en général beaucoup plus faible que le courant crête demandé en pointe de consommation, ce qui permet au dispositif de génération d'énergie photovoltaïque de fonctionner avec satisfaction la plupart du temps avec un nombre relativement important de cellules déconnectées, c'est-à-dire dont l'interrupteur de cellule 13 associé est ouvert, voire de modules déconnectés, c'est-à-dire dont l'interrupteur de module 14 associé est fermé, si l'ensemble d'un module est considéré comme défectueux par exemple.

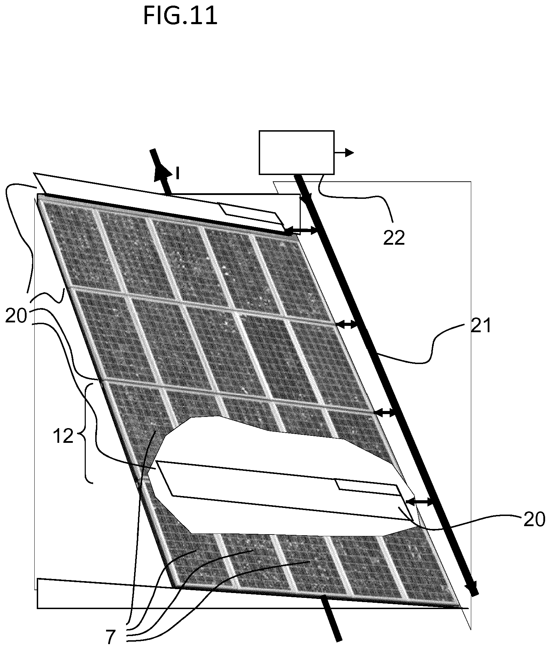

Les figures 11 à 13 représentent des exemples possibles de réalisation physique des fonctions électriques ajoutées par l'invention dans l'architecture d'un dispositif de génération d'énergie photovoltaïque selon un mode de réalisation de l'invention.

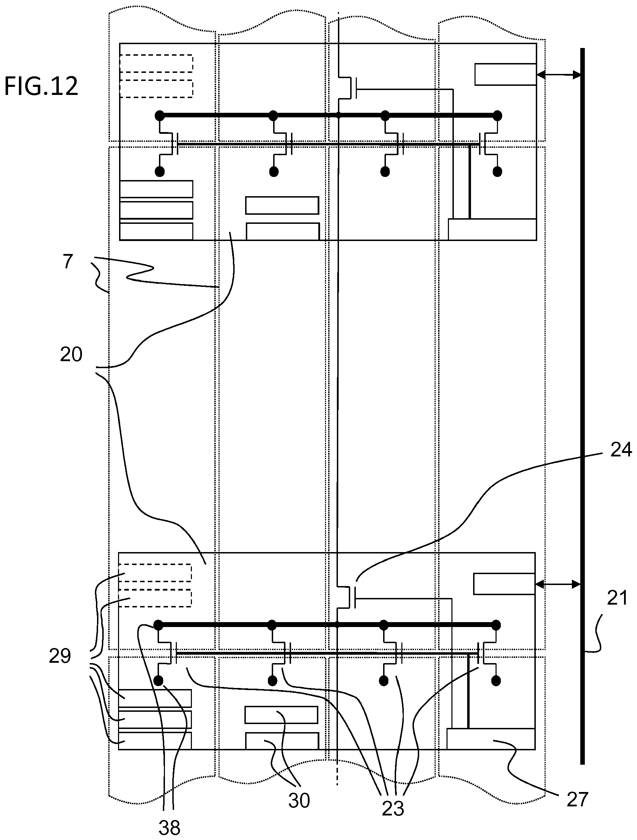

Les figures 11 et 12 illustrent une première réalisation dans laquelle une carte électronique 20, qui comprend les composants explicités précédemment, est ajoutée pour chaque module du dispositif de génération d'énergie photovoltaïque. Cette carte électronique se présente sous la forme d'un circuit imprimé positionné sous la surface de chaque module, sous les cellules photovoltaïques 7, qui remplissent ainsi une fonction de protection des cartes électroniques contre les agressions extérieures, comme provenant de salissure, de la pluie, etc. Ainsi, le dispositif de génération d'énergie photovoltaïque comprend une carte électronique 20 pour chaque module. Les plaques de cellules photovoltaïques peuvent s'enficher directement dans la carte électronique 20 via des connecteurs ou avoir des connexions électriques soudées, de sorte à relier électriquement par des connexions 38 les cellules photovoltaïques aux cartes électroniques. Les éléments de stockage, non représentés, peuvent s'étendre sous une part importante de la surface photovoltaïque ou se présenter simplement comme un composant de taille réduite soudé sur la carte électronique selon l'usage (simple filtrage de la tension ou stockage de masse). Les cartes électroniques 20 peuvent être intégrées au panneau photovoltaïque ou être rattachées à la structure support du panneau photovoltaïque. Par exemple, dans le cas d'une intégration dans une toiture supportée par une charpente, les cartes électroniques 20 peuvent être disposées et fixées sur les liteaux ou chevrons de la charpente sur lesquels viendront reposer les panneaux photovoltaïques qui servent en même temps de couverture à la toiture.

Ensuite, selon la réalisation représentée sur les figures 11 et 12, chaque carte électronique est reliée par un bus de communication 21 à un calculateur central 22, qui reçoit les mesures effectuées localement au sein d'un module du dispositif de génération d'énergie photovoltaïque et met en œuvre un procédé de gestion du dispositif de génération d'énergie photovoltaïque, comprenant notamment la transmission de commandes d'ouverture et/ou fermeture des interrupteurs du dispositif de génération d'énergie photovoltaïque. Ce transfert de données par le bus de communication 21 peut nécessiter un éventuel multiplexage et numérisation des données, ainsi qu'une isolation galvanique (par transformateur ou optocoupleur). D'autre part, un circuit de commande 27 est placé sur chaque carte électronique et constitue un élément intermédiaire entre le calculateur 22 et les interrupteurs, permettant l'adaptation de la tension transmise aux transistors 23, 24 formant la fonction d'interrupteurs pour la mise en œuvre des commandes du calculateur. Ces circuits de commande 27 peuvent de plus intégrer des fonctions de sécurité pour éviter par exemple de fermer un interrupteur de module 14 alors que les interrupteurs de cellule 13 sont fermés, pour éviter tout court-circuit.

La figure 12 illustre plus précisément les composants présents sur chaque carte électronique, qui comprend des capteurs de mesure 29, pour mesurer la température, la tension, et le courant, un ou plusieurs circuits de traitement 30 pour estimer l'état de chaque cellule par exemple, déterminer la pertinence d'utiliser ou non chaque cellule, etc. La carte électronique 20 comprend de plus un circuit de commande 27 permettant l'actionnement des différents transistors 23, 24, formant les interrupteurs 13, 14. Enfin, elle comprend une interface de communication en liaison avec le dispositif de communication afin de communiquer avec le calculateur central 22.

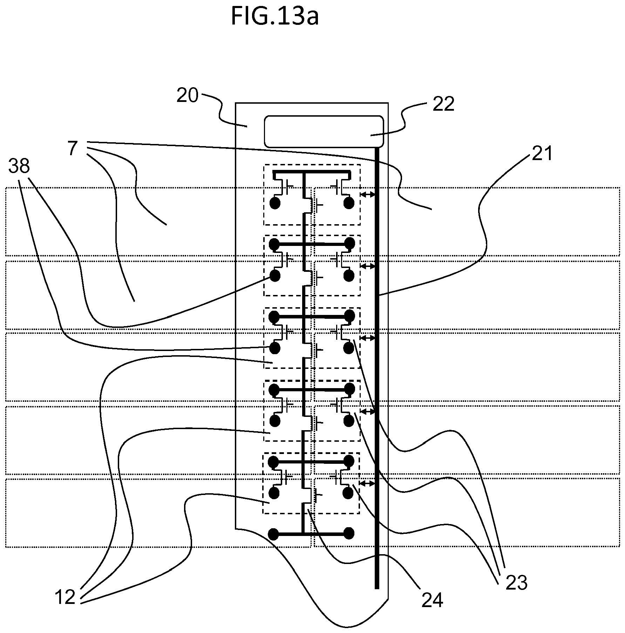

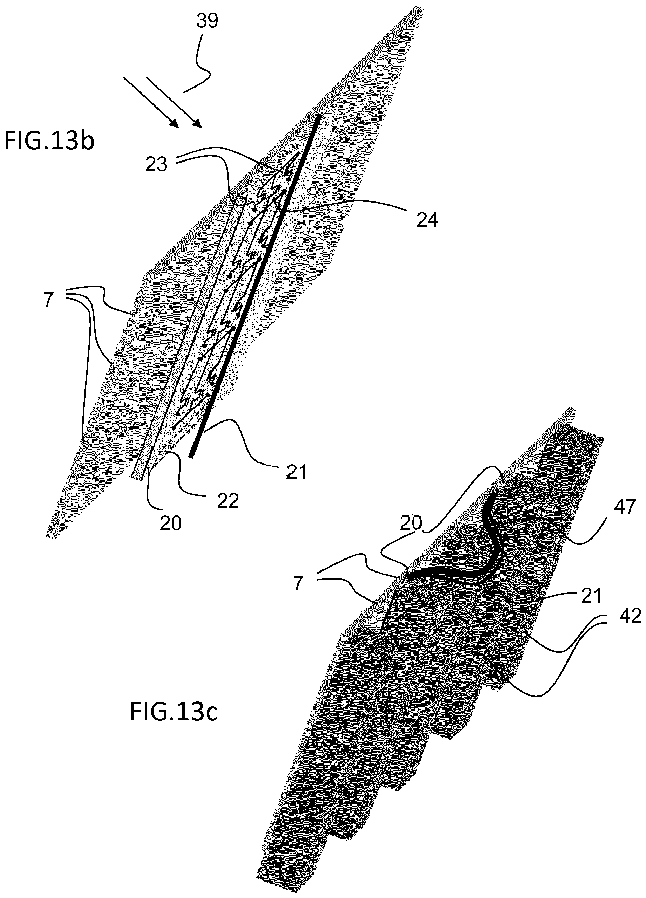

Les figures 13a et 13b illustrent une variante de réalisation dans laquelle les fonctions électroniques de chaque carte électronique du mode de réalisation décrit ci-dessus sont regroupées sur une seule carte électronique 20, à laquelle les cellules sont reliées électriquement par des connexions 38. La figure 13a représente une vue de dessous, permettant de voir la répartition des modules 12 sur la carte 20. Dans le cas d'une intégration dans une toiture supportée par une charpente, la carte électronique 20 peut être disposée et fixée sur un liteau ou un chevron de la charpente sur lesquels viennent reposer les panneaux photovoltaïques qui servent en même temps de couverture à la toiture. La carte 20 peut être découpée en plusieurs morceaux et se prolonger sur plusieurs liteaux ou chevron 42 de la toiture, comme cela apparaît plus particulièrement sur la figure 13c, et ces morceaux peuvent être reliés électriquement par des câbles comme le bus de communication 21 et un câble 47 de puissance pour la mise en série. Pour assurer l'étanchéité du toit, les panneaux photovoltaïques peuvent reposer sur un support tel qu'il existe un chevauchement étanche entre les panneaux. Lors de la construction de la structure support de l'installation, comme une charpente, il peut être prévu sur la carte 20 un nombre de branchement de cellules photovoltaïques supérieur au nombre de cellules photovoltaïques installées au départ pour pouvoir augmenter dans le futur le nombre de cellules photovoltaïques de l'installation. Les cellules photovoltaïques non installées au départ seront simplement shuntées par l'interrupteur de module.

La figure 13b représente une vue en perspective arrière, permettant de distinguer différentes cellules photovoltaïques 7, ainsi que certains composants électroniques comme des transistors de cellule 23, représentés sommairement de manière non exhaustive pour simplifier la représentation de la carte électronique 20 disposée sous la surface des cellules photovoltaïques, à l'opposé de leur face supérieure recevant un flux de lumière 39. La carte électronique 20 comprend tous les composants explicités précédemment. Le bus de communication 21 s'étend sur toute la longueur de la carte jusqu'au calculateur central 22, positionné vers une extrémité libre de la carte électronique 20. Ce bus de communication 21 peut être isolé physiquement de l'électronique des modules en établissant une bande de circuit imprimé dédiée au bus de communication, séparée des composants électronique des différents modules, en séparant par exemple leurs masses, et/ou en gardant une distance de sécurité entre les deux parties. Seuls les éléments de communication entre ces deux parties, comme des transformateurs ou des opto-coupleurs, resteront à cheval sur ces deux parties pour assurer la communication tout en garantissant l'isolation galvanique.

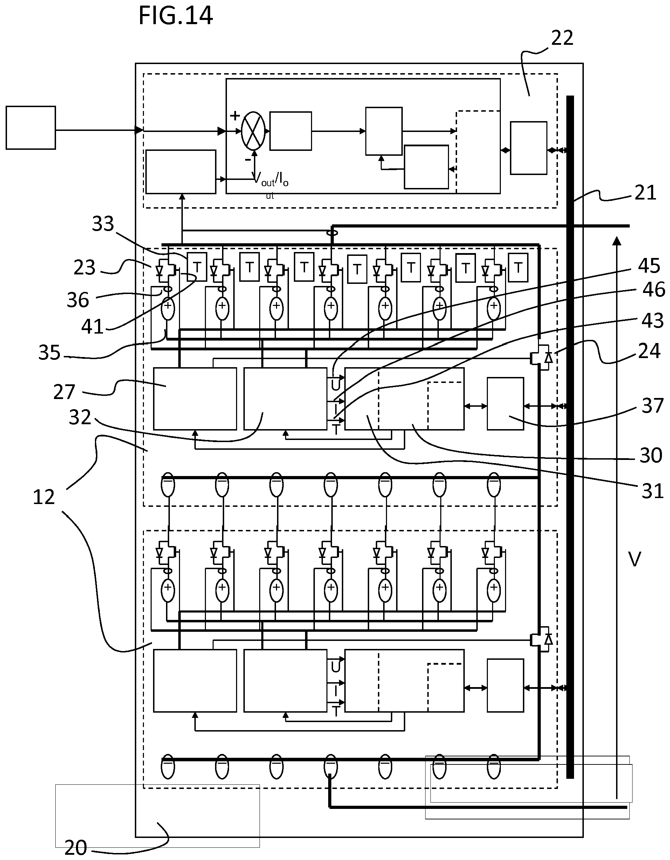

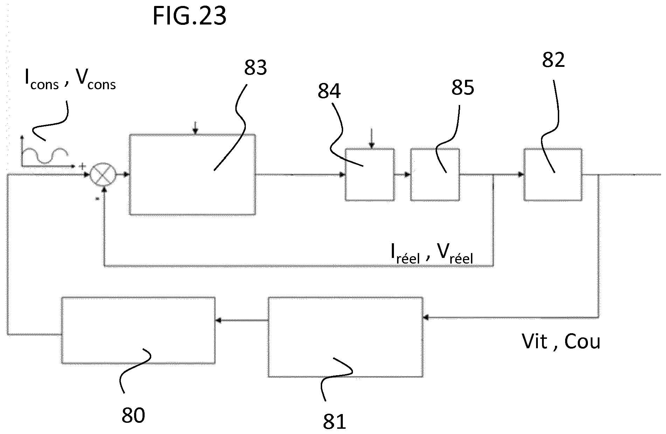

La figure 14 représente de manière plus détaillée l'architecture de la carte électronique 20 associée à deux modules 12, comprenant sept cellules chacun dans cet exemple. Pour chaque cellule, un transistor de cellule 23 est prévu, en série avec la cellule, et un transistor de module 24, en parallèle, est prévu pour chaque module 12, comme explicité précédemment. D'autre part, un capteur de température 33, un capteur de tension 35 et un capteur de courant 36 sont prévus pour chaque cellule. Les mesures effectuées par ces trois capteurs 33, 35, 36 sont transmises à un circuit de traitement 30 local via un multiplexeur 32 par respectivement trois voies de communications 43, 45, 46. En remarque, les connexions ont été simplifiées sur les figures pour une raison de clarté, mais il y a en réalité une nappe de fils pour obtenir une connexion vers chaque capteur et vers chaque tension. De plus, la tension du module est aussi avantageusement mesurée pour en déduire les tensions présentes au niveau des transistors. Le circuit de traitement 30 reçoit ainsi ces données au niveau d'une entrée de communication 31 effectuant une numérisation, de type « ADC input » ; ou en variante, ces signaux arrivent déjà numérisés, cette numérisation étant réalisée au niveau du multiplexeur 32. Selon une réalisation possible, le circuit de traitement 30 peut être un microcontrôleur disposant d'un nombre d'entrée/sortie suffisant pour interroger l'ensemble des capteurs. Tous les transistors 23, 24 sont pilotés par un circuit de commande 27 de puissance qui leur transmet des signaux de commande 41, sous les ordres du circuit de traitement 30. Enfin, le circuit de traitement 30 est relié au calculateur central 22 par le bus de communication 21 et par l'intermédiaire d'une interface 37 formant une isolation galvanique. Tous ces composants associés à un seul module sont alimentés par la tension d'au moins une des cellules du module 12. Comme cela a été décrit, chaque module 12 du dispositif de génération d'énergie photovoltaïque dispose d'une intelligence propre grâce à son circuit de traitement 30 et participe ainsi au procédé de gestion du dispositif de génération d'énergie photovoltaïque, en coopération avec le calculateur central 22 qui pilote l'ensemble des modules. Ce dernier sera décrit plus en détail ultérieurement, en référence avec la figure 23.

D'autre part, selon une réalisation avantageuse, tous les composants de puissance associés à un module sont alimentés directement par la tension disponible au niveau du module correspondant, notamment le circuit de commande 27 des transistors, décrits précédemment. Un tel circuit de commande, alimenté par son module associé, est alors isolé électriquement des autres modules et/ou des potentiels électriques extérieurs au module. Une telle réalisation présente l'avantage de supprimer le risque de piloter un certain transistor avec un potentiel très différent de celui de l'étage, qui pourrait conduire à sa destruction ou à sa mise en court-circuit. De plus, cette solution apporte l'avantage supplémentaire de permettre la réduction des connexions entre les composants du circuit de commande et la source d'alimentation, puisqu'il est possible de les regrouper à une courte distance les uns des autres et de la source de tension, notamment en positionnant les transistors au plus près des cellules à connecter. Enfin, l'utilisation de connexions très courtes réduit aussi fortement tout risque de court-circuit, par exemple entre deux modules.

De même, un dispositif de communication alimenté par l'étage peut permettre de communiquer avec les autres étages et/ou avec un système central via un lien hautement isolé pour éviter les risques électriques (court circuits entre étages, détérioration du système central placé à un potentiel très différents de quelques kV par rapport à celui d'un étage du dispositif de génération d'énergie photovoltaïque, risque électrique pour le réparateur). Contrairement à un transformateur d'impulsion qui permettrait de commander les transistors de puissance au travers d'une isolation galvanique, l'utilisation d'un dispositif de communication alimenté par le module permet d'interpréter les signaux reçus (décodage de l'adresse, de l'information), de coder les signaux à transmettre et de mutualiser les lignes de communication alors que le transformateur d'impulsion permet juste de mettre « on » ou « off » le transistor de puissance avec une ligne de connexion individualisée à chaque transistor. Le dispositif de communication peut être par exemple une interface I2C présente dans de nombreux microcontrôleurs, que l'on relit à un bus de communication mutualisé à chaque étage via une isolation galvanique.

Dans l'exemple décrit ci-dessus, le procédé de gestion du dispositif de génération d'énergie photovoltaïque est mis en œuvre par la coopération d'un circuit de traitement 30 local, disposé au niveau de chaque module, et d'un calculateur central 22. L'ensemble des fonctions de gestion du dispositif de génération d'énergie photovoltaïque pourra donc être mis en œuvre par cette combinaison. Plusieurs modes de réalisation peuvent ainsi être imaginés, en reportant certaines fonctions de gestion du niveau local au niveau central ou inversement.

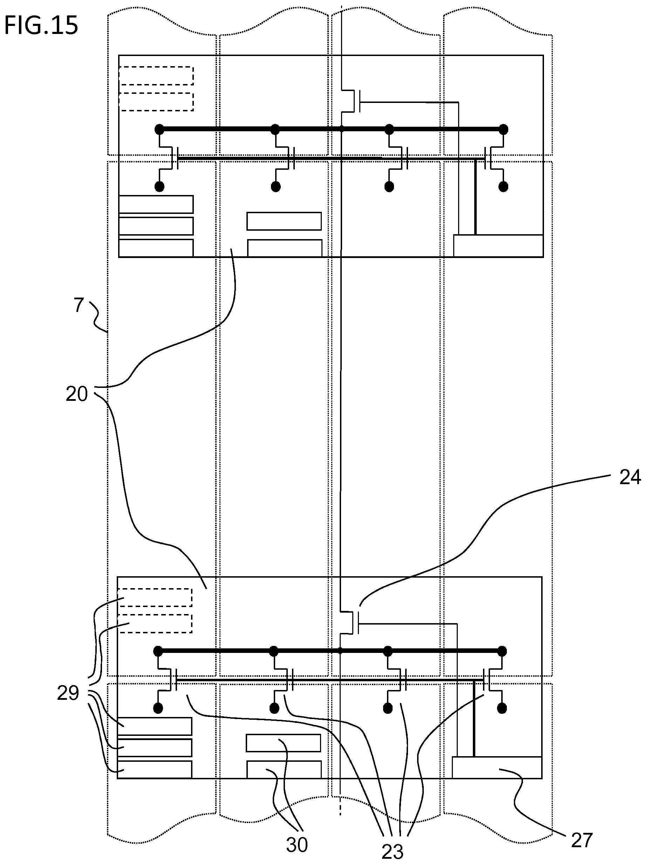

Les figures 15 à 17 illustrent une seconde variante de réalisation dans laquelle le procédé de gestion du dispositif de génération d'énergie photovoltaïque est mis en œuvre localement uniquement, au niveau de chaque module, voire cellule. Cela présente l'avantage de permettre un pilotage plus réactif des différents interrupteurs, d'éviter l'obligation de prévoir une isolation galvanique entre les cartes électroniques 20 et un calculateur central 22 et un codage complexe des informations à transférer. La figure 15 illustre une telle variante, dans laquelle chaque carte électronique 20 comprend des capteurs de mesure 29, pour mesurer la température, la tension, et le courant, un ou plusieurs circuits de traitement 30 pour estimer l'état de chaque cellule par exemple, déterminer la pertinence d'utiliser ou non chaque cellule, etc. La carte électronique comprend de plus un circuit de commande 27 permettant l'actionnement des différents transistors 23, 24, formant les interrupteurs de cellule et module.

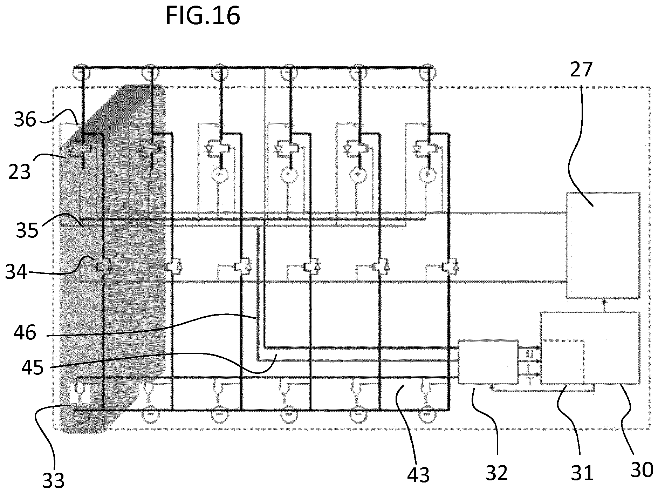

La figure 16 représente de manière plus détaillée l'architecture de la carte électronique associée à un module 12, comprenant six cellules dans cet exemple. Pour chaque cellule, un transistor de cellule 23 est prévu, disposé en série avec la cellule, comme cela a été explicité précédemment. D'autre part, un capteur de température 33, un capteur de tension 35 et un capteur de courant 36 sont de plus agencés au niveau de chaque cellule. Les mesures effectuées par ces trois capteurs 33, 35, 36 sont transmises à un circuit de traitement 30 via un multiplexeur 32 par respectivement trois voies de communications 43, 45, 46, ou en variante par une même voie mutualisée. Le circuit de traitement 30 reçoit ainsi ces données au niveau d'une entrée de communication 31 effectuant une numérisation, de type « ADC input ». Selon une réalisation possible, le circuit de traitement 30 peut être un microcontrôleur disposant d'un nombre d'entrée/sortie suffisant pour interroger l'ensemble des capteurs. En remarque, l'unique transistor de module 24 est remplacé dans cette réalisation par plusieurs interrupteurs parallèles formés par des transistors 34 : dans cette variante, un transistor parallèle 34 est disposé en parallèle de chaque cellule de façon à réduire au maximum la longueur des chemins de puissance lorsque ces transistors 34 sont activés. Ainsi, il apparaît que dans tous les modes de réalisation et leurs variantes, l'interrupteur de module 14 peut être remplacé par des interrupteurs parallèles 44 sur chaque cellule du module, voire par tout nombre d'interrupteurs parallèles, comme un interrupteur parallèle pour une ou deux cellules. Tous ces transistors 23, 34 sont pilotés par un circuit de commande 27, sous les ordres du circuit de traitement 30.

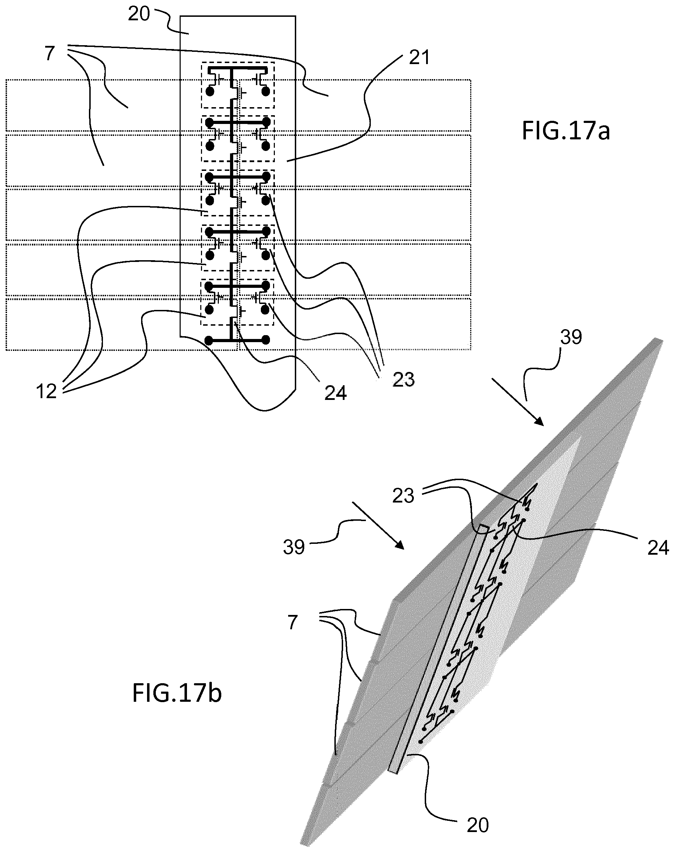

Les figures 17a et 17b illustrent une troisième variante de réalisation, qui s'apparente à celle des figures 13a et 13b, dans laquelle les fonctions électroniques sont regroupées sur une seule carte électronique 20, et dont seul un traitement local au niveau de chaque module est effectué, sans liaison avec un calculateur central. La figure 17a représente une vue de dessus, permettant de voir la répartition des modules 12 sur la carte 20, alors que la figure 17b représente une vue en perspective arrière, permettant de distinguer différentes cellules 11, ainsi que certains composants électroniques comme des transistors de cellule 23, représentés sommairement de manière non exhaustive pour simplifier la représentation de la carte électronique 20. Toutefois, cette dernière comprend tous les composants explicités en référence avec la figure 16.

En remarque, il est finalement possible de réaliser des modes de réalisation avec différents nombres de cartes électroniques 20, une carte pouvant contenir les circuits électroniques de l'invention pour un, deux, ou tout nombre de modules. De plus, il est aussi possible de prévoir d'autres modes de réalisation dans lesquels une partie seulement des composants électroniques présentés précédemment sont présents, sur une carte électronique ou pas, ou dans lesquels certains composants sont partagés entre cellules et/ou modules. Par exemple, un circuit de commande d'interrupteurs et/ou un circuit de traitement peut être partagé par plusieurs modules voisins, par exemple pour deux ou trois modules voisins, de sorte de conserver une alimentation de tension acceptable.

Dans tous les cas, les cartes électroniques 20 sont avantageusement disposées de sorte de disposer leurs bornes de connexion avec les cellules 11 au plus proche des bornes des cellules de façon à réduire au maximum la longueur des connexions et donc les pertes associées. De même, sur le circuit imprimé de la carte électronique, les chemins de puissance sont les plus courts possibles avec une section de conducteur la plus élevée possible.

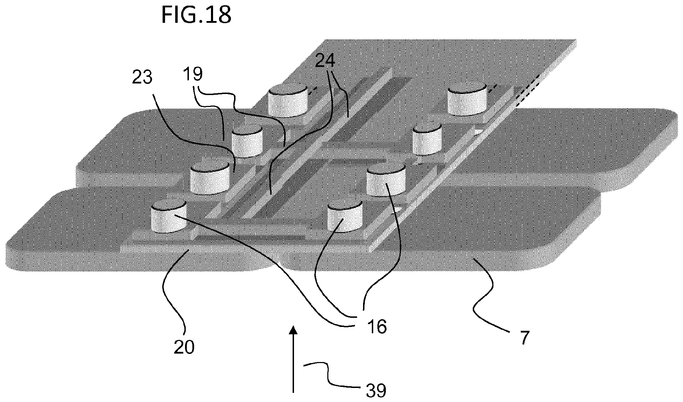

Pour augmenter la section de conducteur, il est possible de renforcer les pistes du circuit imprimé en soudant par-dessus une baguette ou fil conducteur. La figure 18 illustre une telle solution, sur laquelle une carte électronique 20 de type circuit imprimé est superposé sur un module de plusieurs cellules 11. Sur cette figure, seulement deux modules de deux cellules sont représentés, pour une raison de clarté de la figure, mais le dispositif de génération d'énergie photovoltaïque comprend plus de deux modules ayant chacun plus de deux cellules. En remarque, un tel renforcement peut remplir la seconde fonction d'évacuation de la chaleur générée, notamment celle dissipée par les transistors de puissance ; pour cela, sa forme peut présenter une surface favorisant cette fonction, à la manière d'un convecteur ou radiateur. Des connecteurs 16 sont aménagés sur cette plaque, afin de relier électriquement les cellules à l'électronique de la carte (par exemple des cellules dont les bornes positives et négatives traversent la carte et serrent la carte et les pistes de puissance renforcées via un écrou qui se visse sur les bornes de la cellule. Une rondelle relativement élastique peut être rajoutée entre la carte et l'écrou pour compenser des effets de dilatation thermique et assurer un bon contact électrique dans la durée. En variante, une simple soudure peut assurer le contact électrique entre les bornes de la cellule et les pistes de puissance de la carte PCB). Comme cela apparaît sur la figure, des renforts conducteurs électriques 19 sont ajoutés aux pistes du circuit imprimé. Ces renforts représentent aussi un potentiel radiateur thermique soudé et/ou collé sur les pistes. En complément, des trous, non représentés, peuvent être réalisés au travers la carte électronique 20 pour faciliter la circulation d'air et le refroidissement des cellules 11 et des composants électroniques.

Finalement, la structure ainsi décrite d'un dispositif de génération d'énergie photovoltaïque est de type modulaire, et permet une implémentation physique sous la forme de différents boîtiers indépendants et amovibles, qui correspondent chacun à un ensemble de cellules et comprennent donc chacun plusieurs cellules photovoltaïques élémentaires, qui peuvent être connectés les uns avec les autres, par l'intermédiaire d'un bus de communication et d'un bus de puissance. Chaque boîtier peut comprendre une sous-partie quelconque du dispositif global, qui peut aller d'un module à plusieurs modules.

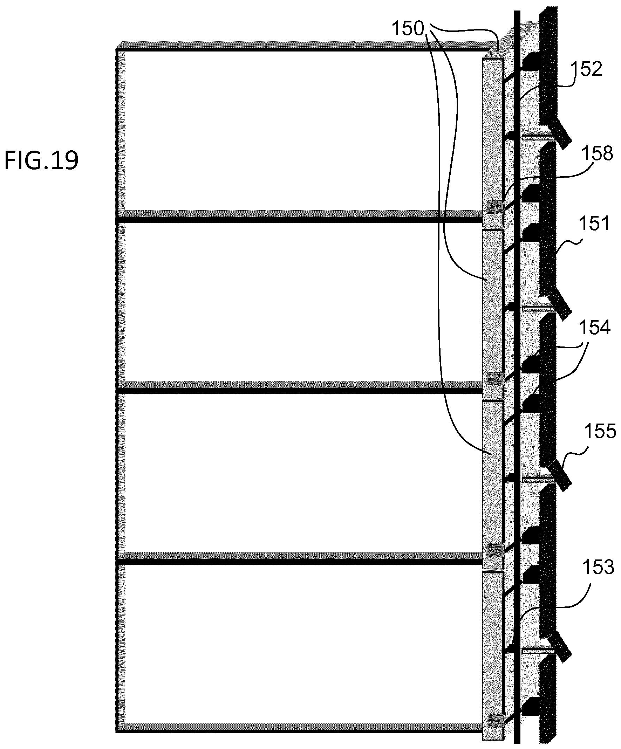

La figure 19 illustre schématiquement une telle approche dans laquelle les différents boîtiers 150, comprenant chacun des panneaux photovoltaïques de plusieurs cellules photovoltaïques, sont reliés par une liaison amovible à un bus de communication 152 par l'intermédiaire d'un connecteur 153, de manière hautement isolée galvaniquement, et à un bus de puissance 151 par un connecteur de puissance 154 qui leur permet une liaison série avec les boîtiers adjacents. Un dispositif de verrouillage/déverrouillage 158 est associé à un système d'interrupteur permettant de couper automatiquement les connexions au bus de communication et au bus de puissance lorsqu'il est actionné pour retirer un boîtier 150. La connexion est remplacée par un court-circuit, via par exemple l'interrupteur mécanique ou électrique 155, lorsque le boîtier est retiré pour ne pas couper la connexion entre les boîtiers restants. Pour cela, un début de verrouillage ou déverrouillage par un actionnement d'un levier ou poignée du dispositif de verrouillage/déverrouillage est détecté et une information est transmise au système de gestion globale du dispositif, comme un calculateur central. En cas de déverrouillage d'un boîtier, le calculateur l'écarte aussitôt du fonctionnement global du dispositif et lui impose une tension nulle à ses bornes, ce qui assure la sécurité des manipulations futures et permet son stockage sécurisé. Les connexions avec les bus de puissance et de communication sont ensuite automatiquement coupées, par un interrupteur, de manière mécanique ou électrique. Les opérations précédentes sont effectuées de manière réversible en cas d'introduction d'un boîtier dans le bâti.

Cette construction présente l'avantage d'une gestion physique simplifiée du dispositif de génération d'énergie photovoltaïque. Chaque sous-ensemble compris dans chaque boîtier est géré de manière indépendante ou semi-indépendante grâce à l'architecture décrite dans les modes de réalisation présentés précédemment. Il est ainsi possible de connaître précisément l'état de chaque boîtier, et de pouvoir intervenir sur un boîtier donné en cas de défaillance, pour changer un module voire une cellule, ou de pouvoir l'échanger si nécessaire, sans pénaliser l'ensemble du dispositif.

Cet assemblage physique peut ainsi être disposé sur la charpente d'un bâtiment, les différents boîtiers étant répartis sur la surface du toit. Cette architecture permet d'ajouter ou de retirer facilement des sous-ensembles, soit des panneaux photovoltaïques, au dispositif global, dont la liaison et la gestion est ensuite automatiquement réalisée de manière optimale. Elle permet donc d'apporter une évolutivité conviviale et aisée à un dispositif de génération d'énergie photovoltaïque.

L'invention porte aussi sur un procédé de gestion d'un dispositif de génération d'énergie photovoltaïque tel que décrit précédemment. Ce procédé consiste à optimiser la puissance produite par le dispositif tout en respectant une première contrainte imposée par l'ensoleillement disponible et une seconde contrainte liée à la demande spécifique de la charge connectée sur le dispositif. Naturellement, la première contrainte s'impose en priorité sur la seconde en cas d'incompatibilité, puisque le dispositif de génération d'énergie photovoltaïque est automatiquement lié dans sa capacité de production à l'ensoleillement, ce qui fait que dans le pire des cas, il ne pourra pas satisfaire un besoin allant au-delà de sa capacité maximale.

Le procédé de génération d'énergie photovoltaïque comprend une étape consistant à déterminer la position des interrupteurs de cellule en fonction de l'état de fonctionnement des cellules photovoltaïques concernées, plus précisément en fonction de leur état par rapport à leur régime optimal.

Pour cela, lorsque la tension aux bornes d'une cellule dépasse la tension optimale, présentée précédemment en référence avec la figure 6, augmentée d'un pourcentage prédéfini, la cellule est alors utilisée de manière prioritaire, c'est-à-dire que son interrupteur de cellule est fermé pour permettre son utilisation pour produire une tension et un courant vers la sortie du dispositif. Cette utilisation de la cellule, qui induit une fourniture d'un courant par la cellule photovoltaïque et par son élément de stockage associé, tend à faire diminuer la tension aux bornes de la cellule photovoltaïque, ce qui évite que cette tension ne s'élève trop, ne s'éloigne trop de la tension de fonctionnement idéale. Au contraire, lorsque cette tension aux bornes d'une cellule descend sous cette tension optimale diminuée d'un pourcentage prédéfini, la cellule n'est alors plus utilisée, c'est-à-dire que l'interrupteur de cellule est ouvert, de sorte qu'elle ne participe plus à la production de tension et de courant en sortie du dispositif. Pendant cette déconnexion d'une cellule du reste du dispositif, sa production d'énergie est exploité pour le chargement de l'élément de stockage qui lui est associé et la tension à ses bornes remonte.

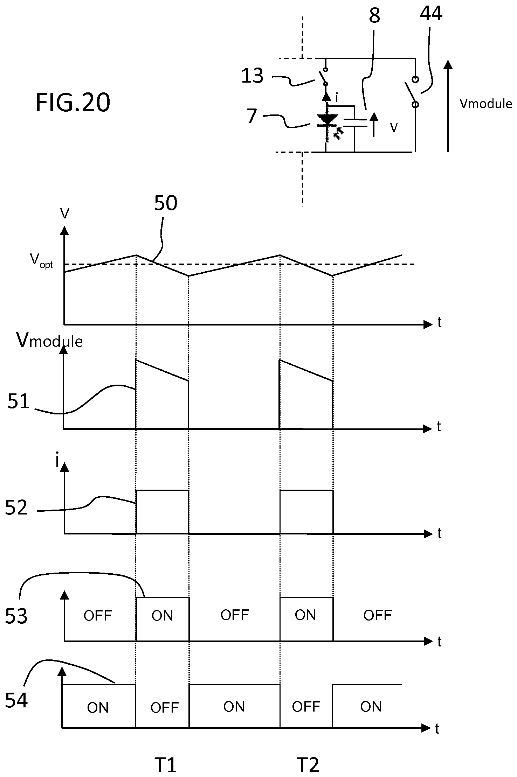

Ce mécanisme, illustré par la figure 20, comprend ainsi la mise en place de cycles d'ouverture et de fermeture de l'interrupteur de cellule 13, comme représenté par la courbe 53, en fonction de l'état de la cellule associée, c'est-à-dire des conditions de fonctionnement de sa cellule photovoltaïque 7 par rapport aux conditions optimales, de sorte que ces conditions de fonctionnement restent toujours dans une plage proche des conditions idéales, de préférence dans une plage de plus ou mois 5% des conditions optimales, avantageusement de 2,5 % de ces conditions. Cette optimisation peut se faire sur chaque cellule photovoltaïque élémentaire dans le cas où chacune est individuellement associée à un interrupteur de cellule, c'est-à-dire dans le cas où une cellule photovoltaïque 7 ne comprend qu'une seule cellule photovoltaïque élémentaire. En variante, cette optimisation peut se faire sur plusieurs cellules photovoltaïques élémentaires. La courbe 54 représente l'état de l'interrupteur parallèle 44 associé à la cellule considérée, qui est ouvert quand l'interrupteur de cellule 13 est fermé et inversement. La courbe 52 illustre le courant i aux bornes de la cellule photovoltaïque 7, qui forme des échelons semblables à ceux de la courbe 53 : l'intensité prend une valeur non nulle lors de la fermeture de l'interrupteur de cellule, illustré par la mention « ON » de la courbe 53, pour les périodes T1, T2 représentées. Durant ces périodes, la cellule photovoltaïque 7 est utilisée et sa tension V descend comme cela est visible sur la courbe 50, avant de remonter lorsque l'interrupteur de cellule est ouvert. La tension V aux bornes de la cellule photovoltaïque 7 oscille bien autour de la tension optimale Vₒₚₜ. La tension Vmodule aux bornes du module, représentée par la courbe 51, prend une valeur nulle lorsque l'interrupteur de cellule 13 est ouvert, puisque la cellule est shuntée par l'interrupteur parallèle 44 qui est fermé, puis une valeur égale à celle de la cellule lors des périodes T1, T2 d'utilisation de cette dernière.

En remarque, le fait de déconnecter du reste du dispositif une cellule de tension inférieure, que ce soit parce qu'elle se trouve dans une zone ombragée ou pour toute autre raison, permet de lui éviter aussi une influence néfaste sur l'ensemble des autres cellules, qui peuvent être plus facilement maintenues dans leur état de fonctionnement optimal. En effet, une cellule ombragée risquerait de se comporter comme une charge vis-à-vis du reste du dispositif de génération d'énergie, et donc de dissiper de l'énergie produite en risquant de surchauffer et d'exiger une baisse de courant global fourni pour réduire ce risque.

Ce procédé de gestion de génération d'énergie photovoltaïque comprend donc une étape de détermination des conditions de fonctionnement d'une cellule photovoltaïque.

Pour cela, le procédé comprend une étape de mesure d'au moins une grandeur au niveau d'une cellule du dispositif de génération d'énergie photovoltaïque, représentative de l'état de la cellule, comme la tension et/ou l'intensité, et éventuellement la température. En remarque, cette ou ces mesures sont avantageusement effectuées localement, par un ou plusieurs capteurs, comme mentionnés précédemment.

Selon une première réalisation, seule la tension aux bornes de la cellule est mesurée. Le courant peut être déduit en analysant la variation de tension aux bornes de l'élément de stockage dans une phase de charge de cet élément, quand l'interrupteur de cellule 13 est ouvert, puisque ce courant est lié à la tension. Pour une capacité C, le courant est lié à cette tension par la formule bien connue de i = C dV/dt.

Ensuite, cette (ou ces) mesure est exploitée par un calculateur d'un circuit de traitement, qui est avantageusement local, c'est-à-dire positionné par exemple sur une carte électronique à proximité de la cellule, comme cela a été décrit précédemment. En variante, la grandeur mesurée est transmise à un calculateur central.

Ce calculateur met en œuvre un procédé de comparaison de l'état réel de la cellule avec un état de fonctionnement optimal, sur la base de cette mesure. Pour cela, une première réalisation est basée sur la mémorisation préalable des valeurs optimales dans une mémoire électronique associée au calculateur, comme la mémorisation de la tension optimale de fonctionnement en fonction de la température par exemple. Une seconde réalisation est basée sur la recherche périodique, éventuellement en temps réel, des conditions optimales de fonctionnement. Pour cela, une solution peut consister à laisser légèrement évoluer les conditions de fonctionnement d'une cellule pour vérifier si cela s'accompagne d'une augmentation ou pas de la puissance fournie par la cellule. Si la puissance augmente, alors l'évolution est poursuivie dans le même sens. En revanche, si elle diminue, l'évolution inverse est mise en place. Ce principe finit par aboutir par itérations successives au point de fonctionnement optimal puis de permettre de poursuivre le procédé de gestion décrit précédemment, pour rester autour de ce point.

Finalement, le procédé de gestion d'un dispositif de génération d'énergie comprend donc la mise en œuvre des étapes suivantes :
- transmission de la grandeur mesurée à au moins un calculateur ;
- détermination de la position d'un interrupteur de cellule et/ou de module en prenant en compte la grandeur mesurée ;
- transmission d'une commande d'ouverture ou fermeture d'un interrupteur de cellule et/ou de module en fonction de la détermination précédente.

Le procédé de gestion de dispositif de génération d'énergie photovoltaïque permet ainsi de déterminer à chaque instant la position de plusieurs interrupteurs de cellules et/ou modules, de façon à maintenir chaque cellule et module dans des conditions optimales.

Le procédé peut de plus comprendre une étape intermédiaire consistant à diagnostiquer une défaillance et/ou un état à risque d'une cellule, en reconnaissant les cellules défectueuses, par exemple en surchauffe suite à une situation de court-circuit, entrée d'humidité, d'arc électrique, de flamme, de défaut d'isolement, etc., à partir de la grandeur mesurée au niveau d'une cellule, afin de déconnecter ou écarter du fonctionnement global du dispositif de génération d'énergie photovoltaïque les cellules concernées, en ouvrant par exemple leur interrupteur de cellule, ou en fermant l'interrupteur de module concerné.

Ainsi, en revenant à l'exemple illustré sur la figure 8, il apparaît que les cellules 1, 2, 5, et 6 ont été écartées. Dans un dispositif de génération d'énergie photovoltaïque comprenant un nombre important de cellules et de modules, il est facile d'en écarter un nombre significatif, par exemple 10 % du nombre total de cellules, sans pénaliser l'utilisation du dispositif de génération d'énergie photovoltaïque car le courant demandé est généralement inférieur au courant maximal disponible, utilisé uniquement dans une situation de crête de consommation. D'ailleurs, en cas de pic de consommation, il sera toujours possible de faire appel momentanément aux cellules écartées pour répondre au besoin plus important.

En remarque, en cas de pic de courant, les éléments de stockage associés aux cellules délivrent aussi un courant complémentaire à celui produit par les cellules photovoltaïques, participant ainsi à l'optimisation globale de la production d'énergie puisque l'énergie produite par les cellules, mêmes lors de leur déconnexion, est finalement exploitée. Les éléments de stockage remplissent ainsi un rôle de tampon, permettant la restitution avec un décalage de toute l'énergie produite dans des conditions optimales. Ils évitent aussi les variations trop brutales de tension aux bornes des cellules lors des opérations de connexion et déconnexion par actionnement de leur interrupteur de cellule, permettent une évolution continue de leur tension. Pour cela, ils sont dimensionnés pour maintenir une faible variation de la tension aux bornes de la cellule devant sa composant continue ΔV/V, par exemple inférieure à 5%, ce qui permet à une cellule de rester proche de ses conditions optimales, sa variation de tension restant négligeable.

Le procédé de gestion de dispositif de génération d'énergie photovoltaïque comprend une étape de diagnostic d'une cellule incluant une étape d'estimation de l'état d'une cellule, qui peut comprendre à titre d'exemple non limitatif une ou plusieurs mesures de courant, de tension, de température, de spectrométrie d'impédance ou autres au niveau d'au moins une cellule, tout ou partie des cellules du dispositif de génération d'énergie photovoltaïque. Pour cela, la grandeur mesurée peut être comparée à des seuils prédéfinis. Le pilotage de chaque transistor de cellule dépend alors de cet état estimé de la cellule, et permet par exemple de déconnecter une cellule si elle fait apparaitre un courant ou une température anormale ou si elle fournie un courant inverse aux autres cellules.

Cette étape de diagnostic peut comprendre l'identification des caractéristiques d'au moins une cellule photovoltaïque et/ou de l'ensoleillement en ouvrant sur une période prédéfinie suffisamment longue au moins un interrupteur de cellule pour mesurer la tension à vide de la cellule photovoltaïque ou en fermant au moins un interrupteur de cellule et un interrupteur parallèle ou de module de sorte à disposer la cellule photovoltaïque en court-circuit pour mesurer le courant en court-circuit de ladite cellule photovoltaïque.

Le procédé de gestion de la génération d'énergie photovoltaïque a été décrit pour optimiser le fonctionnement d'une cellule particulière du dispositif. Toutefois, les différentes cellules du dispositif sont interdépendantes et il est utile de les considérer aussi de manière globale.

Notamment, il est avantageux d'éviter les déséquilibres au sein d'un même module sans quoi il ne sera pas aisé de maintenir toutes les cellules du module dans leur condition de fonctionnement optimal. Un tel déséquilibre peut par exemple survenir si une partie des cellules est ombragée par exemple. Dans un tel cas, les éléments de stockage associés à ces différentes cellules sont chargés à des vitesses différentes et les tensions aux bornes de ces cellules peuvent différer, lorsque les interrupteurs de cellule sont ouverts. Pour compenser ces déséquilibres, le procédé de gestion peut appliquer le principe décrit précédemment, en relation avec la figure 20, mais de manière décalée dans le temps pour chaque cellule.

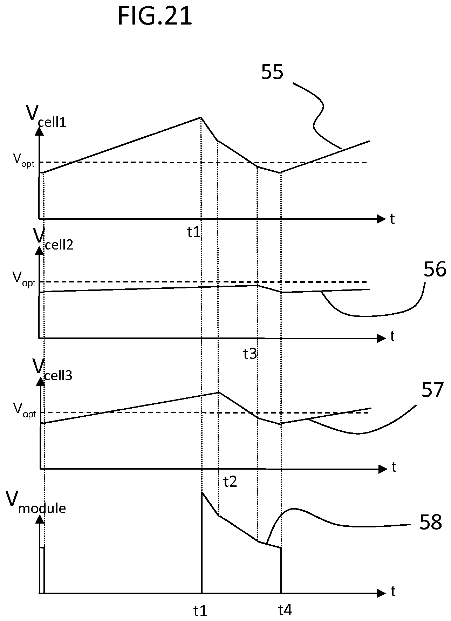

La figure 21 illustre plus précisément une réalisation possible pour compenser le déséquilibre de trois cellules d'un même module. A un instant t1, la tension aux bornes de la première cellule, représentée par la courbe 55, atteint une valeur seuil au-delà de sa tension de fonctionnement optimale, et son interrupteur de cellule passe de l'état ouvert à fermé, pour utiliser la cellule. La tension du module, représentée par la courbe 58, passe alors d'une valeur nulle à la valeur de la tension de cette première cellule. Les deux autres cellules qui sont dans des positions ombragées, et dont la tension est plus faible, restent non utilisées et leur tension continue d'augmenter, alors que celle de la première cellule diminue. La tension du module, représentée par la courbe 58, diminue alors, comme celle de la première cellule. A l'instant t2, la tension du module devient proche de celle aux bornes de la troisième cellule, représentée par la courbe 57, et l'interrupteur de cellule de cette dernière passe de l'état ouvert à fermé. De même, à l'instant t3, la tension du module devient proche de celle aux bornes de la seconde cellule, représentée par la courbe 56, et son interrupteur de cellule passe de l'état ouvert à fermé. A chaque ajout d'une cellule supplémentaire, aux instants t2 et t3, la pente de diminution de la tension du module est modifiée, cette diminution ralentit du fait que de plus en plus de cellules contribuent à la fourniture du courant de sortie. Cette connexion progressive des différentes cellules évite de plus les risques de courts-circuits entre les cellules, par rapport à une solution qui consisterait à connecter en même temps les cellules du module de tension différente. A un instant t4, la tension du module descend sous un seuil en-dessous de la tension optimale des trois cellules et leurs interrupteurs sont alors ouverts simultanément. Le calculateur de gestion du dispositif de génération photovoltaïque tient alors compte de la tension réelle de chaque cellule, de leur tension optimale, et aussi de la tension du module.

Dans cette approche globale, le calculateur peut calculer une même valeur de tension optimale globale par module, en tenant compte de la température et éventuellement de l'ensoleillement global. En variante, il est possible de calculer plus précisément une valeur de tension optimale propre à chaque module, en tenant compte de la température et éventuellement de l'ensoleillement au niveau de chaque module. Dans ce cas, chaque module est utilisé de manière différente, est mis à contribution en fonction de sa propre situation, comme son ensoleillement, l'état de ses cellules, éventuellement leur défaillance, voire leur technologie si plusieurs générations de modules sont utilisées (par exemple si des modules défaillants ont été remplacés par des modules plus récents, ou si une installation existante a été agrandie par l'ajout de modules plus récents), etc.

D'autre part, le procédé de gestion de dispositif de génération d'énergie photovoltaïque peut mettre en œuvre une modification cyclique de l'utilisation des cellules, de sorte que tout ou partie des cellules du dispositif de génération d'énergie photovoltaïque passent d'un état de fonctionnement normal à un état déconnecté et réciproquement, selon un rapport cyclique déterminé qui peut être fixe ou variable. Les cycles de fonctionnement des différentes cellules peuvent être décalés dans le temps pour obtenir à chaque instant un nombre sensiblement équivalent de cellules actives par exemple, en garantissant à chaque instant un nombre suffisant de cellules actives pour satisfaire le courant demandé.

La solution retenue revient en fait à déterminer le courant de sortie du dispositif de génération d'énergie photovoltaïque de sorte que les cellules fonctionnent au maximum dans leur point de fonctionnement optimal. Ce courant est en fait déterminé par l'ensoleillement reçu par les cellules photovoltaïques. Il s'impose à la charge reliée au dispositif. Toutefois, de nombreux moyens sont mis en œuvre pour s'approcher aussi au mieux du besoin en courant et tension de cette charge, tout en restant dans les conditions optimales de fonctionnement des cellules photovoltaïques, comme cela sera détaillé par la suite.

Ainsi, le procédé de gestion de dispositif de génération d'énergie photovoltaïque met en œuvre les étapes suivantes :
- équilibrage des modules et/ou cellules entre eux, en utilisant en priorité les modules et/ou cellules dont la tension est la plus forte lorsque le dispositif de génération d'énergie photovoltaïque est connecté à une charge ;
- équilibrage des modules et/ou cellules en modifiant le taux moyen d'utilisation des modules et/ou cellules, mais sans utiliser les mêmes modules et/ou cellules en permanence, de sorte que la tension des modules et/ou cellules s'équilibre.

La mise en œuvre du procédé de gestion du dispositif de génération d'énergie photovoltaïque décrit ci-dessus peut être mise en œuvre par un calculateur local et/ou distant, comme cela a été explicité auparavant. Ce calculateur peut comprendre un ou plusieurs microprocesseurs.

En remarque, la mise en œuvre du procédé localement, sans recours à un calculateur central, présente les avantages suivants :
- comme la ou les mesures et leur analyse sont faites localement et indépendamment des autres modules, la réaction peut être très rapide. Elle est plus rapide que la réalisation avec un calculateur central qui nécessiterait une communication par une liaison avec isolation galvanique, avec d'abord un codage série qui induirait un premier délai, puis le transfert par un bus dont le débit réduit impliquerait un second délai ;
- dans le cas où un module comprend son propre calculateur, un traitement poussé des mesures peut être fait, pour atteindre ainsi un diagnostic précis de chaque cellule.

Le procédé de gestion de dispositif de génération d'énergie photovoltaïque peut comprendre les étapes spécifiques suivantes dans le cas où la gestion d'une cellule est entièrement locale :
- dés que le taux de défaillance des cellules d'un même étage atteint un seuil on ordonne l'ouverture de toutes les cellules et l'activation d'un shunt, potentiellement placé dans chacune des cellules, pour mettre hors service l'étage ;
- lorsqu'une cellule est défaillante, par exemple lorsqu'il existe une fuite de courant, une surchauffe, lorsqu'elle est trop déchargée (ce qui est par exemple détecté par un passage en dessous d'un seuil de tension) ou trop chargée (ce qui est par exemple détecté par un dépassement d'un seuil de tension ou d'un nombre d'ampères heure acceptable), elle se déconnecte par l'ouverture de son transistor série ;
- lorsqu'une cellule chauffe, elle peut se connecter/déconnecter selon un rapport cyclique, de sorte de limiter sa montée en température. Cet objectif peut être atteint par un asservissement du rapport cyclique en fonction de la température mesurée au niveau de la cellule ;
- si une cellule déconnectée voit la tension de l'étage descendre suffisamment en dessous de 0V (quelques -100mV par exemple), alors elle ferme son transistor parallèle (pas de risque de court-circuiter les cellules placées en parallèle puisque la tension passe d'elle-même par zéro : typiquement quand toutes les cellules du même étage sont déconnectées et qu'un courant est consommé sur le dispositif de génération d'énergie photovoltaïque ou que leur ensoleillement/performance n'est pas suffisant pour maintenir une tension positive sur l'étage). Un petit délai peut être prévu entre la détection du passage de la tension en dessous du seuil et la commande du transistor parallèle pour que les cellules voisines aient aussi eu le temps de détecter le passage du seuil ;
- lors de l'application d'un courant de recharge sur le dispositif de génération d'énergie photovoltaïque, si une cellule déconnectée voit la tension extérieure monter au-dessus de la tension maximale qu'une cellule peut atteindre en charge, alors elle ferme son transistor parallèle (pas de risques de court-circuiter les cellules placées en parallèle puisque pour que la tension puisse aller au-delà de ce seuil, il faut que toutes les cellules de l'étage soient ouvertes) ;
- si une cellule voit un courant trop élevé, ce qui peut notamment arriver lorsqu'il n'y a plus assez de cellules en parallèle pour fournir le courant demandé ou accepter le courant apporté, alors le transistor série de la cellule est ouvert, ce qui élimine le risque de détérioration de la cellule. Si suite à cette déconnexion, les cellules actives restantes placées en parallèle voient un courant trop élevé, elles vont aussi se déconnecter d'elle-même ;
- quand toutes les cellules d'un étage sont déconnectées, et si un courant est consommé sur le dispositif de génération d'énergie photovoltaïque, alors la tension au niveau de l'étage va chuter et tendre à être négative : à ce moment là, chacune des cellules va activer son transistor parallèle qui prendra le relais pour la circulation du courant dans le dispositif de génération d'énergie photovoltaïque ;
- quand toutes les cellules d'un étage sont déconnectées, et si un courant de recharge est apporté sur le dispositif de génération d'énergie photovoltaïque, alors la tension de l'étage va monter et dépasser la tension maximale de charge d'une cellule : dans ce cas, les cellules vont déclencher la fermeture de leur transistor parallèle ;
- pour être certain que toutes les cellules ont bien détecté le dépassement de seuil de tension, on peut volontairement mettre un petit retard sur la commande de l'interrupteur parallèle au niveau de chaque cellule pour bien laisser progresser la tension avant de la ramener à zéro par cette fermeture ;
- si une cellule s'est déconnectée suite à une décharge trop importante (passage au-dessous d'un seuil de tension), elle peut décider de se réactiver dès que la tension de l'étage tend à se rapprocher de celle de la cellule (cas où l'interrupteur parallèle n'a pas été activé). Si l'interrupteur parallèle avait été activé, alors la décision de le désactiver peut se faire à partir d'une détection d'un courant dans le shunt, qui est dans le sens d'un courant de recharge ou d'un courant de décharge inférieur à un seuil. L'ouverture de l'interrupteur parallèle doit alors permettre à la tension de l'étage de sortir d'une tension nulle à moins que la/les cellules placées en parallèle gardent leur interrupteur parallèle fermé pour une autre raison. Si la tension de l'étage n'arrive pas à varier au bout d'un certain temps alors l'interrupteur parallèle est réactivé pour éviter que les interrupteurs parallèles des cellules placées en parallèle supportent tout le courant trop longtemps. Si par contre la tension n'est plus nulle (ou proche de 0), alors l'interrupteur de cellule en série est activé ;
- si une cellule s'est déconnectée suite à une charge trop importante (passage en dessus d'un seuil de tension), elle peut décider de se réactiver dès que la tension de l'étage tend à être inférieure à celui de la cellule (cas où l'interrupteur parallèle n'a pas été activé). Si l'interrupteur parallèle avait été activé alors la décision de le désactiver peut se faire à partir d'une détection d'un courant dans le circuit de shunt parallèle qui est dans le sens d'un courant de décharge. L'ouverture de l'interrupteur parallèle est alors suivie d'une fermeture de l'interrupteur de cellule, un petit délai entre l'ouverture de l'interrupteur parallèle et l'activation l'interrupteur de cellule série peut être prévu afin de laisser le temps à toutes les cellules de détecter le courant de décharge ;
- si une cellule s'est déconnectée suite à un courant trop important et que l'interrupteur parallèle n'a pas été activé, cela signifie que les cellules placées en parallèle ont pu supporter le courant et maintenir la tension, alors la cellule peut tenter de se reconnecter dès que la tension de l'étage est suffisamment proche de la tension de la cellule ;
- Si une cellule s'est déconnectée suite à un courant trop important et que l'interrupteur parallèle a été activé, il est probable que les cellules voisines étaient soit trop chargées, soit trop déchargées et ne participaient plus à l'encaissement du courant. Dans ce cas, dès que le courant qui circule dans l'interrupteur parallèle devient inférieur à un seuil ou de signe opposé au courant qui a causé la désactivation de la cellule (et supposé des cellules voisines), alors il est ouvert. Si on est en présence d'un courant de charge alors on active l'interrupteur de cellule dès que la tension se rapproche de la tension de la cellule, et si la tension n'arrive pas à remonter au bout d'un certain temps on réactive l'interrupteur parallèle (on suppose qu'une cellule placée en parallèle n'a pas ré-ouvert son interrupteur parallèle et on ne peut pas lui laisser un courant important trop longtemps). Si on est en présence d'un courant de décharge et que la tension de l'étage commence à chuter alors l'interrupteur série est fermé (c'est-à-dire dès que l'on est certain que l'interrupteur parallèle de toutes les cellules placées en parallèle est ouvert, sinon la tension n'aurait pas pu descendre), un petit délai entre l'ouverture de l'interrupteur parallèle (puis la détection de la chute de tension) et l'activation de l'interrupteur de cellule peut être prévu afin de laisser le temps à toutes les cellules de détecter le courant de décharge puis la chute de tension ;
- si une cellule s'est déconnectée suite à une défaillance irrémédiable de celle-ci, alors l'interrupteur de cellule n'est plus jamais réactivé. En revanche, l'interrupteur parallèle qui doit se fermer dans certains cas doit pouvoir aussi s'ouvrir. Si l'interrupteur parallèle a été activé suite à la détection du passage de la tension de l'étage par une valeur inférieure à un seuil (quelques -100 mV) alors celui-ci peut être ré-ouvert lorsque le courant le traversant est inférieur à un seuil ou un courant de recharge. S'il a été activé suite à la détection du passage de la tension de l'étage par une valeur supérieure à un seuil (tension maximale qu'une cellule peut atteindre en charge) alors il peut être ré-ouvert lorsque le courant le traversant est inférieur à un seuil ou un courant de décharge. En fait on suppose que ce qui a causé la fermeture généralisée des interrupteurs parallèles provient du fait que les cellules placées en parallèle ont atteint leur pleine charge ou décharge ou sur-courant et que si un courant contraire ou inférieur à un seuil apparait dans le dispositif de génération d'énergie photovoltaïque, alors les cellules placées en parallèle vont se réactiver. Si jamais les cellules voisines placées en parallèle ne se reconnectent pas, alors la tension de l'étage va repartir, soit au-delà de la tension maximale normale soit en dessous de la tension minimale normale et déclencher à nouveau les interrupteurs parallèles des cellules de l'étage ;
- si une cellule s'est déconnectée suite à une défaillance remédiable, alors la cellule peut être reconnectée lorsque la défaillance a disparu (par exemple lorsque sa température est suffisamment redescendue ou si la cellule a été remplacée). Si l'interrupteur parallèle avait été activé, alors on suit le même processus qu'au point précédent.

Les principes précédents peuvent être mis en œuvre de manière similaire à partir d'une gestion centralisée.

Toutes ces opérations du procédé de gestion d'un dispositif de génération d'énergie photovoltaïque ont été effectuées sur la base d'une analyse par un ou plusieurs microcontrôleur(s). En variante, comme les actions à effectuer sont simples, il est possible d'utiliser tout ou partie d'un circuit électronique asynchrone, sans nécessité d'une horloge haute fréquence pour limiter la consommation énergétique de la solution. Dans une telle variante, la détection d'un seuil se ferait directement sur une mesure analogique via un comparateur et l'action induite suite à un passage de seuil pourrait être exécutée de manière asynchrone via des circuits logiques, utilisant par exemple des bascules, registres.

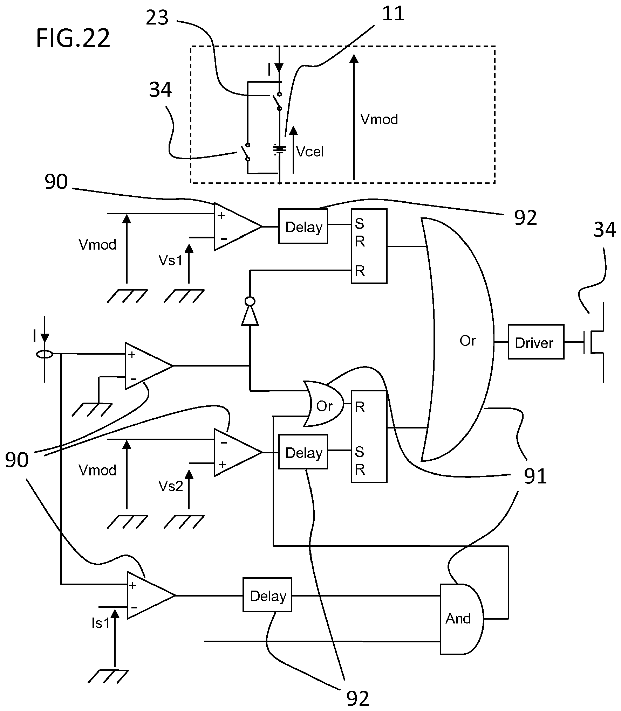

La figure 22 illustre une mise en œuvre possible selon une telle approche permettant le pilotage d'un transistor parallèle 34. Dans cette implémentation, des capteurs de mesure, non représentés, de la tension d'un module Vmod, de la tension aux bornes d'une cellule Vcel, et du courant I traversant une cellule sont utilisés. Ces valeurs mesurées sont comparées à trois valeurs seuil, deux valeurs de seuils haute Vs1 et basse Vs2 pour la tension du module, et une valeur de seuil Is1 pour le courant. Quatre amplificateurs opérationnel 90 (ou comparateurs) permettent de comparer ces valeurs mesurées aux seuils explicités, afin de déterminer, à l'aide de plusieurs opérateurs logiques 91 et de cellules à retard 92, une décision finale d'ouverture ou non du transistor de module 34. Les cellules à retard « Delay » 92 de ce circuit peuvent, outre leur fonction de retarder la réaction à un évènement donné, s'assurer que le résultat de la comparaison est stable sur une certaine durée, et ne prendre en compte une transition que lorsque la stabilité du résultat de la comparaison a été répétée sur une durée prédéfinie, afin d'effacer les mesures brouillées, par exemple suite à des bruits causés par la commutation de cellules ou de modules voisins.

Un avantage de ce type de pilotage d'un transistor de module provient du fait qu'il n'y a pas besoin de numériser les signaux mesurés et que la réaction peut être très rapide, sans pour autant nécessiter un échantillonnage très haute-fréquence des signaux. Par ailleurs toutes les opérations peuvent se faire en parallèle, ce qui est très intéressant si on veut que toutes les cellules puissent réagir de manière synchrone, présentent une ouverture ou une fermeture d'un transistor sur la base de la tension de l'étage commune à toutes les cellules de l'étage, et non sur un front d'horloge qui ne serait pas commun à chaque cellule de l'étage car la même horloge ne pourrait être partagée sans sortie supplémentaire sur les cellules. Une telle synchronisation peut ainsi permettre de réduire, voire supprimer, les risques de recouvrement entre la fermeture des transistors de cellule 23 et les transistors parallèles 34.

D'autre part, le procédé de gestion du dispositif de génération d'énergie photovoltaïque met aussi en œuvre une étape supplémentaire de déconnexion de toutes les cellules possibles lors d'un arrêt prolongé d'utilisation du dispositif de génération d'énergie photovoltaïque. Cette étape apporte une sécurité importante notamment dans les situations particulières comme suite à un accident ou à un incendie. Lorsqu'un nombre important de cellules sont déconnectées, et de préférence toutes les cellules, le risque d'obtenir un court-circuit important entre les cellules, même en cas d'incident important, reste très faible. Par ailleurs, l'isolation des cellules à l'arrêt évite que les cellules se déchargent au travers de certaines cellules au plus gros courant de fuite ou présentant des défauts.

Selon un mode de réalisation avantageux, le procédé de gestion de l'invention comprend une commande d'interrupteurs de cellules et/ou de modules afin d'obtenir une tension de sortie de valeur prédéfinie, et/ou une tension de sortie alternative selon une consigne prédéfinie.

Ainsi, le procédé de gestion de dispositif de génération d'énergie photovoltaïque permet aussi une adaptation de la tension de sortie selon l'utilisation souhaitée, par exemple au besoin d'une charge électrique ou d'un réseau électrique. Cette adaptation comprend par exemple le choix restreint d'un certain nombre de modules ou de sous-ensembles à utiliser en série, les autres modules restant inutilisés, quand la tension totale nécessaire est inférieure à la tension maximale que peut délivrer le dispositif de génération d'énergie photovoltaïque.

L'adaptation de la tension de sortie du dispositif de génération d'énergie photovoltaïque de l'invention peut même prendre des formes complexes. En effet, elle est adaptée pour fournir une tension de sortie sinusoïdale, par exemple de 220 V à 50 Hz pour s'adapter à un réseau électrique public, ou pour un moteur synchrone ou asynchrone. La figure 23 représente un exemple de régulation d'un dispositif de génération d'énergie photovoltaïque pour obtenir une telle sortie de tension, mise en œuvre par exemple au sein du calculateur central 22 du mode de réalisation de la figure 14. Cette régulation repose sur un bloc 80 de calcul d'une valeur de consigne des paramètres électriques souhaités en sortie du dispositif de génération d'énergie photovoltaïque, comprenant la tension de consigne V_{cons} et le courant de consigne I_{cons}. En remarque, la consigne peut consister en une combinaison de ces valeurs de courant et de tension, comme par exemple leur produit I_{cons} x V_{cons}. Le bloc 80 de détermination d'au moins une valeur de consigne peut reposer sur une commande vectorielle, prenant en compte le réglage de l'amplitude, de la fréquence et éventuellement de la phase du paramètre courant/tension selon le type de moteur à alimenter. Naturellement, ce principe fonctionne aussi avec des situations plus simples, comme un besoin d'une tension continue. Ensuite, le bloc de régulation comprend un bloc 83 de correction, à partir de la différence entre les valeurs de consigne I_{cons}, V_{cons} et les valeurs réelles correspondantes I_{réel}, V_{réel}, qui transmet un besoin à un bloc 84 qui détermine le nombre de modules nécessaires dans le dispositif de génération d'énergie photovoltaïque et éventuellement les cellules particulières de ces modules à utiliser. Selon une réalisation préférée, le choix des cellules à utiliser dans les modules se fait au niveau des modules sur la base des paramètres mesurés localement. Pour cela, ce bloc 84 reçoit aussi les informations de mesure de grandeurs effectuées au niveau des modules et des cellules du dispositif de génération d'énergie photovoltaïque. Enfin, un dernier bloc 85 met en œuvre le choix déterminé par le bloc 84, et envoie notamment les commandes nécessaires aux différents interrupteurs du dispositif de génération d'énergie photovoltaïque. Il en résulte en sortie les valeurs réelles du courant I_{réel} et de la tension V_{réel}, qui permettent d'atteindre les valeurs de fonctionnement, comme une vitesse Vit et un couple Cou transmises par le bloc 82. Enfin, un limiteur de fréquence de variation et/ou un filtrage passe-bas peut agir sur le bloc 83 de correction, ou sur la boucle de retour, pour obtenir une valeur moyenne convenable, en limitant les fréquences de commutation des cellules, comme par exemple selon une fréquence de 200 kHz pour une tension de sortie de fréquence 500 Hz.

Cette fonctionnalité de régulation de la tension de sortie du dispositif de génération d'énergie photovoltaïque lui permet de se comporter comme une structure de conversion de type dispositif de génération d'énergie photovoltaïques commutées, qui évite l'utilisation d'un convertisseur DC/DC en sortie du dispositif de génération d'énergie photovoltaïque, pour ajuster la tension aux besoins de l'application, et permet l'utilisation du dispositif de génération d'énergie photovoltaïque selon le schéma simplifié des figures 6 et 7, et non plus comme celui de la figure 1 de l'état de la technique.

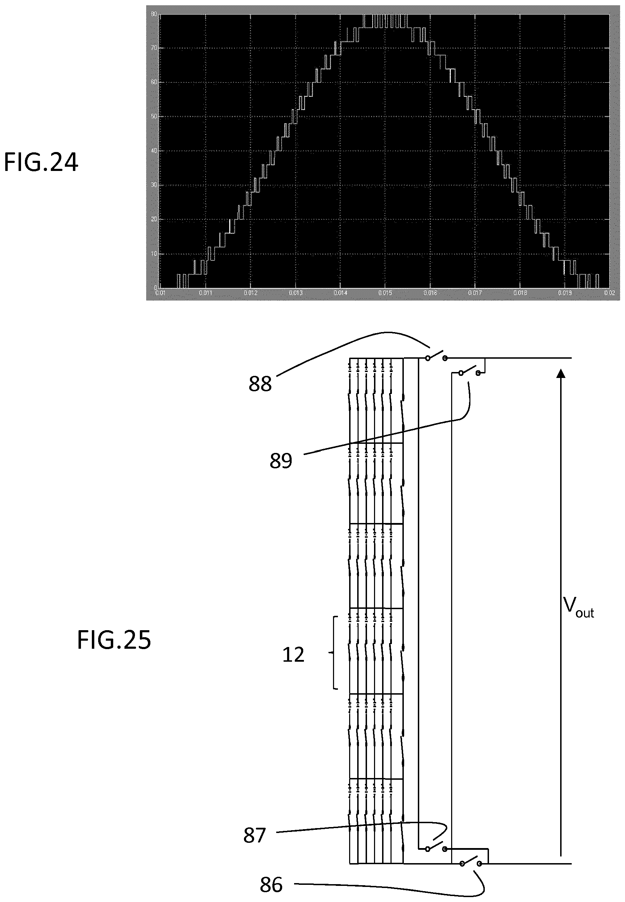

La figure 24 représente un exemple d'onde de tension qui peut être fournie par le dispositif de génération d'énergie photovoltaïque via un pilotage tel qu'explicité ci-dessus, pour une consigne en tension de type sinusoïde à 50 Hz, d'amplitude crête de 40 V et centrée sur 40 V, et pour un dispositif de génération d'énergie photovoltaïque constitué de 20 modules de 4 volts chacun et dont la fréquence de commutation est limitée à 10 kHz (soit 100 commutations par période).

Pour pouvoir générer une tension monophasée centrée sur 0, il faut pouvoir utiliser soit deux colonnes et une tension différentielle, soit rajouter un pont en H, tel qu'illustré sur la figure 25, qui permet d'inverser la tension aux bornes du dispositif de génération d'énergie photovoltaïque sur la base de quatre interrupteurs 86, 87, 88, 89, deux 86, 87 au niveau d'une première borne et deux 88, 89 au niveau d'une seconde borne. Lorsque les deux interrupteurs 86, 88 sont fermés et les deux autres ouverts, la tension de sortie Vₒᵤₜ est positive. Au contraire, lorsque les deux interrupteurs 87, 89 sont fermés et les deux autres ouverts, la tension de sortie Vₒᵤₜ est négative.

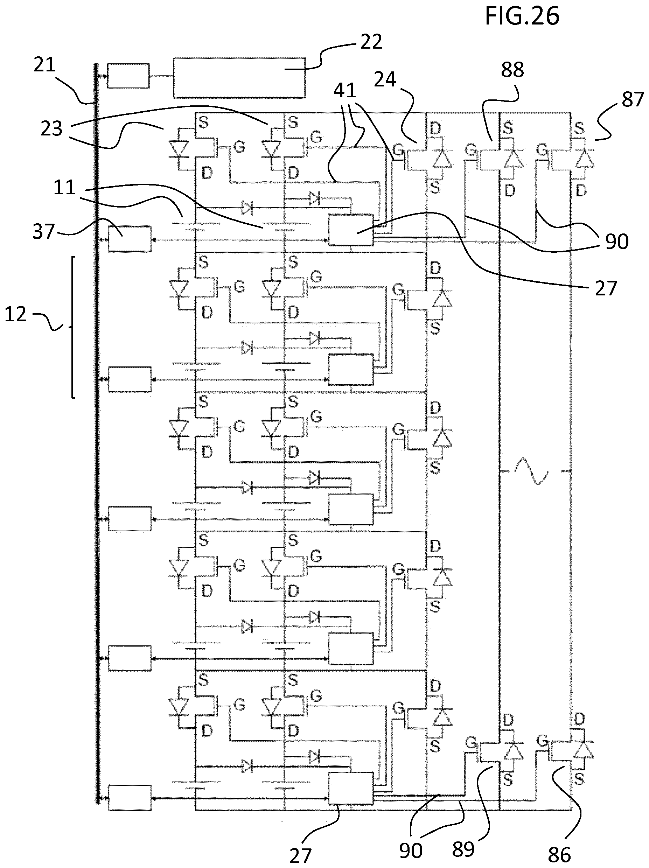

La figure 26 illustre une mise en œuvre plus détaillée du principe décrit à la figure 25, sur la base d'une structure de dispositif de génération d'énergie photovoltaïque telle que présentée à la figure 14, comprenant à titre d'exemple cinq modules de deux cellules. Pour chaque cellule 11, un transistor de cellule 23 est prévu, en série avec la cellule, et un transistor de module 24, en parallèle, est prévu pour chaque module 12, comme explicité précédemment. D'autre part, au moins un capteur de mesure d'une grandeur caractéristique de cellule est présent au niveau du module, non représenté pour une raison de simplification. Un circuit de commande 27 local, au niveau du module 12, pilote les transistors 23, 24 par des signaux de commande 41, comme cela a été explicité précédemment, sous les ordres d'un calculateur central 22 par le bus de communication 21 et par l'intermédiaire d'une interface 37 formant une isolation galvanique. Le dispositif de génération d'énergie photovoltaïque comprend de plus quatre interrupteurs 86, 87, 88, 89 tels que présentés ci-dessus, qui sont des transistors selon ce mode de réalisation, pilotés respectivement par les circuits de commande 27 des modules extrêmes supérieur et inférieur du dispositif de génération d'énergie photovoltaïque, par des liaisons de commande 90.

En remarque, le procédé de gestion du dispositif de génération d'énergie photovoltaïque met en œuvre une commutation optimale des interrupteurs 86, 87, 88, 89. Par exemple, si la tension de sortie doit être une tension sinusoïdale, la commutation des transistors est effectuée lorsque la tension passe par 0, pour limiter les pertes par commutation. Si une onde à 50 Hz est souhaitée en sortie du dispositif de génération d'énergie photovoltaïque, il est nécessaire de procéder à 50 fermetures/ouvertures par seconde des transistors du pont en H.

De plus, le procédé de gestion du dispositif de génération d'énergie photovoltaïque met aussi avantageusement en œuvre une gestion intelligente des transistors du pont en H similaire aux étapes envisagées pour la gestion des transistors série ou de module. Par exemple, il est aussi possible de leur associer une mesure de température ou de tension et/ ou courant, et de prendre une décision d'ouverture d'un transistor si la grandeur mesurée dépasse un certain seuil, par exemple en cas de température trop élevée. Cette grandeur mesurée peut naturellement être transmise à un circuit de traitement local et/ou distant afin de mettre en œuvre cette gestion intelligente.

Les deux modules extrêmes supérieur et inférieur du dispositif de génération d'énergie photovoltaïque intègrent des composants électroniques plus nombreux que les autres modules. Tous ces composants sont avantageusement alimentés électriquement par la tension disponible au niveau du module. Dans ce cas, les modules extrêmes sont plus sollicités que les autres.

Finalement, la solution décrite précédemment présente de nombreux avantages parmi lesquels :
- elle repose sur une multitude d'interrupteurs élémentaires, c'est-à-dire une multitude de transistors selon le mode de réalisation préféré, éloignés les uns des autres, ce qui permet facilement d'évacuer l'énergie dissipée par leur fonctionnement, puisque cette énergie dissipée se présente sous la forme d'une multitude de petites quantités d'énergie éparpillées dans la structure du dispositif de génération d'énergie photovoltaïque ;
- elle permet d'effectuer une optimisation en temps réel du fonctionnement des cellules du dispositif de génération d'énergie photovoltaïque via un aiguillage dynamique ;
- elle permet de déconnecter les cellules défaillantes ;
- elle permet d'ajuster la tension de sortie du dispositif de génération d'énergie photovoltaïque de manière douce (commutation basse fréquence < 1000 Hz et avec des paliers en tension peu élevés, par exemple 4V), sans nécessiter de hachage haute fréquence de la pleine tension du dispositif de génération d'énergie photovoltaïque. Elle permet d'ajuster une tension continue souhaitée pour le pilotage de moteurs à courant continu ou pour une liaison avec un réseau de distribution électrique.
- elle permet d'isoler individuellement une cellule d'un module, en permettant notamment de mesurer sa tension à vide même si le dispositif de génération d'énergie photovoltaïque est en fonctionnement ;
- elle permet d'isoler toutes les cellules, par exemple suite à la détection d'une défaillance majeure, permettant d'écarter tous risques électriques pour l'utilisateur ou les personnes qui seront amenées à intervenir, par exemple les pompiers en cas d'incendie.

En mesurant à la fois la tension des cellules et la tension d'un module du dispositif de génération d'énergie photovoltaïque, il est possible d'en déduire les tensions aux bornes des transistors de puissance. A partir de ces tensions et du courant traversant les cellules ou transistors de modules, il est possible, dans certaines configurations, de détecter si un transistor est défaillant. Ainsi, le dispositif de génération d'énergie photovoltaïque met aussi en œuvre un procédé de diagnostic du fonctionnement de tout ou partie des transistors qui remplissent les fonctions essentielles d'interrupteurs, qui peut comprendre tout ou partie des étapes suivantes :
- si à l'ouverture des transistors de cellules, la tension de l'étage reste sensiblement égale à celle des cellules alors qu'un courant circule, c'est qu'au moins un des transistors de cellule ne s'ouvre plus. Pour connaître lequel, il suffit de regarder par quelle cellule circule le courant. Ainsi, le procédé de diagnostic comprend une étape de commande d'ouverture de tous les transistors de cellules d'un module, la mesure de la tension du module, et en cas de valeur proche de la tension d'une cellule, mesure du courant traversant chaque cellule et classification de transistors de cellule comme « défaillants » si un courant y circule. Dans la suite, le/les transistors de module associés à un module dont un au moins un des transistors de cellules est défaillant (reste fermé) n'est/ne sont plus activés pour ne pas créer de courts-circuits. Le procédé peut comprendre une étape complémentaire de transmission des données relatives à l'identité des interrupteurs défaillants et/ou du courant maximal que peut délivrer chaque module à une unité locale et/ou centrale. Un utilisateur doit pouvoir savoir quels transistors sont à changer ;
- si lors d'une commande d'ouverture des transistors parallèles, la tension de l'étage reste sensiblement nulle alors qu'un courant circule, alors au moins un transistor parallèle ne s'est pas ouvert et est défaillant. La mesure du courant au travers de chaque transistor parallèle du module (cas par exemple d'un transistor en parallèle de chaque cellule) permet de déterminer le ou les transistors parallèles défaillants. Le procédé de diagnostic comprend donc une étape de commande d'ouverture des transistors parallèles, de mesure de la tension et du courant, d'identification des transistors de module défaillants si la tension est nulle alors qu'un courant circule. Dans la suite, les transistors de cellule associés à un module dont le transistor parallèles est défaillant (reste fermé) ne sont plus activés pour ne pas créer de courts-circuits. Le module concerné n'est plus utilisé jusqu'au remplacement de son transistor de module ou des interrupteurs parallèles ;
- si lors de la commande de fermeture d'un transistor de cellule, il apparait une chute de tension sur un transistor alors que le courant dans la cellule associée est sensiblement nul, alors le transistor de cellule est défaillant et ne se ferme plus. Une telle situation limite le courant que peut fournir un module. Le calculateur central du dispositif de génération d'énergie photovoltaïque est informé en lui indiquant le courant maximal que le module peut encore supporter. De plus, l'utilisateur est averti du transistor à changer ;
- de manière similaire, si la commande de fermeture d'un transistor de module entraîne une chute de tension sur le transistor alors que le courant y est nul, alors cela signifie que le transistor est défaillant et ne se ferme plus. Cela limite le courant que peut faire passer le module lorsque les cellules sont déconnectées. Le calculateur central est averti en lui indiquant le courant maximal que le module peut encore supporter. De plus, l'utilisateur est averti du transistor à changer ;
- lorsqu'un courant dans une branche est de signe opposé au courant circulant dans les autres branches, au-delà d'un certain seuil, alors il est diagnostiqué un courant de fuite du transistor normalement ouvert de cette branche. Le calculateur central est averti en lui indiquant la valeur du courant de fuite et le courant maximal que le module pourra encore supporter dans le cas d'une défaillance partielle ou complète du transistor à l'état passant qui pourrait ensuite survenir, selon par exemple une anticipation par modèle de la dégradation future du transistor. Le calculateur principal pourra par exemple privilégier de maintenir le module dans un état particulier (activation des cellules ou du/des transistors parallèles) de façon à plutôt maintenir le transistor avec courant de fuite dans un état fermé pour éviter les pertes, son échauffement, et limiter ses commutations pour limiter sa dégradation. De plus, l'utilisateur est averti du transistor à changer.

Naturellement, l'invention ne se limite pas aux exemples précédents. Notamment, plusieurs capteurs de mesure par cellule ont été implémentés mais en variante d'autres nombres de capteurs de mesure peuvent être choisis ou aucun capteur. De plus, il est possible d'utiliser d'autres types de capteurs de mesure que ceux décrits, pour mesurer d'autres grandeurs caractéristiques de l'état d'une cellule que la tension, le courant ou la température.

De plus, les modes de réalisation précédents ont été décrits en implémentant un interrupteur de cellule pour chaque cellule du dispositif de génération d'énergie photovoltaïque. Toutefois, il serait possible d'obtenir une amélioration d'un dispositif de génération d'énergie photovoltaïque en ne gérant qu'une partie de ses cellules selon le concept de l'invention, et donc en ne disposant des interrupteurs de cellule que sur une partie des cellules du dispositif de génération d'énergie photovoltaïque, donc au moins un interrupteur, avantageusement sur au moins deux cellules d'un même module pour permettre une certaine souplesse dans cette gestion. Certains modules pourraient ne pas implémenter l'approche décrite précédemment et il est possible d'imaginer un dispositif de génération d'énergie photovoltaïque associant des parties conventionnelles et des modules améliorés selon l'invention. D'autre part, un interrupteur de module a été décrit pour chaque module du dispositif de génération d'énergie photovoltaïque, ou en variante des interrupteurs parallèles associés à chaque cellule. De tels interrupteurs restent optionnels et pourraient être supprimés, dans une version simplifiée de l'invention. De plus, l'invention couvre toutes les réalisations intermédiaires intégrant un ou plusieurs interrupteur(s) de module et/ou interrupteurs parallèles, pour une partie seulement des cellules et/ou modules.

Enfin, les exemples représentés comprennent peu de cellules pour une raison de clarté des figures. Toutefois, les réalisations envisagées sont adaptées pour la mise en œuvre de dispositifs de génération d'énergie aptes à fournir une tension de sortie importante, pouvant atteindre plusieurs centaines de volts, par exemple pour une connexion sur le secteur à 220 volts. Elles sont donc adaptées pour des dispositifs comprenant un nombre important de modules, notamment supérieur ou égal à 8.

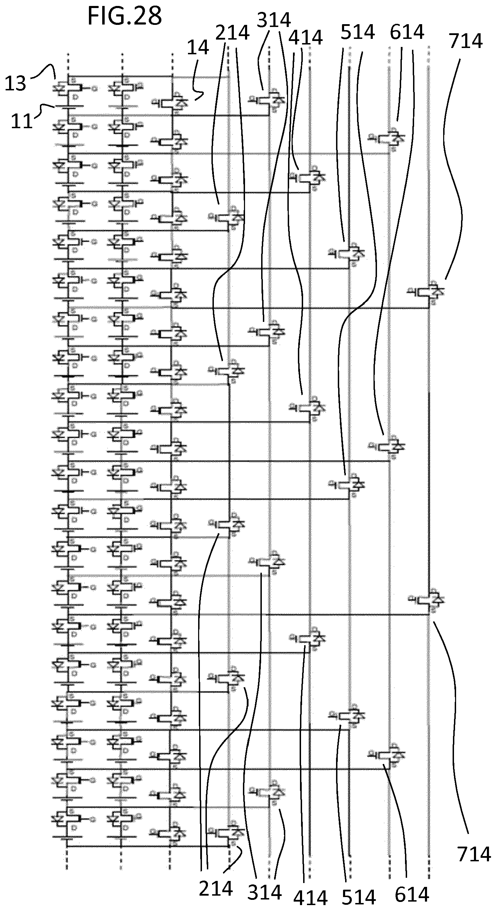

Les figures 28 à 30 illustrent à cet effet des variantes de réalisation de mise en œuvre d'une fonction de shunt de plusieurs modules d'un dispositif de génération d'énergie photovoltaïque, qui reposent sur des interrupteurs complémentaires disposés en parallèle de plusieurs modules permettant de rajouter un chemin de passage du courant lorsque plusieurs modules sont désactivés, limitant ainsi les pertes.

Ainsi, la figure 28 ajoute une première série d'interrupteurs 214 permettant chacun de shunter quatre modules consécutifs, une seconde série d'interrupteurs 314 permettant chacun de shunter six modules consécutifs, une troisième série d'interrupteurs 414 permettant chacun de shunter aussi six modules consécutifs mais décalés par rapport à la seconde série, une quatrième série d'interrupteurs 514 permettant chacun de shunter aussi six modules consécutifs mais décalés par rapport aux deux séries précédentes, une cinquième série d'interrupteurs 614 permettant chacun de shunter huit modules consécutifs et une sixième série d'interrupteurs 714 permettant chacun de shunter aussi huit modules consécutifs mais décalés par rapport à la cinquième série.

Tous les interrupteurs de ces différentes séries sont disposés entre les bornes inférieures et supérieures de modules différents, en parallèle les uns des autres. Naturellement, leur gestion est cohérente pour éviter de créer des situations de court-circuit, comme cela a été explicité sur les exemples précédents.

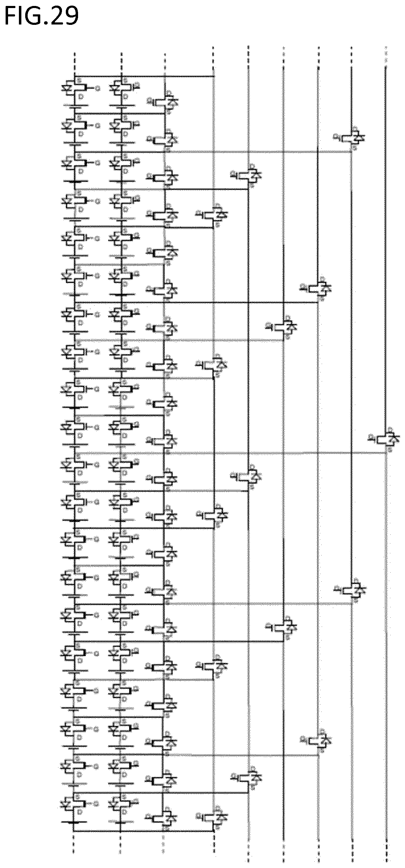

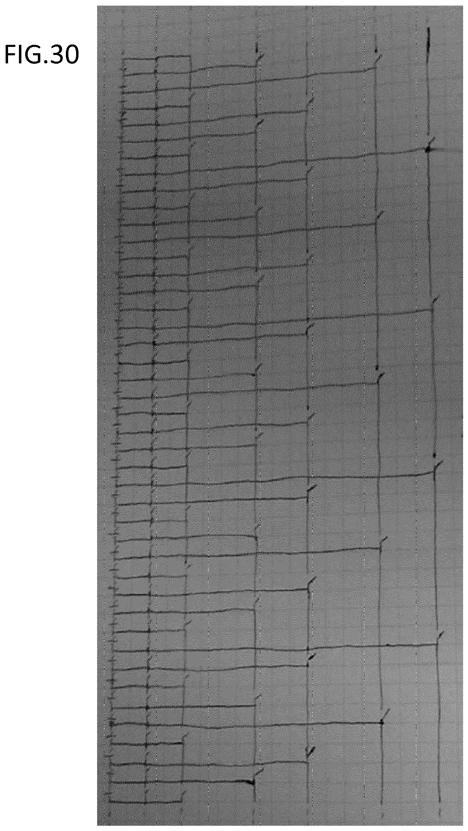

Les deux figures 29 et 30 illustrent deux autres variantes de réalisation selon la même approche.

L'avantage de ces différentes réalisation est d'ajouter des chemins de passages du courant beaucoup plus directes lors de la désactivation de plusieurs modules grâce à des interrupteurs qui shuntent plusieurs étages à la fois, ce qui génère alors beaucoup moins de pertes. Ainsi, à chaque instant, selon le nombre de modules nécessaires, une configuration sensiblement optimale est mise en œuvre pour minimiser la résistance totale du dispositif de génération d'énergie photovoltaïque.

Les différents interrupteurs mentionnés, de cellule et/ou module et/ou parallèles, ont été implémentés à l'aide de transistors. Des transistors NMOS ou PMOS ont été principalement représentés, mais il est toutefois possible d'utiliser des transistors bipolaires NPN et PNP, qui présentent l'avantage de pouvoir être commandés avec une tension assez faible, des transistors FET, JFET, IGBT, GaN, des relais, etc. En variante, tout autre type d'interrupteurs que ceux décrits pourrait être implémenté, comme des thyristors si le courant est naturellement amené à s'inverser au moment où on souhaite l'ouvrir.

Le dispositif de génération d'énergie photovoltaïque de l'invention peut être gérée par une unité intelligente, un calculateur ou circuit de traitement local et/ou distant et accessible par un dispositif de communication local, ce calculateur pouvant comprendre tout élément logiciel (software) et/ou matériel (hardware) pour gérer le dispositif de génération d'énergie photovoltaïque, notamment déterminer la configuration de ses interrupteurs. Pour cela, le dispositif de génération d'énergie photovoltaïque peut intégrer tout moyen d'actionnement, tout circuit de commande, de ses interrupteurs.

De nombreuses autres variantes de réalisation de l'invention peuvent être facilement imaginées par une simple combinaison des modes de réalisation et/ou leurs variantes décrits précédemment.

En remarque, la communication au sein du dispositif de génération d'énergie photovoltaïque et/ou vers une unité extérieure peut se faire selon un principe de courant porteur, dès lors que le courant demandé par une charge n'est pas trop important pour autoriser la déconnection de certaines cellules. En effet, ce principe repose sur une alternance volontaire de connexions et déconnexions de certaines cellules du dispositif de génération d'énergie photovoltaïque, afin de créer une modulation de courant induit et une modulation de puissance au niveau d'un module, qui se propage à l'ensemble du dispositif de génération d'énergie photovoltaïque et au-delà. Cette modulation de puissance est donc visible par les autres modules du dispositif de génération d'énergie photovoltaïque et par une charge extérieure, ce qui permet de l'utiliser pour transmettre des informations selon n'importe quel protocole de communication, existant et normalisé ou non. Il peut par exemple être défini un circuit maître qui interroge tour à tour toutes les cellules, par leur adresse, chaque cellule répondant ensuite dans un créneau temporel dédié. Le maître peut par exemple demander une information comme une mesure de tension, courant et/ou température à une certaine cellule, puis cette dernière peut envoyer l'information demandée avec éventuellement un code permettant d'informer d'une éventuelle défaillance ou non. Ce principe permet ainsi à différentes cellules du dispositif de génération d'énergie photovoltaïque de communiquer simplement entre elles, ou de communiquer vers un calculateur central ou un circuit de traitement du dispositif de génération d'énergie photovoltaïque ou vers une unité extérieure. En remarque, la modulation de courant peut se faire sans déconnecter complètement une cellule, mais simplement en modulant la résistance à l'état passant du transistor de cellule, c'est-à-dire en modulant la tension de grille du transistor autour d'un point de polarisation. Cette modulation de résistance à l'état passant peut aussi se faire sur le transistor de module lorsque celui-ci est activé. Cela permet alors de communiquer même si l'étage est désactivé par l'ouverture des transistors de cellule. La communication par courant porteur permet de moduler un courant important au niveau d'un module sans pour autant engendrer de pertes électriques importantes. En effet, cette modulation de courant se fait en modulant une consommation de courant simplement stocké et déstocké puisqu'appartenant à un dispositif de génération d'énergie photovoltaïque couplé à un élément de stockage, ce qui fait qu'il n'existe pas les pertes qui existent dans un élément dissipatif comme une résistance ou un transistor en mode linéaire utilisé classiquement pour un système de courant porteur.

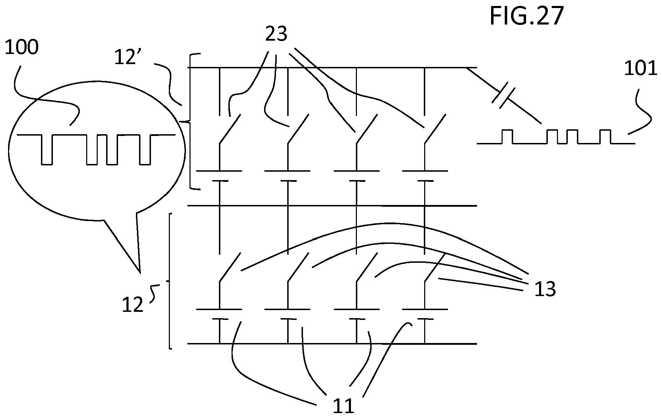

La figure 27 illustre ainsi schématiquement la mise en œuvre de principe, sur laquelle un premier module 12 d'un dispositif de génération d'énergie photovoltaïque génère un signal de communication 100 par l'actionnement d'au moins un interrupteur de cellule 13, alors qu'un signal correspondant 101 est ensuite reçu au niveau d'un second module 12' du dispositif de génération d'énergie photovoltaïque.

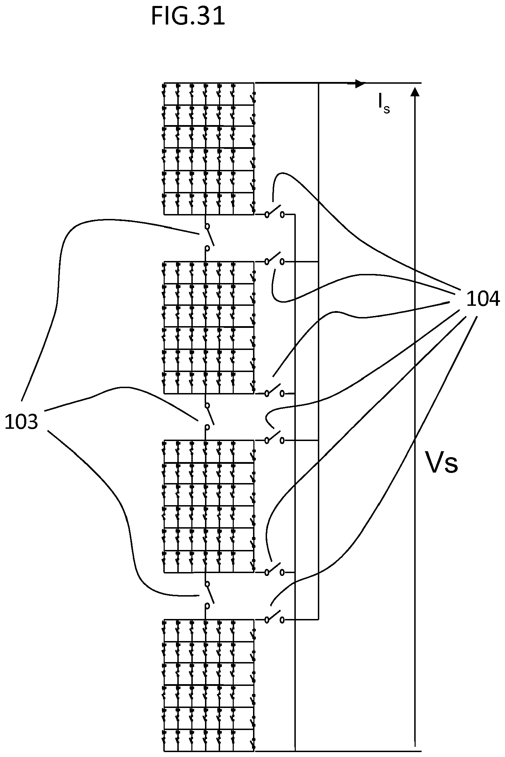

La figure 31 illustre une variante du mode de réalisation de l'invention, dans laquelle le dispositif de génération d'énergie photovoltaïque est séparé en quatre parties ou sous-ensembles équivalents comprenant plusieurs modules de plusieurs cellules. La structure de ces modules intègre le concept tel que décrit précédemment, et chaque cellule comprend ici un interrupteur de cellule et chaque module un interrupteur de module. Ces différentes parties peuvent être soit disposées en série, en fermant des premiers interrupteurs 103 les reliant et en ouvrant des seconds interrupteurs 104, ce qui représente alors une géométrie telle que décrite précédemment en référence avec la figure 7, soit en parallèle en ouvrant au contraire les premiers interrupteurs 103 et en fermant les seconds interrupteurs 104. En variante, toute combinaison intermédiaire est possible, comme le regroupement des parties deux par deux en série, puis la disposition de ces groupements de deux parties en parallèle. Cette variante permet d'avoir le choix entre une tension de sortie Vs importante ou une tension plus faible mais un courant de sortie Is supérieur à celui qu'on obtiendrait avec toutes les parties en série. Ainsi, cette structure devient exploitable dès que la tension de sortie désirée est inférieure à celle que peut fournir la moitié des modules. Si cette tension est inférieure à un quart de celle que peut fournir la totalité des modules en série, alors les quatre parties représentées peuvent être utilisées en parallèle.

En variante, la même approche pourrait être implémentée avec tout autre nombre de parties ; chaque module pourrait même représenter une partie, adaptée pour une association en série ou en parallèle avec le reste du dispositif de génération d'énergie photovoltaïque. De plus, ces différentes parties pourraient être différentes entre elles, ne pas comprendre le même nombre de cellules. Le procédé de gestion du dispositif de génération d'énergie photovoltaïque pourrait ainsi comprendre une étape de calcul automatique du nombre de parties à placer en parallèle, selon une période prédéterminée, en fonction de la tension et du courant demandés en sortie, puis une étape d'actionnement des interrupteurs 103, 104 afin d'obtenir la géométrie du dispositif de génération d'énergie photovoltaïque la plus adaptée au besoin, à chaque instant.

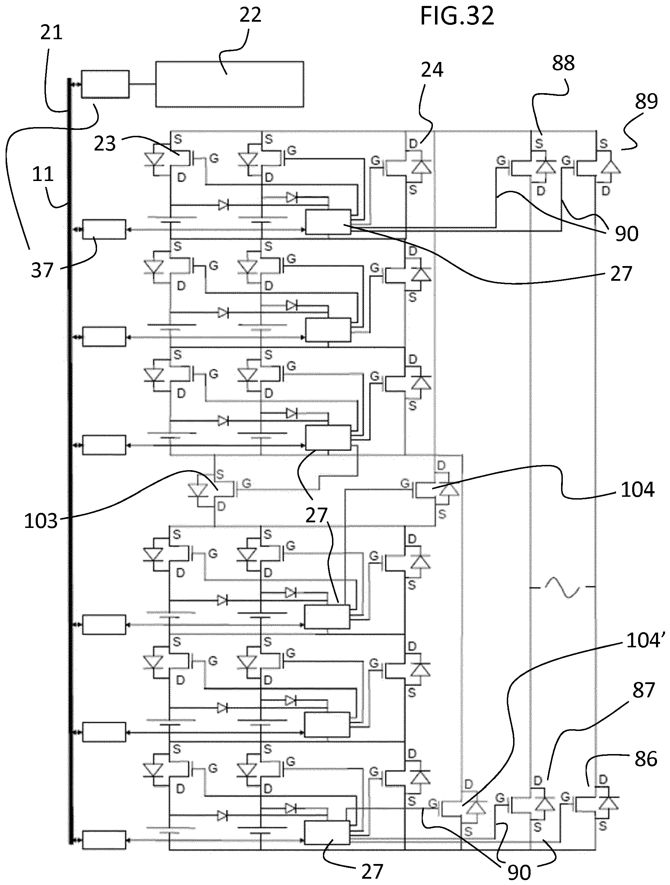

La figure 32 illustre ainsi une mise en œuvre du principe décrit ci-dessus en référence à la figure 31. Dans cet exemple, le dispositif de génération d'énergie photovoltaïque comprend seulement deux parties de trois modules pour obtenir une clarté de la représentation. Naturellement, ce principe peut se dupliquer pour un dispositif de génération d'énergie photovoltaïque d'une centaine de modules, divisible en une multitude de parties. Le dispositif de génération d'énergie photovoltaïque représenté correspond à celui décrit en référence avec la figure 14. Tous les modules comprennent les composants électroniques déjà décrits en détail et sont reliés à un calculateur central 22 par un bus de communication 21 et une isolation galvanique 37. Le dispositif de génération d'énergie photovoltaïque est de plus équipée d'un pont en H par l'intermédiaire de quatre interrupteurs 86 à 89 tels qu'explicités précédemment. Enfin, le découpage du dispositif de génération d'énergie photovoltaïque en deux parties est obtenu par l'ajout de trois transistors formant les interrupteurs 103, 104, 104' explicités précédemment. Comme cela est illustré, deux transistors 103, 104 sont positionnés dans la partie centrale du dispositif de génération d'énergie photovoltaïque de sorte d'être pilotés par des circuits de commande 27 des modules adjacents répartis physiquement de part et d'autre de ces transistors. D'autre part, un transistor 104' est positionné vers l'extrémité inférieure du dispositif de génération d'énergie photovoltaïque et est piloté par un signal 90 du circuit de commande du module inférieur du dispositif de génération d'énergie photovoltaïque. Naturellement, ces interrupteurs 103, 104, 104' pourraient être répartis différemment au sein de la structure du dispositif de génération d'énergie photovoltaïque.

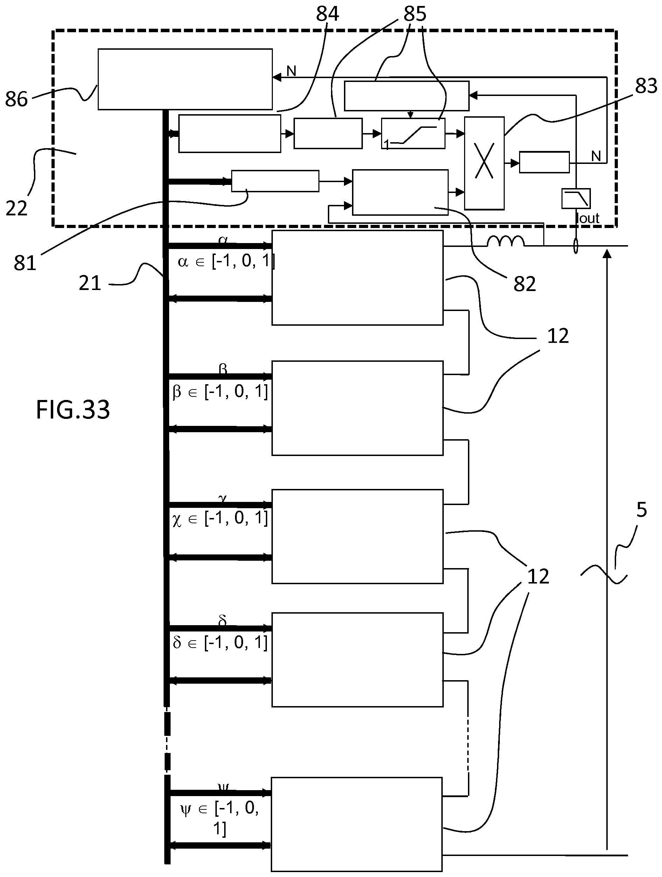

La figure 33 illustre schématiquement les différents blocs du calculateur 22 qui met en œuvre un procédé de gestion du dispositif de génération d'énergie photovoltaïque, qui comprend plusieurs modules 12 qui peuvent être mis en série ou en parallèle entre eux, selon le principe décrit ci-dessus, et qui est relié au secteur 5. Ce calculateur met en œuvre un premier calcul dans un bloc 82 du rapport entre la tension du secteur 5 et la tension moyenne d'un module ou étage 12, obtenue dans un premier bloc 81, ce qui donne le nombre, non entier, de modules à mettre en série pour atteindre, à vide, la tension correspondant à celle du secteur 5. Il en déduit dans un bloc 83 le nombre N de modules à mettre en série pour obtenir, avec le courant souhaité, la tension correspondant à celle du secteur 5. Pour cela, un bloc d'arrondi est disposé en sortie de ce bloc 83, permettant d'obtenir un nombre entier. Un bloc 84 calcule un écart moyen entre la tension des modules et leur tension optimale, et met en œuvre une rétroaction pour se rapprocher de la situation optimale, par des blocs 85. Cette solution revient à modifier le courant de sortie pour s'approcher d'une situation plus favorable pour atteindre le fonctionnement optimal au niveau de chaque module. Pour cela, un coefficient α est choisi, de préférence borné, pour ajuster le courant global afin d'atteindre un fonctionnement optimal du module. Le résultat est aussi transmis au bloc 83 de calcul du nombre de modules nécessaire. Ensuite, un bloc 86 effectue la sélection des N modules particuliers à utiliser, notamment en tenant compte de l'écart entre leur tension et leur tension optimale, privilégiant ceux dont la tension est la plus éloignée au-dessus de cette tension optimale.

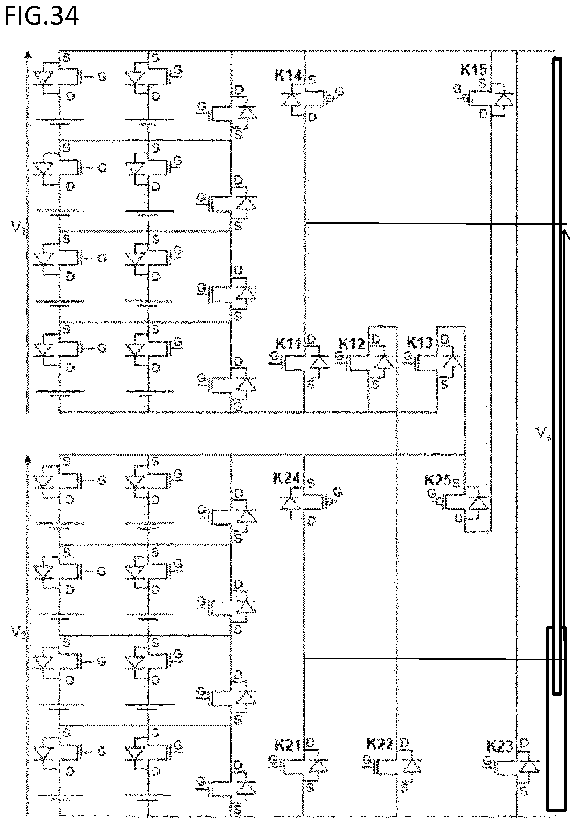

La figure 34 illustre ainsi un autre exemple de réalisation d'un dispositif de génération d'énergie photovoltaïque comprenant huit modules de deux cellules, répartis en deux parties de quatre modules restituant chacune respectivement une tension V₁ et V₂. Ce dispositif de génération d'énergie photovoltaïque comprend de plus dix transistors MOS, dont cinq transistors K11 à K15 liés à la première partie et cinq transistors K21 à K25 liés à la seconde partie. Ces dix transistors sont commandés directement par les modules adjacents. Ils permettent de mettre en œuvre les deux fonctions d'inversion de tension et de mise en série ou parallèle des deux parties du dispositif de génération d'énergie photovoltaïque.

Pour cela, il s'agit bien d'une solution équivalente au schéma précédent. La tension totale Vₛ restituée par le dispositif de génération d'énergie photovoltaïque se définit en effet par les formules suivantes :
- Vₛ = V₁ + V₂ quand les transistors K13, K14 et K21 sont fermés, les autres étant ouverts,
- Vₛ = - V₁ - V₂ quand les transistors K11, K23 et K24 sont fermés, les autres étant ouverts,
- Vₛ = V₁ = V₂ quand les transistors K12, K22, K15, K25, K14 et K21 sont fermés, les autres étant ouverts,
- Vₛ = - (V₁ = V₂) quand les transistors K12, K22, K15, K25, K11 et K24 sont fermés, les autres étant ouverts.

Cette réalisation comprend des transistors K14, K15, K24 et K25 qui ne sont jamais soumis à une tension supérieure à V₁ ou V₂, ce qui permet de choisir des transistors basse tension, susceptibles de recevoir un courant plus fort sans générer trop de pertes. Les dix transistors sont commandés via une électronique qui peut être alimentée et placée sur les modules inférieurs et supérieurs des deux parties du dispositif de génération d'énergie photovoltaïque, comme dans les cas précédents. Comme les potentiels de source de ces transistors sont référencés par rapport à ces modules, cela simplifie leur commande.

Dans le cas d'un dispositif de génération d'énergie photovoltaïque comprenant N modules, si le calcul détermine que n modules en série sont nécessaires pour obtenir une tension demandée, alors le calcul suivant peut être effectué :
- Si n < N/2 alors mise en parallèle de deux parties, en découpant le dispositif de génération d'énergie photovoltaïque en deux ;
- Si n < N/3, division du dispositif de génération d'énergie photovoltaïque en trois parties, etc.

En variante, une régulation de type hystérésis peut être choisie, pour éviter de commuter trop souvent les interrupteurs lorsque la tension demandée varie autour d'une valeur limite comme N/2. Pour cela, il peut être décidé de procéder à la division en p parties du dispositif de génération d'énergie photovoltaïque lorsque n < N/p - q, où q est une constante entière.

En variante, le procédé de gestion du dispositif de génération d'énergie photovoltaïque peut mettre en œuvre toute régulation autour d'une valeur de tension et/ou courant de sortie. Lorsque la tension de sortie est inférieure à la valeur de consigne, le nombre n de modules en série est augmenté, et au contraire si elle est supérieure à la valeur de consigne, alors ce nombre n est diminué. Pour éviter que le nombre n oscille entre deux valeurs pour atteindre une valeur de consigne non atteignable avec une valeur de n entière, un limiteur de fréquence de variation peut être utilisé et/ou un filtrage passe-bas au niveau du correcteur ou de la boucle de retour pour atteindre une régulation sur une valeur moyenne.

Si le dispositif de génération d'énergie photovoltaïque doit fournir une tension alternative, ou toute tension variable dans le temps selon une période donnée, la mise en parallèle de différentes parties du dispositif de génération d'énergie photovoltaïque peut se décider sur des critères similaires, appliqués à l'amplitude de la sinusoïde ou de la tension variable à fournir, pour éviter de basculer d'un mode à un autre trop souvent, à chaque période. Globalement, le courant demandé pourra être d'autant plus élevé que l'amplitude de la tension demandée sera faible.

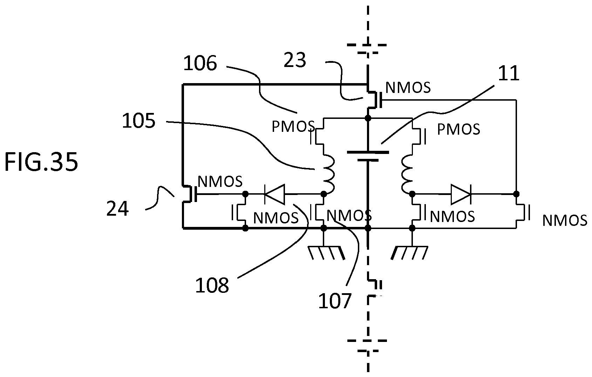

La figure 35 représente un mode de réalisation d'un circuit de commande des transistors 23, 24, via la décharge d'une inductance 105, auparavant chargée par la fermeture de deux transistors PMOS 106 et NMOS 107 qui l'encadrent. Quand l'inductance 105 est suffisamment chargée, le transistor NMOS 107 s'ouvre alors que le transistor PMOS 106 reste fermé. Le courant passe alors par la diode 108 puis va charger la grille du transistor de module 24, suffisamment pour induire son changement d'état.

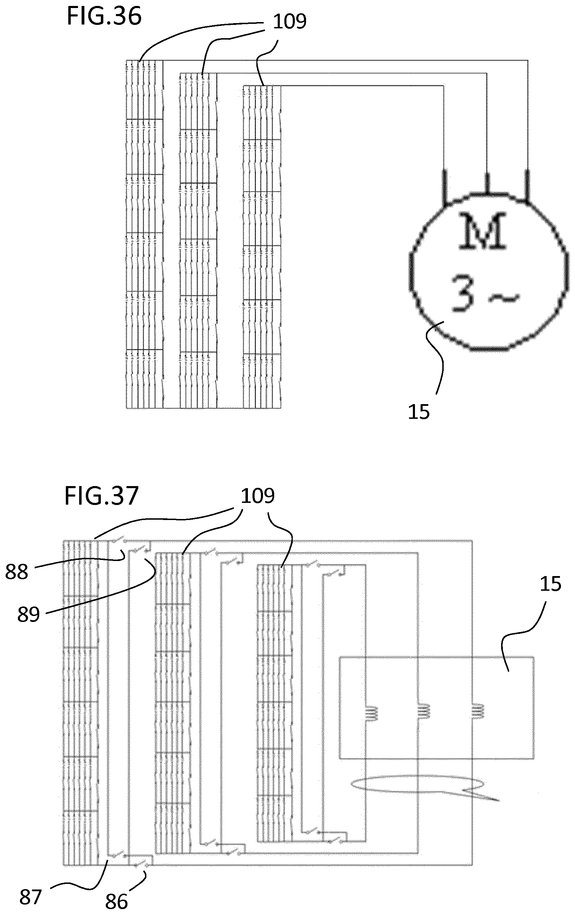

D'autre part, l'invention est aussi compatible avec une implémentation triphasée. La figure 36 illustre simplement un dispositif de génération d'énergie photovoltaïque comprenant trois colonnes 109, chacune d'architecture similaire à un dispositif de génération d'énergie photovoltaïque selon l'invention telle que décrite précédemment, permettant d'alimenter un moteur triphasé 15.

La figure 37 illustre une variante de réalisation d'un dispositif de génération d'énergie photovoltaïque adaptée pour délivrer une tension triphasée à un moteur triphasé 15, qui diffère de la réalisation précédente par le fait que chaque colonne 109 du dispositif de génération d'énergie photovoltaïque est équipée d'interrupteurs 86 à 89, avantageusement des transistors, pour réaliser des ponts en H tels qu'explicités en relation avec la figure 25. Ce pont en H permet de doubler la tension crête à crête de commande du moteur et par la même de diviser le courant de sortie par deux pour une même puissance de sortie (Ueff*leff=cste). Ces interrupteurs commutent deux fois par période, c'est-à-dire à chaque changement de signe de la tension de sortie. Cette architecture, par rapport à celle de la figure 36, permet d'éviter que le courant fourni par une colonne ne se déplace sous la forme d'un courant inverse dans une autre colonne à certains moments de la période. Dans cette solution, les trois bobinages du moteur triphasé 15 peuvent être alimentés de manière indépendante. Cette isolation peut permettre d'isoler galvaniquement chacune des colonnes 109 du dispositif de génération d'énergie photovoltaïque. Cette isolation peut notamment être utile si les trois colonnes 109 sont séparées en trois blocs de dispositif de génération d'énergie photovoltaïque physiquement réparties en différents endroits, par exemple au sein d'un véhicule pour des raisons de sécurité électrique.

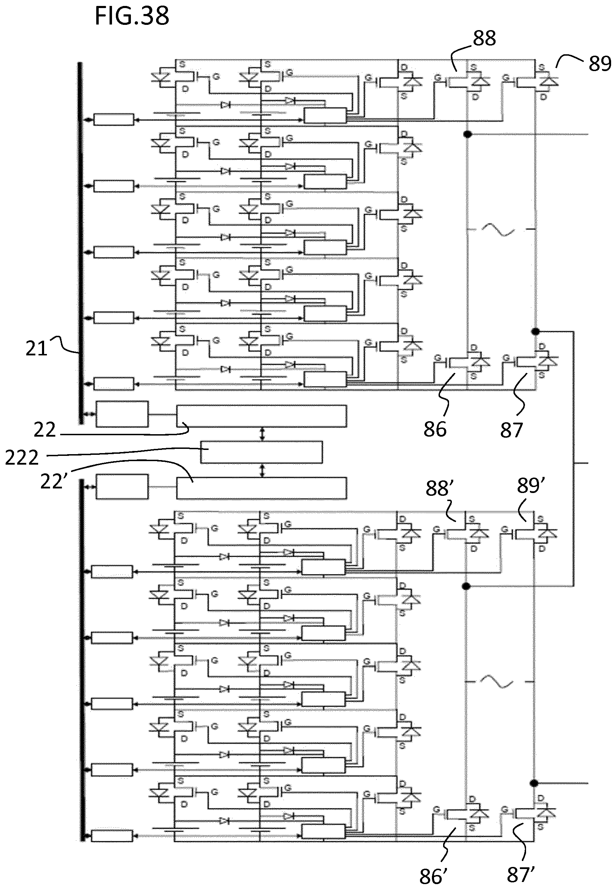

La figure 38 illustre une autre variante de réalisation permettant de fournir une alimentation triphasée. Le dispositif utilisé comprend le montage en série de deux structures ou deux colonnes de dispositif de génération d'énergie photovoltaïque telles que décrites en rapport avec la figure 25. Comme cela a été présenté, chaque colonne est adaptée pour restituer une tension de sortie alternative de type sinusoïdale. En appliquant un déphasage de 2π/3 sur les tensions restituées par ces deux colonnes, il est possible de récupérer en sortie du dispositif de génération d'énergie photovoltaïque une tension triphasée. En remarque, chaque colonne est reliée à son calculateur central 22, 22' par respectivement un bus de communication 21, 21' et ces deux calculateurs 22, 22' sont en liaison avec un calculateur principal 222 qui gère l'ensemble du dispositif de génération d'énergie photovoltaïque et notamment la coordination de ses deux colonnes.

Les trois calculateurs partagent ainsi la mise en œuvre du procédé de gestion d'un tel dispositif de génération d'énergie photovoltaïque. A titre d'exemple, le calculateur principal 222 détermine le nombre d'étage n1 et n2 à utiliser sur respectivement chacune des deux colonnes du dispositif de génération d'énergie photovoltaïque. Pour cela, une solution consiste à choisir les nombres n1 et n2 selon la règle suivante :
- n1 = arrondi à l'entier le plus proche de [(amplitude de la tension crête de consigne / tension d'un module) * sin (2πft)]
- n2 = arrondi à l'entier le plus proche de [(amplitude de la tension crête de consigne / tension d'un module) * sin (2πf t)]

Le calculateur définit une consigne de sortie souhaitée, incluant la fréquence f du signal et son amplitude. Dans le cas de l'utilisation du dispositif de génération d'énergie photovoltaïque pour alimenter un moteur, la tension et le courant de sortie et la vitesse du moteur peuvent être gérés selon une boucle d'asservissement. Les nombres n1 et n2 sont ajustés à tout instant t pour atteindre la consigne définie par cet asservissement.

En complément, les deux calculateurs 22, 22' dédiés à chaque colonne du dispositif de génération d'énergie photovoltaïque déterminent plus précisément les modules (et éventuellement les cellules) à utiliser pour respecter les nombres n1 et n2 définis tout en atteignant les valeurs de tension et de courant demandés. Ce choix est réalisé de sorte de respecter l'état des différents modules. Pour cela, chaque calculateur 22, 22' reçoit l'information de l'état de chaque module de sa colonne, ce qui permet de déterminer quels n1 et n2 modules sont précisément utilisés à chaque instant. Ainsi, les cellules qui permettent d'obtenir le courant demandé à court terme sont sélectionnées, et restent connectées jusqu'au passage par la crête de courant, ce qui évite les connexions et déconnexions trop nombreuses des modules. Les modules qui ne peuvent fournir qu'un courant plus faible ne sont alors utilisés que lorsque le courant crête demandé est inférieur à la capacité en courant de ces modules.

De plus, le calculateur principal 222 transmet aussi l'information du signe de la tension demandée, pour que chaque colonne positionne son pont en H en fonction. Selon une réalisation avantageuse, cette information est transmise à chaque colonne en modifiant le signe des nombres n1 et n2.

D'autre part, le procédé de gestion comprend aussi une étape de transmission au calculateur principal 222 de l'information de l'état de chaque module des deux colonnes. Il est ainsi possible de calculer le courant et la tension maximum que peut fournir le dispositif de génération d'énergie photovoltaïque pour en tenir compte lors de la gestion du dispositif de génération d'énergie photovoltaïque : en cas de besoin, le calculateur principal 222 peut ainsi mettre en œuvre une limitation du courant crête demandé ou absorbé, voire une limitation de la vitesse du moteur dans le cas d'une alimentation du moteur.

Finalement, toutes les réalisations de dispositifs de génération d'énergie illustrés précédemment montrent qu'il est possible d'utiliser différents types d'interrupteurs pour remplir des fonctions différentes et complémentaires parmi lesquels :
- des interrupteurs de cellule, pour connecter ou déconnecter une cellule particulière du dispositif ;
- des interrupteurs parallèles, pour by-passer ou non une cellule particulière du dispositif ;
- des interrupteurs de module, pour by-passer ou non un module du dispositif ;
- des interrupteurs pour by-passer ou non plusieurs modules simultanément du dispositif ;
- des interrupteurs pour inverser ou non la tension en sortie du dispositif ;
- des interrupteurs d'inversion série/parallèle pour disposer en série ou en parallèle certaines sous-parties du dispositif.

Selon une réalisation avantageuse, comme cela a été décrit, tous ces interrupteurs sont pilotés par un circuit de commande alimenté par au moins une cellule du dispositif lui-même, c'est-à-dire alimenté localement, sans recours à une alimentation extérieure. D'autre part, le pilotage d'un interrupteur est de préférence réalisé par un circuit de commande suffisamment proche, alimenté par au moins une cellule du module le plus proche ou à proximité, pour mettre en jeu des tensions d'un même ordre de grandeur entre le circuit de commande et l'interrupteur piloté, par exemple le transistor piloté. Pour cela, il est avantageusement choisi de piloter un interrupteur, dont une des bornes, de source ou drain dans le cas d'un transistor NMOS par exemple, est reliée à une tension d'un certain module par un circuit de commande alimenté par ce même module ou un module adjacent, plus exactement par au moins une cellule de l'un de ces modules. Plus généralement, il pourra être choisi tout circuit de commande dont la liaison d'alimentation se trouve sur un module dont la différence de potentiel avec les bornes de l'interrupteur ne dépasse pas un seuil prédéfini, qui risquerait d'endommager l'interrupteur, de créer une situation de risque électrique. Ce seuil est défini par des normes de sécurité et dépend du type d'interrupteur implémenté. Cette alimentation locale, de proximité, présente le second avantage de permettre l'utilisation de liaisons de pilotage de faible longueur entre le circuit de commande et l'interrupteur.

Ensuite, il faut noter que le circuit de commande doit permettre l'actionnement fiable des différents interrupteurs. Dans un cas où les différents modules présentent une différence de potentiel de 3V ou moins et que l'interrupteur est de type NMOS, un circuit de commande intègre de préférence un élévateur de tension (par exemple une pompe de charge) pour augmenter la tension présente sur ses bornes d'entrée, et utiliser en sortie une tension plus élevée pour l'actionnement des interrupteurs, en fonction de ces derniers. Dans le cas d'un transistor NMOS par exemple, il sera choisi d'alimenter sa grille par une tension telle que la différence de tension entre sa grille et sa source soit de l'ordre de 20 V, pour garantir un actionnement fiable.

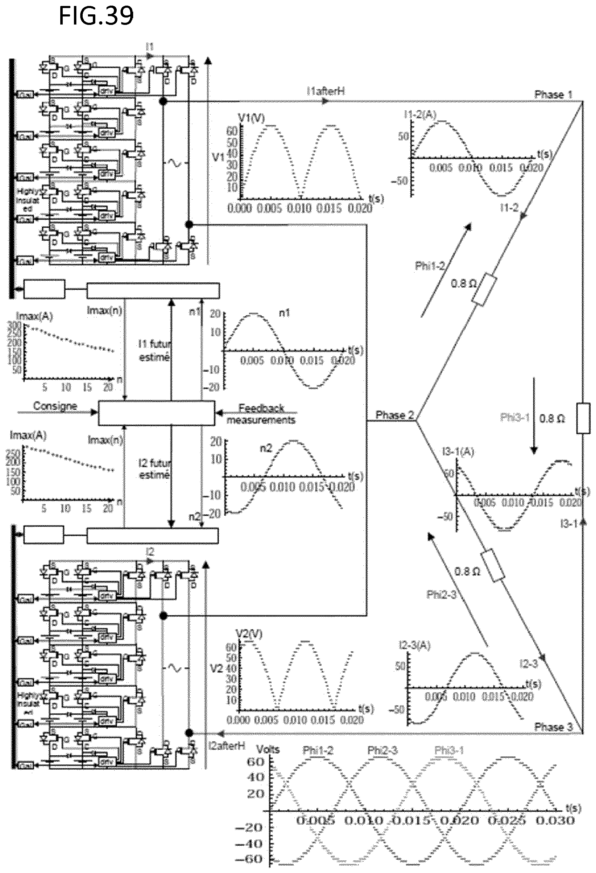

La figure 39 illustre ainsi un exemple d'utilisation d'un tel dispositif de génération d'énergie photovoltaïque appliquée à une charge résistive, avec certaines hypothèses de vieillissement et de perte de capacité de certains modules.

L'invention a été décrite avec des modes de réalisation dans lesquels chaque étage ou module est composé de cellules, associées à des interrupteurs pilotés par un circuit de commande. Toutefois, il est possible d'imaginer des variantes dans lesquelles toutes les cellules ne comprennent pas un interrupteur de cellule, et/ou dans lesquelles tous les modules ne sont pas pilotés, comme cela a été mentionné précédemment.

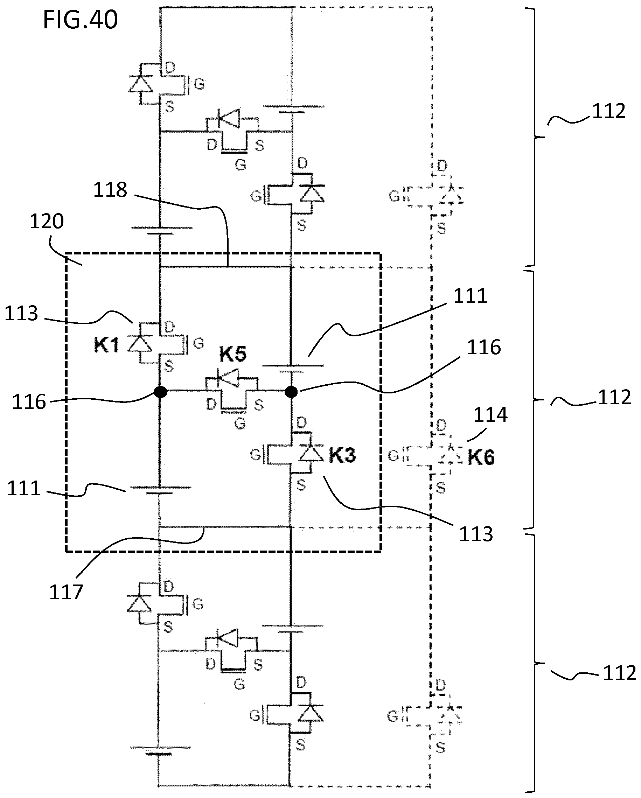

D'autre part, il a été vu qu'il est intéressant de pouvoir modifier le nombre de cellules en série ou en parallèle, pour s'adapter plus facilement au besoin en fonction de l'ensoleillement. Les figures 40 à 46 illustrent à cet effet d'autres réalisations de dispositifs de génération d'énergie photovoltaïque, dans lesquelles les cellules sont organisées différemment à l'intérieur des modules, pour faciliter la modification de leur nombre en série ou parallèle et s'adapter aux conditions d'ensoleillement et de demande d'une charge.

Ainsi, la figure 40 représente schématiquement un mode de réalisation de l'invention dans lequel un dispositif de génération d'énergie photovoltaïque comprend une multitude de cellules 111 organisées en plusieurs modules 112.

Dans ce mode de réalisation, chaque module 112 comprend une borne inférieure 117, reliée à un module voisin inférieur, et une borne supérieure 118 pour une liaison série avec le module voisin supérieur. Chaque module est composé de briques 120 disposées en parallèle entre ses deux bornes 117, 118. Dans ce mode de réalisation, chaque brique 120 comprend deux branches verticales s'étendant entre ses deux bornes inférieure 117 et supérieure 118, sur lesquelles sont respectivement disposés dans l'ordre suivant de bas en haut: une cellule 111 et un interrupteur K1 sur la première branche, et un interrupteur K3 et une cellule 111 sur la seconde branche. De plus, une branche transversale comprenant un troisième interrupteur K5 relie les deux bornes intermédiaires 116 disposées sur chacune des deux branches verticales entre la cellule 111 et l'interrupteur K1, K3.

Cette architecture permet à une brique 120 d'occuper les différentes configurations suivantes :
- si les interrupteurs K1 et K3 sont fermés et l'interrupteur K5 est ouvert, alors les deux cellules 111 de la brique sont disposées en parallèle : cette configuration permet d'obtenir le courant maximal par la brique ;
- si les interrupteurs K1 et K3 sont ouverts et K5 fermé, alors les deux cellules 111 de la brique sont disposées en série : cette configuration permet d'obtenir la tension maximale de la brique, et la tension maximale d'un module 112 ;
- si l'interrupteur K5 est ouvert et un seul des deux interrupteurs K1 ou K3 est fermé, alors une seule des deux cellules de la brique est active ;
- enfin, si tous les interrupteurs sont ouverts, les deux cellules de la brique sont déconnectées du reste du dispositif.

Il apparaît ainsi que cette architecture permet à chaque brique et donc chaque module de fournir une tension nulle, simple ou double, un courant disponible nul, simple ou double, simplement en choisissant la position des trois interrupteurs K1, K3, K5 disposés au niveau des cellules d'une brique. Pour cette raison, nous appellerons simplement « interrupteur de cellule 113 » par la suite ces trois interrupteurs.

Sur le mode de réalisation choisi, chaque module 112 comprend aussi un interrupteur K6 114 en parallèle des briques 120 du module 112, permettant ainsi de court-circuiter l'ensemble du module : pour cela, nous l'appellerons « interrupteur de module 114 » par la suite. Il est utile lorsque toutes les briques d'un module sont en configuration déconnectée. En remarque, dans ce mode de réalisation, la fermeture de l'interrupteur K6 nécessite que les interrupteurs K1 et K3 soient réversible en tension.

L'utilisation d'un tel dispositif de génération d'énergie photovoltaïque pour alimenter une charge, comme un moteur, permet de s'affranchir des convertisseurs intermédiaires utilisés dans l'état de la technique, comme cela a été explicité précédemment.

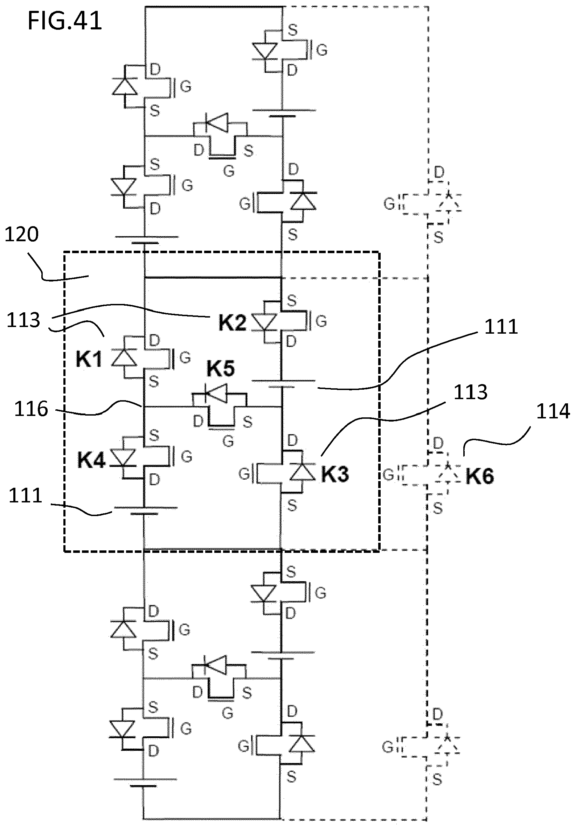

La figure 41 représente une variante de réalisation dans laquelle chaque brique 120 comprend deux interrupteurs K2, K4 supplémentaires, disposés sur chaque branche verticale du côté de la cellule 111 par rapport à la borne intermédiaire 116. Une telle architecture offre des configurations supplémentaires, en plus des configurations déjà explicitées en rapport avec la réalisation précédente. Elle permet notamment d'imposer une différence de tension nulle entre les deux bornes 117, 118 d'un module, en fermant les trois interrupteurs K1, K3, K5 et en ouvrant les deux autres interrupteurs K2, K4.

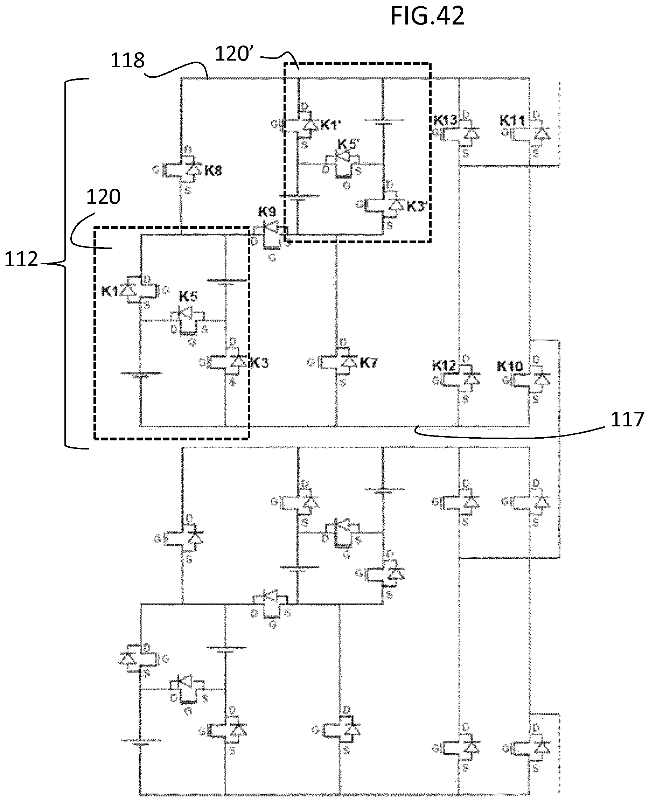

La figure 42 illustre une autre réalisation dans laquelle les briques présentées dans les réalisations précédentes sont associées deux par deux dans chaque module 112 afin de permettre la mise en série ou en parallèle de cellules quatre par quatre, et non plus deux par deux. En effet, deux briques 120, 120' sont reliées par trois branches et trois interrupteurs supplémentaires K7, K8, K9 disposés respectivement entre les deux bornes inférieures des deux briques, entre leurs deux bornes supérieures, et entre la borne supérieure de la première brique inférieure 120 et la borne inférieure de la seconde brique supérieure 120'.

Les trois interrupteurs supplémentaires dits « intermédiaires » K7, K8, K9 entre les deux briques 120, 120' peuvent occuper les configurations suivantes :
- K7 et K8 fermés, K9 ouvert : les deux briques 120, 120' sont disposées en parallèle entre les deux bornes 117, 118 du module ;
- K7, K8 ouverts, K9 fermé : les deux briques 120, 120' sont disposées en série entre les deux bornes 117, 118 du module.

Comme les cellules 111 de chaque brique 120, 120' peuvent elles-mêmes se trouver en série ou en parallèle, il apparaît que les configurations suivantes sont possibles :
- les quatre cellules 111 peuvent se trouver en parallèle entre les bornes 117, 118 du module ;
- les quatre cellules 111 peuvent se trouver en série entre les bornes 117, 118 du module ;
- deux ensembles de deux cellules en parallèle peuvent se trouver en série ;
- deux ensembles de deux cellules en série peuvent se trouver en parallèle.

En remarque, quatre interrupteurs K10, K11, K12 et K13 sont disposés sur la sortie du module. Ils permettent d'annuler la tension de sortie du module (entre les potentiels des connexions situées entre K10 et K11 et entre K12 et K13) sans nécessiter de transistors bidirectionnels au niveau de K1, K3, K1' et K3', en fermant K10 et K12 (K11 et K13 ouverts) ou en fermant K11 et K13 (K10 et K12 ouverts). Ces quatre transistors permettent par ailleurs d'inverser ou non la tension de sortie du module. Comme la tension maximale du module est relativement limitée (par exemple inférieure à 30 V), cela permet d'utiliser des transistors de faible tenue en tension, qui sont moins couteux et moins résistifs que des transistors qui devraient tenir la pleine tension du dispositif pour ne faire une inversion de tension qu'au niveau du dispositif. Chacun de ces modules équipés de leur inverseur de sortie sont ensuite placés en série et/ou parallèle pour atteindre les tensions/courants crête souhaités au niveau du dispositif.

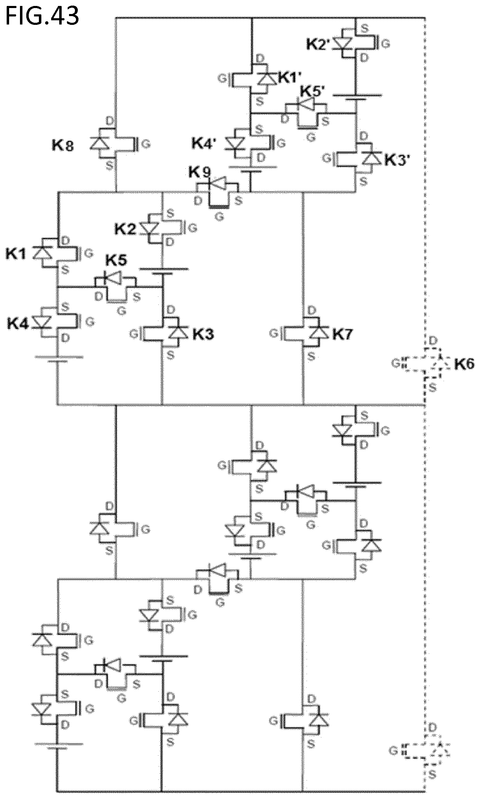

La figure 43 représente une variante de la réalisation précédente, dans laquelle chaque brique comprend cinq interrupteurs de cellule 113 K1, K2, K3, K4, K5, de manière similaire à la réalisation illustrée sur la figure 41. D'autre part, les modules sont simplement disposés en série, sans les interrupteurs K10 à K13 prévus dans la réalisation précédente.

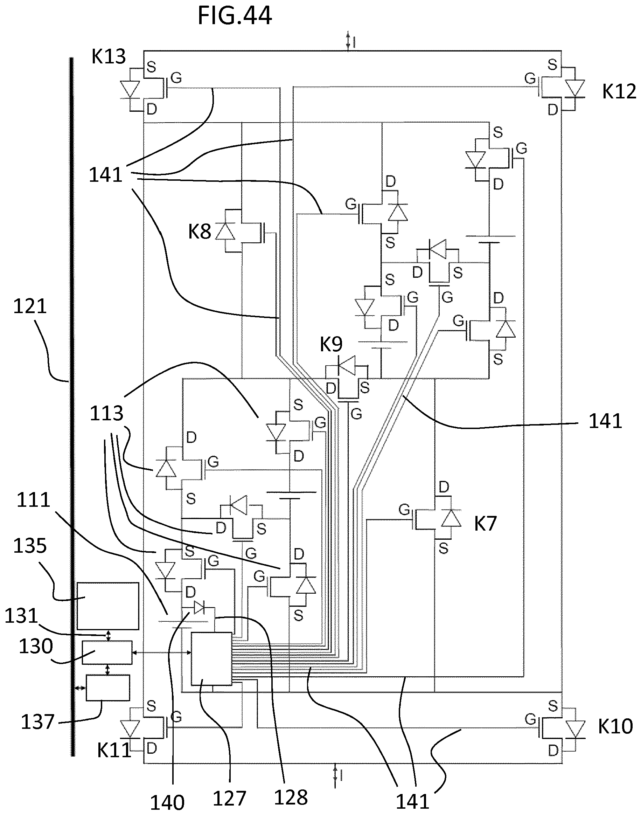

La figure 44 montre de manière schématique l'architecture prévue au niveau d'un module pour la gestion d'un tel dispositif de génération d'énergie photovoltaïque. Cette même architecture de gestion peut aisément être implémentée sur toutes les autres réalisations de dispositif de génération d'énergie photovoltaïque.

Un ou plusieurs capteurs de mesure, non représentés, pour mesurer par exemple la température, la tension et/ou le courant, sont prévus pour chaque cellule du module 112 et communiquent leurs mesures à une unité de mesure 135. Les mesures effectuées par ce ou ces capteurs sont transmises à un circuit de traitement 130 local, via un multiplexeur par exemple, par des voies de communications non représentées. Le circuit de traitement 130 reçoit ainsi ces données par une voie communication 131 effectuant une numérisation, de type « ADC input » ; ou en variante, ces signaux arrivent déjà numérisés, cette numérisation étant réalisée au niveau du multiplexeur. Selon une réalisation possible, le circuit de traitement 130 peut être un microcontrôleur disposant d'un nombre d'entrée/sortie suffisant pour interroger l'ensemble des capteurs. Tous les transistors utilisés pour former les interrupteurs de cellule 113, pour former le dispositif d'inversion série/parallèle entre les briques du module (K7, K8, K9), et pour former le dispositif d'inversion série/parallèle avec les modules adjacents (K10 à K13), sont pilotés par un circuit de commande 127 qui leur transmet des signaux de commande 141, sous les ordres du circuit de traitement 130. Enfin, ce dernier est relié au calculateur central par le bus de communication 121 et par l'intermédiaire d'une interface 137 formant une isolation galvanique. Tous ces composants associés à un seul module sont alimentés par la tension d'au moins une des cellules 111 du module 112, selon les solutions explicitées lors des modes de réalisation précédents, par exemple par l'intermédiaire d'une liaison 128 et d'une diode 140. Comme dans le cas de la figure 42, il est possible d'imaginer une variante de réalisation sans les transistors K2, K4, K2' et K4' représentés sur la figure 43.

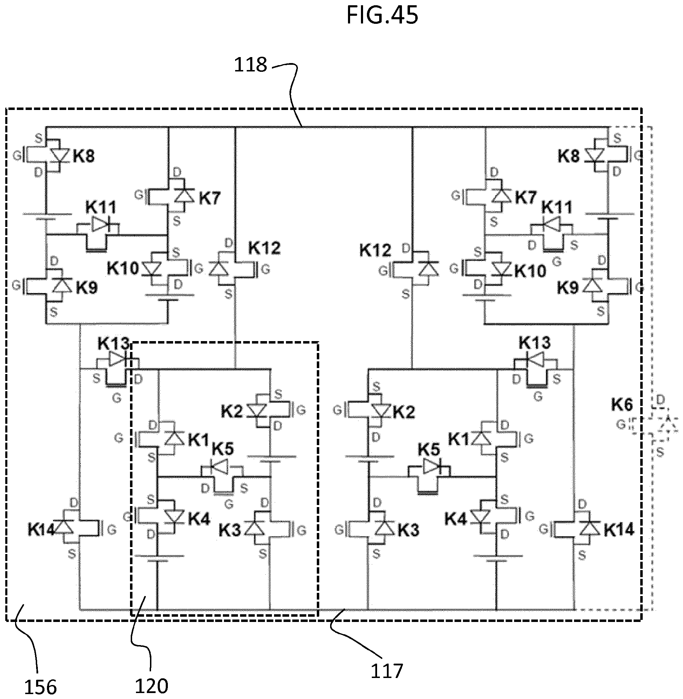

La figure 45 illustre une autre réalisation d'un dispositif de génération d'énergie photovoltaïque dont un module comprend l'association de quatre briques 120 telles que présentées précédemment, pour former une structure de base de quatre briques que nous appellerons « superbrique » 156. Cette superbrique comprend une première brique reliée à la borne inférieure 117 du module, et reliée à une seconde brique reliée à la borne supérieure 118 du module par l'intermédiaire de trois interrupteurs K12, K13, K14 permettant de disposer ces deux briques en série ou en parallèle, selon un fonctionnement explicité précédemment. Cette même association de deux briques est disposée entre les deux bornes inférieure 117 et supérieure 118 du module en parallèle des deux briques décrites précédemment. Ces quatre briques forment ensemble une superbrique, qui sert de base à l'architecture du dispositif de génération d'énergie photovoltaïque. Ce dernier comprend donc une multitude d'autres superbriques, non représentées, disposées sur le même module en parallèle de la superbrique illustrée et/ou sur les autres modules. Cette superbrique offre une multitude de possibilités pour agencer huit cellules, soit toutes en parallèle, soit en deux branches verticales parallèles de quatre cellules en série chacune, soit selon des configurations intermédiaires comme quatre branches verticales de deux cellules en série chacune par exemple.

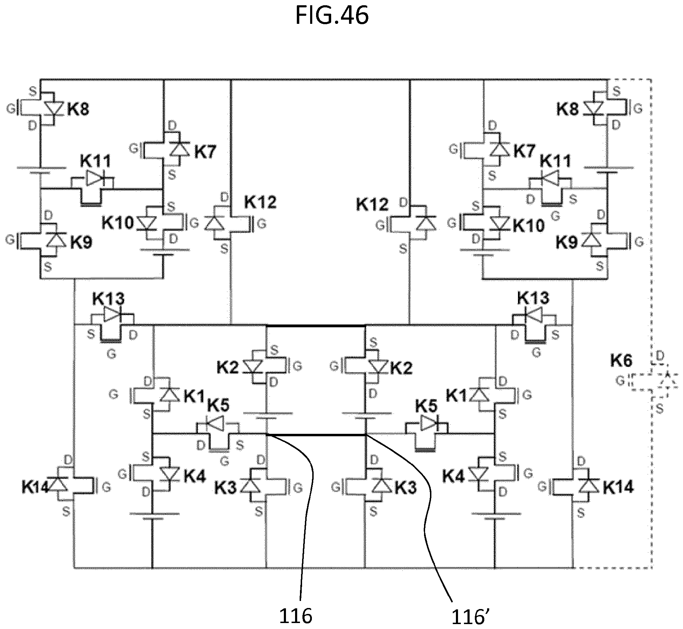

La figure 46 présente une variante de la réalisation précédente dans laquelle deux bornes intermédiaires 116, 116' des deux briques inférieures de la superbrique sont reliées, ainsi que les deux bornes supérieures de ces deux mêmes briques. Cette configuration offre la possibilité supplémentaire de mettre en série une cellule d'une des deux briques inférieures avec une cellule de l'autre brique par exemple.

En variante, d'autres liaisons entre les quatre briques de la superbrique peuvent être implémentées, comme une liaison entre des bornes intermédiaires des deux briques supérieures, de manière similaire au schéma choisi pour les deux briques inférieures, et/ou une liaison entre les autres bornes intermédiaires des deux briques inférieures, etc.

Naturellement, ces modes de réalisation décrits en référence avec les figures 40 à 46 peuvent être gérés par le procédé de génération d'énergie photovoltaïque décrit précédemment. De plus, les dispositifs illustrés peuvent être combinés entre eux pour proposer d'autres variantes de réalisation.

De manière fractale, on peut associer autant de briques que souhaité pour assurer des mises en série ou parallèle d'un nombre de cellules souhaité. Par exemple, en reprenant l'exemple de la figure 42, il est possible de placer les deux sous ensembles de deux briques élémentaires en série ou parallèle via les transistors K7, K8 et K9. Il est possible d'étendre ce principe en remontant à chaque fois d'un niveau en associant deux groupes de quatre briques élémentaires via des transistors K7', K8' et K9' puis K7", K8" et K9", etc., pour former un module contenant un nombre plus important de cellules complètement commutables en série/parallèle et permettant de générer une tension de sortie variable par pas d'une tension de cellule élémentaire (de la tension d'une cellule élémentaire à la tension correspondant à l'ensemble des cellules en série). Si on place de plus un inverseur de tension en sortie, le module peut prendre une tension de sortie allant de plus ou moins la tension de toutes les cellules en séries, par pas de tension d'une cellule.

## Revendications

1. Dispositif de génération d'énergie photovoltaïque comprenant plusieurs modules (12 ; 112) disposés en série, **caractérisé en ce qu'**il comprend au moins un module (12 ; 112) comprenant plusieurs cellules (11 ; 111) disposées en parallèle associées chacune à au moins un interrupteur de cellule (13 ; 113) qui lui est propre, disposé en série, de sorte à pouvoir les déconnecter du reste du dispositif de génération d'énergie photovoltaïque, chacune de ces cellules (11 ; 111) disposées en parallèle comprenant une cellule photovoltaïque (7) comprenant une ou plusieurs cellule(s) photovoltaïque(s) élémentaire(s), et un élément de stockage (8) connecté aux bornes de la cellule photovoltaïque.

2. Dispositif de génération d'énergie photovoltaïque selon la revendication précédente, **caractérisé en ce qu'**il comprend au moins un module (12 ; 112) comprenant plusieurs cellules (11 ; 111) disposées en parallèle et plusieurs interrupteurs parallèles (44) connectés en parallèle avec au moins une cellule dudit module (12 ; 112).

3. Dispositif de génération d'énergie photovoltaïque selon la revendication 2, **caractérisé en ce que** ledit au moins un module (12 ; 112) comprend une borne inférieure (17 ; 117) apte à une connexion avec un module inférieur et une borne supérieure (18 ; 118) apte à une connexion avec un module supérieur, et **en ce qu'**il comprend plusieurs branches entre sa borne inférieure (17 ; 117) et sa borne supérieure (18 ; 118) comprenant chacune au moins une cellule (11 ; 111) et un interrupteur de cellule (13 ; 113) disposés en série et plusieurs autres branches parallèles entre sa borne inférieure (17 ; 117) et sa borne supérieure (18 ; 118) comprenant chacune un interrupteur parallèle (44).

4. Dispositif de génération d'énergie photovoltaïque selon l'une des revendications précédentes, **caractérisé en ce qu'**il comprend un agencement de briques (120) comprenant deux branches parallèles comprenant respectivement une cellule (111) et au moins un interrupteur de cellule (113) et au moins un interrupteur de cellule (113) et une cellule (111), et comprenant une branche transversale reliant les deux bornes intermédiaires (116) de respectivement lesdites deux branches parallèles, cette branche transversale comprenant un interrupteur de cellule (113).

5. Dispositif de génération d'énergie photovoltaïque selon l'une des revendications précédentes, **caractérisé en ce qu'**il comprend plusieurs modules (12 ; 112) disposés en série comprenant chacun plusieurs cellules (11 ; 111) disposées en parallèle et/ou série, chaque cellule (11 ; 111) étant associée à au moins un interrupteur de cellule (13 ; 113) et chaque cellule (11 ; 111) comprenant une cellule photovoltaïque (7), comprenant une ou plusieurs cellule(s) photovoltaïque(s) élémentaire(s), et un élément de stockage (8) connecté aux bornes de la cellule photovoltaïque.

6. Dispositif de génération d'énergie photovoltaïque selon l'une des revendications précédentes, **caractérisé en ce qu'**il comprend au moins une carte électronique (20) comprenant :
- des bornes (38, 16) pour une liaison avec des cellules (11 ; 111) du dispositif de génération d'énergie photovoltaïque, et
- des interrupteurs de cellules (13 ; 113), et/ou
- des interrupteurs parallèles (44), et/ou
- des interrupteurs de module (14 ; 114).

7. Dispositif de génération d'énergie photovoltaïque selon la revendication précédente, **caractérisé en ce qu'**il comprend au moins une carte électronique (20) intégrée au panneau photovoltaïque ou rattachée à la structure support du panneau photovoltaïque, notamment disposée sous la surface des cellules photovoltaïques, à l'opposé de leur face supérieure recevant un flux de lumière (39), de sorte que ses bornes (38, 16) de connexion avec les cellules (11 ; 111) se trouvent positionnées au plus proche des bornes des cellules de façon à réduire au maximum la longueur des connexions et donc les pertes associées.

8. Dispositif de génération d'énergie photovoltaïque selon la revendication 6 ou 7, **caractérisé en ce qu'**il comprend au moins une carte électronique (20) disposée de sorte à minimiser les chemins de puissance et/ou à optimiser la section de conducteur, notamment en renforçant les pistes du circuit imprimé formant ladite carte électronique (20) en leur ajoutant un renfort conducteur électrique (19) par-dessus, comme une baguette ou un fil conducteur.

9. Dispositif de génération d'énergie photovoltaïque selon la revendication précédente, **caractérisé en ce qu'**il comprend des trous réalisés au travers d'au moins une carte électronique (20) pour faciliter la circulation d'air et le refroidissement des cellules (11 ; 111) et des composants électroniques.

10. Dispositif de génération d'énergie photovoltaïque selon l'une des revendications précédentes, **caractérisé en ce qu'**il comprend au moins un capteur de mesure (33, 35, 36) d'une grandeur caractéristique de l'état d'une cellule (11 ; 111), et **en ce qu'**il comprend, au niveau d'un module (12 ; 112), un circuit de commande (27 ; 127) d'au moins un interrupteur de cellule (13 ; 113) et/ou d'un interrupteur parallèle (44) pour le commander en fonction de la grandeur caractéristique de l'état de la cellule.

11. Dispositif de génération d'énergie photovoltaïque selon l'une des revendications précédentes, **caractérisé en ce qu'**il comprend plusieurs cellules (11 ; 111) associées chacune à au moins un interrupteur de cellule (13 ; 113) et/ou un interrupteur parallèle (44), commandé(s) par un ou plusieurs circuit(s) de commande alimenté(s) électriquement directement par au moins une cellule (11 ; 111) d'un module du dispositif de génération d'énergie photovoltaïque.

12. Dispositif de génération d'énergie photovoltaïque selon l'une des revendications précédentes, **caractérisé en ce qu'**il comprend au moins un circuit de traitement (30 ; 130) au niveau d'un module (12 ; 112) ou d'une brique (120) et/ou un calculateur central (22 ; 122 ; 222), qui pilote(nt) des interrupteurs de cellule (13 ; 113) ou de module (14 ; 114) ou parallèles (34) par l'intermédiaire d'un circuit de commande (27 ; 127).

13. Dispositif de génération d'énergie photovoltaïque selon la revendication précédente, **caractérisé en ce que** le circuit de commande (27 ; 127) et/ou un circuit de traitement (30 ; 130) d'au moins un interrupteur (13 ; 113 ; 14 ; 114 ; 44) est alimenté par au moins une cellule (11 ; 111) du module (12 ; 112) ou d'un module voisin ou de la brique (120) ou d'une brique (120) voisine de l'interrupteur de cellule qu'il pilote.

14. Dispositif de génération d'énergie photovoltaïque selon l'une des revendications précédentes, **caractérisé en ce que** l'interrupteur de cellule (13 ; 113) et/ou de module (14 ; 114) et/ou parallèle (44) est un transistor (23 ; 24 ; 34) et/ou **en ce que** l'élément de stockage (8) comprend au moins un condensateur.

15. Dispositif de génération d'énergie photovoltaïque selon l'une des revendications précédentes, **caractérisé en ce qu'**il comprend trois colonnes (109) comprenant chacune plusieurs modules disposés en série pour fournir une sortie triphasée.

16. Procédé de gestion d'un dispositif de génération d'énergie photovoltaïque selon l'une des revendications précédentes, **caractérisé en ce qu'**il comprend une étape de détermination de la position de plusieurs interrupteurs de cellule (13 ; 113) et/ou de plusieurs interrupteurs parallèles (44) de plusieurs cellules (11 ; 111) disposées en parallèle pour maintenir les cellules dans un état de fonctionnement dans une plage autour d'un point de fonctionnement optimal.

17. Procédé de gestion d'un dispositif de génération d'énergie photovoltaïque selon la revendication précédente, **caractérisé en ce que** la position d'au moins un interrupteur de cellule (13 ; 113) et/ou d'au moins un interrupteur parallèle (44) maintient une cellule (13 ; 113) dans un état de fonctionnement dans une plage de plus ou mois 5% autour d'un point de fonctionnement optimal.

18. Procédé de gestion d'un dispositif de génération d'énergie photovoltaïque selon la revendication 16 ou 17, **caractérisé en ce qu'**il comprend les étapes suivantes :
- lorsque la tension aux bornes d'une cellule dépasse une tension optimale correspondant au point de fonctionnement optimal, augmentée d'un pourcentage prédéfini, au moins un interrupteur de cellule et/ou parallèle est actionné pour permettre son utilisation pour produire une tension et un courant vers la sortie du dispositif, et/ou
- lorsque la tension aux bornes d'une cellule descend sous cette tension optimale diminuée d'un pourcentage prédéfini, au moins un interrupteur de cellule et/ou parallèle est actionné, de sorte qu'elle ne participe plus à la production de tension et de courant en sortie du dispositif.

19. Procédé de gestion d'un dispositif de génération d'énergie photovoltaïque selon l'une des revendications 16 à 18, **caractérisé en ce qu'**il comprend une étape de charge d'un élément de stockage (8) par une cellule photovoltaïque (7) pendant sa déconnexion du reste du dispositif.

20. Procédé de gestion d'un dispositif de génération d'énergie photovoltaïque selon l'une des revendications 16 à 19, **caractérisé en ce qu'**il comprend une étape de comparaison de l'état réel d'une cellule (11 ; 111) avec un état de fonctionnement optimal, mémorisé préalablement dans une mémoire électronique, ou une étape de recherche des conditions optimales de fonctionnement de la cellule.

21. Procédé de gestion d'un dispositif de génération d'énergie photovoltaïque selon l'une des revendications 16 à 20, **caractérisé en ce qu'**il comprend la mise en œuvre des étapes suivantes :
- mesure d'une grandeur représentative de l'état d'une cellule et transmission de la grandeur mesurée à au moins un calculateur ;
- détermination de la position d'un interrupteur de cellule et/ou de module et/ou parallèle en prenant en compte la grandeur mesurée ;
- transmission d'une commande d'ouverture ou fermeture d'un interrupteur de cellule et/ou de module et/ou parallèle en fonction de la détermination précédente.

22. Procédé de gestion d'un dispositif de génération d'énergie photovoltaïque selon la revendication précédente, **caractérisé en ce qu'**il comprend une étape consistant à diagnostiquer une défaillance et/ou un état à risque d'une cellule, en reconnaissant les cellules défectueuses, comme en surchauffe suite à une situation de court-circuit, entrée d'humidité, d'arc électrique, de flamme, de défaut d'isolement, à partir de la grandeur mesurée au niveau d'une cellule, afin de déconnecter ou écarter du fonctionnement global du dispositif de génération d'énergie photovoltaïque la cellule concernée, en ouvrant son interrupteur de cellule et/ou en fermant l'interrupteur de module et/ou parallèle concerné.

23. Procédé de gestion de dispositif de génération d'énergie photovoltaïque selon l'une des revendications 16 à 22, **caractérisé en ce qu'**il met en œuvre les étapes suivantes :
- équilibrage des modules et/ou cellules entre eux, en utilisant en priorité les modules et/ou cellules dont la tension est la plus forte; et/ou
- équilibrage des modules et/ou cellules en modifiant le taux moyen d'utilisation des modules et/ou cellules, mais sans utiliser les mêmes modules et/ou cellules en permanence, de sorte que la tension des modules et/ou cellules s'équilibre.

24. Procédé de gestion d'un dispositif de génération d'énergie photovoltaïque selon l'une des revendications 16 à 23, **caractérisé en ce qu'**il comprend une étape d'alimentation électrique d'un circuit de commande (27 ; 127) d'un interrupteur de cellule (13 ; 113) et/ou d'un interrupteur parallèle (44) à partir d'au moins une cellule (11 ; 111) du dispositif de génération d'énergie photovoltaïque.

25. Procédé de gestion d'un dispositif de génération d'énergie photovoltaïque selon la revendication précédente, **caractérisé en ce qu'**il comprend une étape d'alimentation électrique de tous les autres composants électroniques internes au dispositif de génération d'énergie photovoltaïque nécessitant une alimentation par au moins une cellule du dispositif de génération d'énergie photovoltaïque.

26. Procédé de gestion d'un dispositif de génération d'énergie photovoltaïque selon l'une des revendications 16 à 25, **caractérisé en ce qu'**il comprend une étape de communication par courant porteur entre un circuit de traitement (30 ; 130) d'un module (12 ; 112) et celui d'un autre module ou un calculateur central (22 ; 122) ou une charge (15).

27. Procédé de gestion d'un dispositif de génération d'énergie photovoltaïque selon l'une des revendications 16 à 26, **caractérisé en ce qu'**il comprend une étape de régulation de la tension de sortie du dispositif de génération d'énergie photovoltaïque qui comprend une étape d'ouverture/fermeture d'interrupteurs de cellules (13 ; 113) et/ou d'un interrupteur parallèle (34) du dispositif de génération d'énergie photovoltaïque pour suivre une consigne de tension de sortie imposée, notamment une consigne variable avec le temps comme de forme sinusoïdale.

28. Procédé de gestion d'un dispositif de génération d'énergie photovoltaïque selon l'une des revendications 16 à 27, **caractérisé en ce qu'**il comprend une étape de déconnexion de toutes les cellules du dispositif de génération d'énergie photovoltaïque en cas d'arrêt prolongé du dispositif de génération d'énergie photovoltaïque ou d'incident.

29. Procédé de gestion d'un dispositif de génération d'énergie photovoltaïque selon l'une des revendications 16 à 28, **caractérisé en ce qu'**il comprend une étape de diagnostic du fonctionnement de tout ou partie des interrupteurs de cellules et/ou de modules et/ou parallèles.

30. Procédé de gestion d'un dispositif de génération d'énergie photovoltaïque selon l'une des revendications 16 à 29, **caractérisé en ce qu'**il comprend une étape d'identification des caractéristiques d'au moins une cellule photovoltaïque et/ou de l'ensoleillement en ouvrant sur une période prédéfinie au moins un interrupteur de cellule (13 ; 113) pour mesurer la tension à vide de la cellule photovoltaïque ou en fermant au moins un interrupteur de cellule (13 ; 113) et un interrupteur parallèle ou de module de sorte à disposer la cellule photovoltaïque en court-circuit pour mesurer le courant en court-circuit de ladite cellule photovoltaïque.

## Patentansprüche

1. Vorrichtung zur Erzeugung von photovoltaischer Energie, welche mehrere in Reihe angeordnete Module (12; 112) umfasst, **dadurch gekennzeichnet, dass** sie wenigstens ein Modul (12; 112) umfasst, das mehrere parallel angeordnete Zellen (11; 111) umfasst, die jeweils wenigstens einem ihnen eigenen Zellenschalter (13; 113) zugeordnet sind, der in Reihe angeordnet ist, so dass er sie vom Rest der Vorrichtung zur Erzeugung von photovoltaischer Energie trennen kann, wobei jede dieser parallel angeordneten Zellen (11; 111) eine photovoltaische Zelle (7), die eine oder mehrere elementare photovoltaische Zellen umfasst, und ein Speicherelement (8), das mit den Anschlüssen der photovoltaischen Zelle verbunden ist, umfasst.

2. Vorrichtung zur Erzeugung von photovoltaischer Energie nach dem vorhergehenden Anspruch, **dadurch gekennzeichnet, dass** sie wenigstens ein Modul (12; 112) umfasst, das mehrere parallel angeordnete Zellen (11; 111) und mehrere parallele Schalter (44), die mit wenigstens einer Zelle des Moduls (12; 112) parallel geschaltet sind, umfasst.

3. Vorrichtung zur Erzeugung von photovoltaischer Energie nach Anspruch 2, **dadurch gekennzeichnet, dass** das wenigstens eine Modul (12; 112) einen unteren Anschluss (17; 117), der für eine Verbindung mit einem unteren Modul geeignet ist, und einen oberen Anschluss (18; 118), der für eine Verbindung mit einem oberen Modul geeignet ist, umfasst, und dadurch, dass es mehrere Zweige zwischen seinem unteren Anschluss (17; 117) und seinem oberen Anschluss (18; 118) umfasst, die jeweils eine Zelle (11; 111) und einen Zellenschalter (13; 113), die in Reihe angeordnet sind, umfassen, und mehrere weitere parallele Zweige zwischen seinem unteren Anschluss (17; 117) und seinem oberen Anschluss (18; 118), die jeweils einen parallelen Schalter (44) umfassen.

4. Vorrichtung zur Erzeugung von photovoltaischer Energie nach einem der vorhergehenden Ansprüche, **dadurch gekennzeichnet, dass** sie eine Anordnung von Ziegeln (120) umfasst, die zwei parallele Zweige umfasst, die eine Zelle (111) und wenigstens einen Zellenschalter (113) bzw. wenigstens einen Zellenschalter (113) und eine Zelle (111) umfassen, und die einen Querzweig umfasst, der die zwei Zwischenanschlüsse (116) jeweils eines der zwei parallelen Zweige verbindet, wobei dieser Querzweig einen Zellenschalter (113) umfasst.

5. Vorrichtung zur Erzeugung von photovoltaischer Energie nach einem der vorhergehenden Ansprüche, **dadurch gekennzeichnet, dass** sie mehrere in Reihe angeordnete Module (12; 112) umfasst, die jeweils mehrere parallel und/oder in Reihe angeordnete Zellen (11; 111) umfassen, wobei jede Zelle (11; 111) wenigstens einem Zellenschalter (13; 113) zugeordnet ist und jede Zelle (11; 111) eine photovoltaische Zelle (7), die eine oder mehrere elementare photovoltaische Zellen umfasst, und ein Speicherelement (8), das mit den Anschlüssen der photovoltaischen Zelle verbunden ist, umfasst.

6. Vorrichtung zur Erzeugung von photovoltaischer Energie nach einem der vorhergehenden Ansprüche, **dadurch gekennzeichnet, dass** sie wenigstens eine Leiterplatte (20) umfasst, welche umfasst:
- Anschlüsse (38, 16) für eine Verbindung mit Zellen (11; 111) der Vorrichtung zur Erzeugung von photovoltaischer Energie, und
- Zellenschalter (13; 113), und/oder
- parallele Schalter (44), und/oder
- Modulschalter (14; 114).

7. Vorrichtung zur Erzeugung von photovoltaischer Energie nach dem vorhergehenden Anspruch, **dadurch gekennzeichnet, dass** sie wenigstens eine Leiterplatte (20) umfasst, die in das Photovoltaikpanel integriert oder an der Stützkonstruktion des Photovoltaikpanels angebracht ist, insbesondere unter der Oberfläche der photovoltaischen Zellen angeordnet ist, gegenüber von deren Oberseite, die einen Lichtstrom (39) empfängt, so dass ihre Anschlüsse (36, 16) zur Verbindung mit den Zellen (11; 111) so nahe wie möglich bei den Anschlüssen der Zellen positioniert sind, um so die Länge der Verbindungen und somit die entsprechenden Verluste maximal zu verringern.

8. Vorrichtung zur Erzeugung von photovoltaischer Energie nach Anspruch 6 oder 7, **dadurch gekennzeichnet, dass** sie wenigstens eine Leiterplatte (20) umfasst, die so angeordnet ist, dass sie die Leistungspfade minimiert und/oder den Leiterquerschnitt optimiert, insbesondere indem die Leiterbahnen der gedruckten Schaltung, welche die Leiterplatte (20) bildet, verstärk werden, indem ihnen von oben eine elektrisch leitende Verstärkung (19) hinzugefügt wird, wie etwa ein Stab oder ein Leitungsdraht.

9. Vorrichtung zur Erzeugung von photovoltaischer Energie nach dem vorhergehenden Anspruch, **dadurch gekennzeichnet, dass** sie Löcher umfasst, die durch wenigstens eine Leiterplatte (20) hindurch ausgebildet sind, um die Zirkulation von Luft und die Kühlung der Zellen (11; 111) und der elektronischen Komponenten zu erleichtern.

10. Vorrichtung zur Erzeugung von photovoltaischer Energie nach einem der vorhergehenden Ansprüche, **dadurch gekennzeichnet, dass** sie wenigstens einen Sensor zur Messung (33, 35, 36) einer charakteristischen Größe des Zustands einer Zelle (11; 111) umfasst, und dadurch, dass sie an einem Modul (12; 112) eine Schaltung zur Steuerung (27; 127) wenigstens eines Zellenschalters (13; 113) und/oder eines parallelen Schalters (44) umfasst, um ihn in Abhängigkeit von der charakteristischen Größe des Zustands der Zelle zu steuern.

11. Vorrichtung zur Erzeugung von photovoltaischer Energie nach einem der vorhergehenden Ansprüche, **dadurch gekennzeichnet, dass** sie mehrere Zellen (11; 111) umfasst, die jeweils wenigstens einem Zellenschalter (13; 113) und/oder einem parallelen Schalter (44) zugeordnet sind, der (die) von einer oder mehreren Steuerschaltung(en) gesteuert wird (werden), die direkt von wenigstens einer Zelle (11; 111) eines Moduls der Vorrichtung zur Erzeugung von photovoltaischer Energie mit Strom versorgt wird (werden).

12. Vorrichtung zur Erzeugung von photovoltaischer Energie nach einem der vorhergehenden Ansprüche, **dadurch gekennzeichnet, dass** sie wenigstens eine Verarbeitungsschaltung (30; 130) an einem Modul (12; 112) oder einem Ziegel (120) und/oder einen Zentralrechner (22; 122; 222) umfasst, die (der) Zellenschalter (13; 113) oder Modulschalter (14; 114) oder parallele Schalter (34) über eine Steuerschaltung (27; 127) ansteuert (ansteuern).

13. Vorrichtung zur Erzeugung von photovoltaischer Energie nach dem vorhergehenden Anspruch, **dadurch gekennzeichnet, dass** die Steuerschaltung (27; 127) und/oder eine Verarbeitungsschaltung (30; 130) wenigstens eines Schalters (13; 113; 14; 114; 44) von wenigstens einer Zelle (11; 111) des Moduls (12; 112) oder eines benachbarten Moduls oder des Ziegels (120) oder eines benachbarten Ziegels (120) des Schalters der Zelle, welchen sie ansteuert, mit Strom versorgt wird.

14. Vorrichtung zur Erzeugung von photovoltaischer Energie nach einem der vorhergehenden Ansprüche, **dadurch gekennzeichnet, dass** der Zellenschalter (13; 113) und/oder Modulschalter (14; 114) und/oder parallele Schalter (44) ein Transistor (23; 24; 34) ist, und/oder dadurch, dass das Speicherelement (8) wenigstens einen Kondensator umfasst.

15. Vorrichtung zur Erzeugung von photovoltaischer Energie nach einem der vorhergehenden Ansprüche, **dadurch gekennzeichnet, dass** sie drei Spalten (109) umfasst, die jeweils mehrere in Reihe angeordnete Module umfassen, um einen dreiphasigen Ausgang zu liefern.

16. Verfahren zur Verwaltung einer Vorrichtung zur Erzeugung von photovoltaischer Energie nach einem der vorhergehenden Ansprüche, **dadurch gekennzeichnet, dass** es einen Schritt der Bestimmung der Position mehrerer Zellenschalter (13; 113) und/oder mehrerer paralleler Schalter (44) mehrerer parallel angeordneter Zellen (11; 111) zum Halten der Zellen in einem Betriebszustand in einem Bereich um einen optimalen Betriebspunkt umfasst.

17. Verfahren zur Verwaltung einer Vorrichtung zur Erzeugung von photovoltaischer Energie nach dem vorhergehenden Anspruch, **dadurch gekennzeichnet, dass** die Position wenigstens eines Zellenschalters (13; 113) und/oder wenigstens eines parallelen Schalters (44) eine Zelle (13; 113) in einem Betriebszustand in einem Bereich von plus oder minus 5 % um einen optimalen Betriebspunkt hält.

18. Verfahren zur Verwaltung einer Vorrichtung zur Erzeugung von photovoltaischer Energie nach Anspruch 16 oder 17, **dadurch gekennzeichnet, dass** es die folgenden Schritte umfasst:
- Wenn die Spannung an den Anschlüssen einer Zelle eine dem optimalen Betriebspunkt entsprechende optimale Spannung, erhöht um einen vordefinierten prozentualen Wert, überschreitet, wird wenigstens ein Zellenschalter und/oder paralleler Schalter betätigt, um ihre Verwendung zum Erzeugen einer Spannung und eines zum Ausgang der Vorrichtung fließenden Stroms zu ermöglichen; und/oder
- wenn die Spannung an den Anschlüssen einer Zelle unter diese optimale Spannung, verringert um einen vordefinierten prozentualen Wert, absinkt, wird wenigstens ein Zellenschalter und/oder paralleler Schalter betätigt, so dass sie nicht mehr an der Erzeugung von Spannung und von Strom am Ausgang der Vorrichtung beteiligt ist.

19. Verfahren zur Verwaltung einer Vorrichtung zur Erzeugung von photovoltaischer Energie nach einem der Ansprüche 16 bis 18, **dadurch gekennzeichnet, dass** es einen Schritt des Ladens eines Speicherelements (8) durch eine photovoltaische Zelle (7) während ihrer Trennung vom Rest der Vorrichtung umfasst.

20. Verfahren zur Verwaltung einer Vorrichtung zur Erzeugung von photovoltaischer Energie nach einem der Ansprüche 16 bis 19, **dadurch gekennzeichnet, dass** es einen Schritt des Vergleichs des tatsächlichen Zustands einer Zelle (11; 111) mit einem optimalen Betriebszustand, der zuvor in einem elektronischen Speicher gespeichert wurde, oder einen Schritt der Suche nach den optimalen Betriebsbedingungen der Zelle umfasst.

21. Verfahren zur Verwaltung einer Vorrichtung zur Erzeugung von photovoltaischer Energie nach einem der Ansprüche 16 bis 20, **dadurch gekennzeichnet, dass** es die Durchführung der folgenden Schritte umfasst:
- Messung einer Größe, die für den Zustand einer Zelle repräsentativ ist, und Übertragung der gemessenen Größe an wenigstens einen Rechner;
- Bestimmung der Position eines Zellenschalters und/oder Modulschalters und/oder parallelen Schalters unter Berücksichtigung der gemessenen Größe;
- Übertragung eines Befehls zum Öffnen oder Schließen eines Zellenschalters und/oder Modulschalters und/oder parallelen Schalters in Abhängigkeit von der vorangegangenen Bestimmung.

22. Verfahren zur Verwaltung einer Vorrichtung zur Erzeugung von photovoltaischer Energie nach dem vorhergehenden Anspruch, **dadurch gekennzeichnet, dass** es einen Schritt umfasst, der darin besteht, einen Ausfall und/oder einen Risikozustand einer Zelle zu diagnostizieren, indem die fehlerbehafteten Zellen, wie bei einer Überhitzung infolge einer Kurzschlusssituation, eines Eindringens von Feuchtigkeit, eines Lichtbogens, einer Flamme, eines Isolationsfehlers, anhand der an einer Zelle gemessenen Größe erkannt werden, um die betreffende Zelle abzuschalten oder vom Gesamtbetrieb der Vorrichtung zur Erzeugung von photovoltaischer Energie abzukoppeln, indem ihr Zellenschalter geöffnet wird und/oder indem der betreffende Modulschalter und/oder parallele Schalter geschlossen wird.

23. Verfahren zur Verwaltung einer Vorrichtung zur Erzeugung von photovoltaischer Energie nach einem der Ansprüche 16 bis 22, **dadurch gekennzeichnet, dass** die folgenden Schritte ausgeführt werden:
- Ausgleichen der Module und/oder Zellen untereinander, indem vorrangig die Module und/oder Zellen verwendet werden, deren Spannung die höchste ist; und/oder
- Ausgleichen der Module und/oder Zellen, indem die mittleren Nutzungsgrade der Module und/oder Zellen geändert werden, jedoch ohne ständig dieselben Module und/oder Zellen zu verwenden, so dass sich die Spannung der Module und/oder Zellen ausgleicht.

24. Verfahren zur Verwaltung einer Vorrichtung zur Erzeugung von photovoltaischer Energie nach einem der Ansprüche 16 bis 23, **dadurch gekennzeichnet, dass** es einen Schritt der Stromversorgung einer Schaltung zur Steuerung (27; 127) eines Zellenschalters (13; 113) und/oder eines parallelen Schalters (44) mittels wenigstens einer Zelle (11; 111) der Vorrichtung zur Erzeugung von photovoltaischer Energie umfasst.

25. Verfahren zur Verwaltung einer Vorrichtung zur Erzeugung von photovoltaischer Energie nach dem vorhergehenden Anspruch, **dadurch gekennzeichnet, dass** es einen Schritt der Stromversorgung aller anderen inneren elektronischen Komponenten der Vorrichtung zur Erzeugung von photovoltaischer Energie, die eine Stromversorgung benötigen, durch wenigstens eine Zelle der Vorrichtung zur Erzeugung von photovoltaischer Energie umfasst.

26. Verfahren zur Verwaltung einer Vorrichtung zur Erzeugung von photovoltaischer Energie nach einem der Ansprüche 16 bis 25, **dadurch gekennzeichnet, dass** es einen Schritt der Kommunikation über Stromleitungen zwischen einer Verarbeitungsschaltung (30; 130) eines Moduls (12; 112) und derjenigen eines anderen Moduls oder einem Zentralrechner (22; 122) oder einer Last (15) umfasst.

27. Verfahren zur Verwaltung einer Vorrichtung zur Erzeugung von photovoltaischer Energie nach einem der Ansprüche 16 bis 26, **dadurch gekennzeichnet, dass** es einen Schritt der Regelung der Ausgangsspannung der Vorrichtung zur Erzeugung von photovoltaischer Energie umfasst, welcher einen Schritt des Öffnens/Schließens von Zellenschaltern (13; 113) und/oder eines parallelen Schalters (34) der Vorrichtung zur Erzeugung von photovoltaischer Energie umfasst, um einer vorgegebenen Sollausgangsspannung zu folgen, insbesondere einer zeitlich variablen, wie etwa sinusförmigen Ausgangsspannung.

28. Verfahren zur Verwaltung einer Vorrichtung zur Erzeugung von photovoltaischer Energie nach einem der Ansprüche 16 bis 27, **dadurch gekennzeichnet, dass** es einen Schritt der Abschaltung aller Zellen der Vorrichtung zur Erzeugung von photovoltaischer Energie im Falle einer längeren Betriebsunterbrechung der Vorrichtung zur Erzeugung von photovoltaischer Energie oder einer Störung umfasst.

29. Verfahren zur Verwaltung einer Vorrichtung zur Erzeugung von photovoltaischer Energie nach einem der Ansprüche 16 bis 28, **dadurch gekennzeichnet, dass** es einen Schritt der Diagnose der Funktionsfähigkeit aller oder eines Teils der Zellenschalter und/oder Modulschalter und/oder parallelen Schalter umfasst.

30. Verfahren zur Verwaltung einer Vorrichtung zur Erzeugung von photovoltaischer Energie nach einem der Ansprüche 16 bis 29, **dadurch gekennzeichnet, dass** es einen Schritt der Ermittlung der Kenngrößen wenigstens einer photovoltaischen Zelle und/oder der Sonneneinstrahlung umfasst, indem für eine vordefinierte Zeitdauer wenigstens ein Zellenschalter (13; 113) geöffnet wird, um die Leerlaufspannung der photovoltaischen Zelle zu messen, oder indem wenigstens ein Zellenschalter (13; 113) und ein paralleler Schalter oder ein Modulschalter geschlossen werden, um die photovoltaische Zelle kurzzuschließen, um den Kurzschlussstrom der photovoltaischen Zelle zu messen.

## Claims

1. Photovoltaic energy generation device comprising several modules (12; 112) disposed in series, **characterized in that** it comprises at least one module (12; 112) comprising several cells (11; 111) disposed in parallel associated each with its at least one own cell switch (13; 113), disposed in series, so as to be able to disconnect them from the remainder of the photovoltaic energy generation device, each of these cells (11; 111) disposed in parallel comprising a photovoltaic cell (7), comprising one or more elementary photovoltaic cell(s), and a storage element (8) connected across the terminals of the photovoltaic cell.

2. Photovoltaic energy generation device according to the preceding claim, **characterized in that** it comprises at least one module (12; 112) comprising several cells (11; 111) disposed in parallel and several parallel switchs (44) connected in parallel with at least one cell of the said module (12; 112).

3. Photovoltaic energy generation device according to Claim 2, **characterized in that** the said at least one module (12; 112) comprises a lower terminal (17; 117) suitable for connection with a lower module and an upper terminal (18; 118) suitable for connection with an upper module, and **in that** it comprises several branches between its lower terminal (17; 117) and its upper terminal (18; 118) each comprising at least one cell (11; 111) and a cell switch (13; 113) disposed in series and several other parallel branches between its lower terminal (17; 117) and its upper terminal (18; 118) each comprising a parallel switch (44).

4. Photovoltaic energy generation device according to one of the preceding claims, **characterized in that** it comprises an arrangement of bricks (120) comprising two parallel branches comprising respectively a cell (111) and at least one cell switch (113) and at least one cell switch (113) and a cell (111), and comprising a transverse branch linking the two intermediate terminals (116) of respectively the said two parallel branches, this transverse branch comprising a cell switch (113).

5. Photovoltaic energy generation device according to one of the preceding claims, **characterized in that** it comprises several modules (12; 112) disposed in series each comprising several cells (11; 111) disposed in parallel and/or series, each cell (11; 111) being associated with at least one cell switch (13; 113) and each cell (11; 111) comprising a photovoltaic cell (7), comprising one or more elementary photovoltaic cell(s), and a storage element (8) connected across the terminals of the photovoltaic cell.

6. Photovoltaic energy generation device according to one of the preceding claims, **characterized in that** it comprises at least one electronic card (20) comprising:
- terminals (38, 16) for a link with cells (11; 111) of the photovoltaic energy generation device, and
- cell switchs (13; 113), and/or
- parallel switchs (44), and/or
- module switchs (14; 114).

7. Photovoltaic energy generation device according to the preceding claim, **characterized in that** it comprises at least one electronic card (20) incorporated into the photovoltaic panel or attached to the support structure of the photovoltaic panel, in particular disposed under the surface of the photovoltaic cells, opposite from their upper face receiving a light flux (39), so that its terminals (38, 16) for connection with the cells (11; 111) are positioned as close as possible to the terminals of the cells so as to reduce to a minimum the length of the connections and therefore the associated losses.

8. Photovoltaic energy generation device according to Claim 6 or 7, **characterized in that** it comprises at least one electronic card (20) disposed so as to minimize the power paths and/or to optimize the conductor cross-section, in particular by strengthening the tracks of the printed circuit forming the said electronic card (20) by adding to them an electrical conducting strengthener (19) above, such as a conducting wire or a baton.

9. Photovoltaic energy generation device according to the preceding claim, **characterized in that** it comprises holes made through at least one electronic card (20) so as to facilitate the circulation of air and the cooling of the cells (11; 111) and electronic components.

10. Photovoltaic energy generation device according to one of the preceding claims, **characterized in that** it comprises at least one sensor (33, 35, 36) for measuring a quantity characteristic of the state of a cell (11; 111), and **in that** it comprises, at the level of a module (12; 112), a control circuit (27; 127) for at least one cell switch (13; 113) and/or for a parallel switch (44) to control it as a function of the quantity characteristic of the state of the cell.

11. Photovoltaic energy generation device according to one of the preceding claims, **characterized in that** it comprises several cells (11; 111) each associated with at least one cell switch (13; 113) and/or a parallel switch (44), controlled by one or more control circuit(s) supplied electrically directly by at least one cell (11; 111) of a module of the photovoltaic energy generation device.

12. Photovoltaic energy generation device according to one of the preceding claims, **characterized in that** it comprises at least one processing circuit (30; 130) at the level of a module (12; 112) or of a brick (120) and/or a central computer (22; 122; 222), which drives(drive) cell switchs (13; 113) or module switchs (14; 114) or parallel switchs (34) by way of a control circuit (27; 127).

13. Photovoltaic energy generation device according to the preceding claim, **characterized in that** the control circuit (27; 127) and/or a processing circuit (30; 130) for at least one switch (13; 113; 14; 114; 44) is powered by at least one cell (11; 111) of the module (12; 112) or of a neighbour module or of the brick (120) or of a brick (120) neighbouring the cell switch that it drives.

14. Photovoltaic energy generation device according to one of the preceding claims, **characterized in that** the cell switch (13; 113) and/or module switch (14; 114) and/or parallel switch (44) is a transistor (23; 24; 34) and/or **in that** the storage element (8) comprises at least one capacitor.

15. Photovoltaic energy generation device according to one of the preceding claims, **characterized in that** it comprises three columns (109) each comprising several modules disposed in series so as to provide a three-phase output.

16. Method for managing a photovoltaic energy generation device according to one of the preceding claims, **characterized in that** it comprises a step of determining the position of several cell switchs (13; 113) and/or of several parallel switchs (44) of several cells (11; 111) disposed in parallel so as to maintain the cells in an operating state in a range around an optimal operating point.

17. Method for managing a photovoltaic energy generation device according to the preceding claim, **characterized in that** the position of at least one cell switch (13; 113) and/or of at least one parallel switch (44) maintains a cell (13; 113) in an operating state in a range of plus or minus 5% around an optimal operating point.

18. Method for managing a photovoltaic energy generation device according to Claim 16 or 17, **characterized in that** it comprises the following steps:
- when the voltage across the terminals of a cell exceeds an optimal voltage corresponding to the optimal operating point, increased by a predefined percentage, at least one cell switch and/or parallel switch is actuated so as to allow its use to produce a voltage and a current towards the output of the device, and/or
- when the voltage across the terminals of a cell falls below this optimal voltage decreased by a predefined percentage, at least one cell switch and/or parallel switch is actuated, so that said cell no longer participates in the production of voltage and current at the output of the device.

19. Method for managing a photovoltaic energy generation device according to one of Claims 16 to 18, **characterized in that** it comprises a step of charging of a storage element (8) by a photovoltaic cell (7) during its disconnection from the remainder of the device.

20. Method for managing a photovoltaic energy generation device according to one of Claims 16 to 19, **characterized in that** it comprises a step of comparing the actual state of a cell (11; 111) with an optimal operating state, stored previously in an electronic memory, or a step of searching for the optimal operating conditions of the cell.

21. Method for managing a photovoltaic energy generation device according to one of Claims 16 to 20, **characterized in that** it comprises the implementation of the following steps:
- measurement of a quantity representative of the state of a cell and transmission of the measured quantity to at least one computer;
- determination of the position of a cell switch and/or module switch and/or parallel switch by taking into account the measured quantity;
- transmission of a command for opening or closing a cell switch and/or module switch and/or parallel switch as a function of the preceding determination.

22. Method for managing a photovoltaic energy generation device according to the preceding claim, **characterized in that** it comprises a step consisting in diagnosing a failure and/or an at-risk state of a cell, by recognizing defective cells, such as overheating subsequent to a situation of short-circuit, ingress of moisture, electrical arcing, flame, isolation defect, on the basis of the quantity measured at the level of a cell, so as to disconnect or discard from the overall operation of the photovoltaic energy generation device the cell concerned, by opening its cell switch and/or by closing the module switch and/or parallel switch concerned.

23. Photovoltaic energy generation device management method according to one of Claims 16 to 22, **characterized in that** it implements the following steps:
- mutual balancing of the modules and/or cells, using by priority the modules and/or cells whose voltage is the highest; and/or
- balancing of the modules and/or cells by modifying the mean rate of use of the modules and/or cells, but without using the same modules and/or cells permanently, so that the voltage of the modules and/or cells balances.

24. Method for managing a photovoltaic energy generation device according to one of Claims 16 to 23, **characterized in that** it comprises a step of supplying electrical power to a control circuit (27; 127) of a cell switch (13; 113) and/or of a parallel switch (44) on the basis of at least one cell (11; 111) of the photovoltaic energy generation device.

25. Method for managing a photovoltaic energy generation device according to the preceding claim, **characterized in that** it comprises a step of supplying electrical power to all the other electronic components internal to the photovoltaic energy generation device requiring power supply by at least one cell of the photovoltaic energy generation device.

26. Method for managing a photovoltaic energy generation device according to one of Claims 16 to 25, **characterized in that** it comprises a step of communication by carrier current between a processing circuit (30; 130) of a module (12; 112) and that of another module or a central computer (22; 122) or a load (15).

27. Method for managing a photovoltaic energy generation device according to one of Claims 16 to 26, **characterized in that** it comprises a step of regulating the output voltage of the photovoltaic energy generation device which comprises a step of opening/closing cell switchs (13; 113) and/or a parallel switch (34) of the photovoltaic energy generation device so as to follow an imposed output voltage setpoint, in particular a time-varying setpoint such as of sinusoidal form.

28. Method for managing a photovoltaic energy generation device according to one of Claims 16 to 27, **characterized in that** it comprises a step of disconnecting all the cells of the photovoltaic energy generation device in case of prolonged shutdown of the photovoltaic energy generation device or of incident.

29. Method for managing a photovoltaic energy generation device according to one of Claims 16 to 28, **characterized in that** it comprises a step of diagnosing the operation of all or some of the cell switchs and/or module switchs and/or parallel switchs.

30. Method for managing a photovoltaic energy generation device according to one of Claims 16 to 29, **characterized in that** it comprises a step of identifying the characteristics of at least one photovoltaic cell and/or of the sunshine by opening over a predefined period at least one cell switch (13; 113) so as to measure the no-load voltage of the photovoltaic cell or by closing at least one cell switch (13; 113) and a parallel switch or module switch in such a way as to short-circuit the photovoltaic cell so as to measure the short-circuit current of the said photovoltaic cell.
